# EUROPEAN PATENT APPLICATION

(11) **EP 4 709 124 A1**
(43) Date of publication of application: **11.03.2026**
(21) Application number: 25194320.5
(22) Date of filing: 06.08.2025
(51) Int. Cl.: H10K 59/80

(54) **DISPLAY DEVICE INCLUDING A LIGHT CONTROL LAYER, AUTOMOBILE, AND METHOD FOR MANUFACTURING DISPLAY DEVICE**

(30) Priority: 05.09.2024 KR 20240120898
(71) Applicant: Samsung Display Co., Ltd., Yongin-si, Gyeonggi-do 17113 (KR)
(72) Inventor: Choi, Nak Cho, Yongin-si, Gyeonggi-do (KR); Kim, Kang San, Yongin-si, Gyeonggi-do (KR); Jang, Kyung Soo, Yongin-si, Gyeonggi-do (KR)
(74) Representative: Gulde & Partner

(57) **Abstract**

A display device includes. a substrate. A light emitting element layer is disposed on the substrate and includes a plurality of light emitting elements. A light control layer is disposed on the light emitting element layer. The light control layer includes a first light blocking layer including a plurality of first light blocking patterns, a low refractive transmitting film disposed on the first light blocking layer and including a plurality of grooves, a second light blocking layer disposed on the low refractive transmitting film and including a plurality of second light blocking patterns, and a high refractive transmitting film disposed on the second light blocking layer and including a plurality of lens units having a shape that is concave, bending toward the plurality of grooves.

## Description

### TECHNICAL FIELD

The present disclosure relates to a display device and, more specifically, to a display device including a light control layer, an automobile including the display device, and a method for manufacturing the display device.

### DISCUSSION OF THE RELATED ART

As society becomes increasingly information-oriented, there is a growing demand for display devices for display devices capable of presenting images in diverse ways. These display devices can include technologies such as a liquid crystal display (LCDs), field emission displays (FEDs), and a light emitting displays. Light emitting displays may be further categorized into organic light emitting diode (OLED) display devices, which use organic light emitting diodes as light emitting elements and inorganic light emitting display devices, which use inorganic light emitting diodes as a light emitting element.

In the case of vehicle display devices, images displayed on screens positioned in front of the driver or passenger can reflect off the windshield at night, potentially causing visual distractions and impairing the driver's ability to focus. To address this, it is important to control the viewing angle of these displays to minimize reflections. Additionally, controlling the viewing angle ensures that information intended for the driver remains hidden from the passenger, thereby enhancing privacy.

### SUMMARY

A display device includes a substrate. A light emitting element layer is disposed on the substrate and includes a plurality of light emitting elements. A light control layer is disposed on the light emitting element layer. The light control layer includes a first light blocking layer including a plurality of first light blocking patterns, a low refractive transmitting film disposed on the first light blocking layer and including a plurality of grooves, a second light blocking layer disposed on the low refractive transmitting film and including a plurality of second light blocking patterns, and a high refractive transmitting film disposed on the second light blocking layer and including a plurality of lens units having a shape that is concave, curving toward the plurality of grooves. The display device may be a vehicle display used as a display screen of a vehicle. Further, the display device may comprise a display panel including the substrate, the light emitting element layer and the light control layer

The display device may further include a first medium layer disposed between the light emitting element layer and the first light blocking layer and including an inorganic material.

The display device may further include a first light transmitting lower film disposed between the first light blocking layer and the low refractive transmitting film. The low refractive transmitting film and the first light transmitting lower film may include different materials.

The low refractive transmitting film may include at least one of an ester-based compound or a phosphine oxide compound, and the first light transmitting lower film contains at least one of propylene glycol methyl ether acetate, methacrylic acid-benzylmethacrylic acid copolymer, multi-functional acrylate, or a photo initiator.

The display device may further include a second light transmitting lower film disposed between the second light blocking layer and the high refractive transmitting film. The high refractive transmitting film and the second light transmitting lower film may include different materials.

The high refractive transmitting film may include at least one of an ester-based compound or a phosphine oxide compound, and the second light transmitting lower film may include at least one of propylene glycol methyl ether acetate, methacrylic acid-benzylmethacrylic acid copolymer, multi-functional acrylate, or a photo initiator.

A top surface of the second light transmitting lower film may have a shape that is concave, curving toward the plurality of grooves.

The display device may further include a second medium layer disposed between the low refractive transmitting film and the second light blocking layer and including an inorganic material.

The display device may further include a third medium layer disposed between the second light blocking layer and the second light transmitting lower film and including an inorganic material.

A bottom surface of the second light transmitting lower film may have a conformal shape along the plurality of grooves, the second medium layer, and the third medium layer.

The third medium layer may cover a top surface and a side surface of the second light blocking layer.

The plurality of lens units may be respectively disposed between the plurality of second light blocking patterns.

A refractive index of the high refractive transmitting film may be greater than a refractive index of the low refractive transmitting film.

A difference in refractive index of the high refractive transmitting film and the low refractive transmitting film may be 0.1 or more.

The refractive index of the high refractive transmitting film may be within a range of 1.5 to 1.8, and the refractive index of the low refractive transmitting film may be within a range of 1.4 to 1.7.

The low refractive transmitting film may include a plurality of partition walls disposed between the plurality of grooves, and the plurality of second light blocking patterns may be respectively disposed on the plurality of partition walls.

The display device may further include a second light transmitting lower film disposed between the second light blocking layer and the high refractive transmitting film. A side surface of the second light blocking layer may be in direct contact with the second light transmitting lower film.

The display device may further include a third medium layer disposed between the second light blocking layer and the second light transmitting lower film. A top surface of the second light blocking layer may be in direct contact with the third medium layer, and a bottom surface of the second light blocking layer may be in direct contact with the low refractive transmitting film.

One end of each of the plurality of lens units and one end of each of the plurality of second light blocking patterns, which are adjacent to each other, may be positioned on a same line.

The plurality of lens units and the plurality of second light blocking patterns, which are adjacent to each other, may overlap each other.

The low refractive transmitting film may include a first low refractive transmitting layer and a second low refractive transmitting layer disposed on the first low refractive transmitting layer. The display device may further include a third light blocking layer disposed between the first low refractive transmitting layer and the second low refractive transmitting layer and including a plurality of third light blocking patterns.

The plurality of grooves may be disposed in the second low refractive transmitting layer.

A width of each of the plurality of second light blocking patterns may be less than a width of each of the plurality of first light blocking patterns.

A width of each of the plurality of third light blocking patterns may be less than a width of each of the plurality of second light blocking patterns and may be greater than a width of each of the plurality of first light blocking patterns.

The display device may further include a color filter disposed between the plurality of first light blocking patterns.

The display device may further include a color filter disposed between the plurality of second light blocking patterns.

At least some of the plurality of second light blocking patterns may be disposed further in one direction than at least some of the plurality of first light blocking patterns, and central portions of the at least some of the plurality of second light blocking patterns may be misaligned with central portions of the at least some of the plurality of first light blocking patterns.

At least some of the plurality of lens units may be disposed further in one direction than the at least some of the plurality of first light blocking patterns, and central portions of the at least some of the plurality of lens units may be misaligned with the central portions of the at least some of the plurality of first light blocking patterns.

The plurality of light emitting elements may include a first light emitting element and a second light emitting element that emit light of different colors. The plurality of lens units may include a first lens overlapping the first light emitting element and a second lens overlapping the second light emitting element. Average curvatures of the first lens and the second lens may be different from one another.

A method for manufacturing a display device includes forming a first light blocking layer on a light emitting element layer. A low refractive transmitting material layer is disposed on the first light blocking layer. A second light blocking layer is formed on the low refractive transmitting material layer. A first medium layer is disposed on the second light blocking layer. The low refractive transmitting material layer is patterned using the first medium layer to form a low refractive transmitting film. A high refractive transmitting film is formed on the low refractive transmitting film and the second light blocking layer.

A method for manufacturing a display device includes forming a first light blocking layer on a light emitting element layer. A low refractive transmitting material layer is disposed on the first light blocking layer and a second light blocking material layer is disposed on the low refractive transmitting material layer. A first medium layer is formed on the second light blocking material layer. The low refractive transmitting material layer and the second light blocking material layer are simultaneously patterned using the first medium layer to form a low refractive transmitting film and a second light blocking layer. A high refractive transmitting film is formed on the low refractive transmitting film and the second light blocking layer.

The medium layer may include an inorganic material and the low refractive transmitting film may include at least one of an ester-based compound or a phosphine oxide compound.

An automobile includes a body including a windshield, an interior space disposed in the body, a dashboard disposed in the interior space, proximate to the windshield, and a display panel disposed on the dashboard. The display panel includes a substrate, a light emitting element layer disposed on the substrate and including a plurality of light emitting elements, and a light control layer disposed on the light emitting element layer. The light control layer includes a first light blocking layer including a plurality of first light blocking patterns, a low refractive transmitting film disposed on the first light blocking layer and including a plurality of grooves, a second light blocking layer disposed on the low refractive transmitting film and including a plurality of second light blocking patterns, and a high refractive transmitting film disposed on the second light blocking layer and including a plurality of lens units having a shape that is concave, curving toward the plurality of grooves.

The display panel may further include a first medium layer disposed between the light emitting element layer and the first light blocking layer and comprising an inorganic material and a first light transmitting lower film disposed between the first light blocking layer and the low refractive transmitting film. The low refractive transmitting film and the first light transmitting lower film may include different materials from one another. The low refractive transmitting film may include at least one of an ester-based compound or a phosphine oxide compound. The first light transmitting lower film may include at least one of propylene glycol methyl ether acetate, methacrylic acid-benzylmethacrylic acid copolymer, multi-functional acrylate, or a photo initiator.

Alternatively, the automobile may include the display device as defined in par. [0004] to [0032]. In this case, the display panel of the display device may be disposed on the dashboard.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to an embodiment;
FIG. 2 is a plan view illustrating a display device according to an embodiment;
FIG. 3 is a schematic cross-sectional view of the display device taken along line X1-X1' of FIG. 2;
FIG. 4 is a schematic diagram when a display device according to an embodiment is applied to a vehicle;
FIG. 5 is a cross-sectional view illustrating an example of a display panel according to an embodiment;
FIG. 6A is a cross-sectional view illustrating an example of a portion of a display area according to an embodiment;
FIG. 6B is a plan view showing an example of a portion of a display area according to an embodiment;
FIG. 7 is a cross-sectional view of a display panel taken along line X2-X2' of FIG. 6A;
FIG. 8A is a cross-sectional view of a display panel taken along line X3-X3' of FIG. 6A;
FIG. 8B is a graph showing changes in a refractive index of a high refractive transmitting film according to a wavelength of light;
FIG. 9 is a cross-sectional view showing a display area, a non-display area, and a protrusion area of a display panel according to an embodiment;
FIG. 10A is an enlarged view of area A of FIG. 8A;
FIG. 10B is a plan view illustrating a portion of a display area according to an embodiment;
FIG. 10C is a cross-sectional view illustrating a portion of a display panel according to an embodiment;
FIG. 10D is a simulated image showing a movement path of light in the display panel according to the embodiment of FIG. 10A;
FIG. 10E is a simulated image showing a movement path of light in the display panel according to the embodiment of FIGS. 10B and 10C;
FIG. 11 is a perspective view showing a first lens unit according to an embodiment;
FIG. 12 is a perspective view showing a second lens unit according to an embodiment;
FIG. 13 is a cross-sectional view showing a display panel according to an embodiment;
FIGS. 14 and 15A are enlarged views of area B of FIG. 13;
FIG. 15B is a simulated image showing a movement path of light in the display panel according to the embodiment of FIGS. 14 and 15A;
FIG. 16 is a cross-sectional view showing a display panel according to an embodiment;
FIG. 17 is an enlarged view of area C of FIG. 16;
FIG. 18 is a cross-sectional view showing a display panel according to an embodiment;
FIG. 19 is a cross-sectional view showing a display panel according to an embodiment;
FIG. 20 is a flowchart showing a method for manufacturing a display device according to an embodiment;
FIG. 21 is a cross-sectional view showing step S100 of FIG. 20;
FIGS. 22 to 24 are cross-sectional views showing step S110 of FIG. 20;
FIG. 25 is a cross-sectional view showing step S120 of FIG. 20;
FIGS. 26 and 27 are cross-sectional views showing step S130 of FIG. 20;
FIGS. 28 to 30 are cross-sectional views showing step S140 of FIG. 20;
FIG. 31 is a cross-sectional view showing step S150 of FIG. 20;
FIGS. 32 and 33 are cross-sectional views showing step S160 of FIG. 20;
FIG. 34 is a cross-sectional view showing step S170 of FIG. 20;
FIG. 35 is a cross-sectional view showing step S180 of FIG. 20;
FIG. 36 is a cross-sectional view showing step S190 of FIG. 20;
FIG. 37 is a flowchart illustrating a method for manufacturing a display device according to an embodiment;
FIGS. 38 to 40 are cross-sectional views showing step S130_1 of FIG. 37;
FIGS. 41 and 42 are cross-sectional views showing step S160_1 of FIG. 37;
FIG. 43 is a cross-sectional view showing step S170_1 of FIG. 37;
FIG. 44 is a cross-sectional view showing step S180 of FIG. 37; and
FIG. 45 is a cross-sectional view showing step S190 of FIG. 37.

### DETAILED DESCRIPTION OF THE EMBODIMENTS

Embodiments of the present invention will now be described more fully hereinafter with reference to the accompanying drawings. This invention may, however, be embodied in different forms and should not necessarily be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers may indicate the same components throughout the specification and the drawings.

Hereinafter, embodiments of the present disclosure will be described in detail with reference to the accompanying drawings.

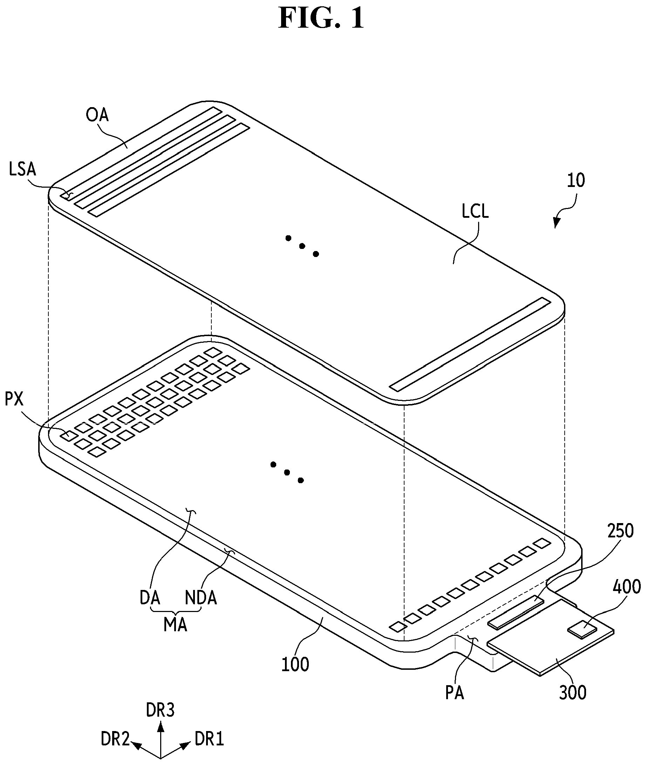

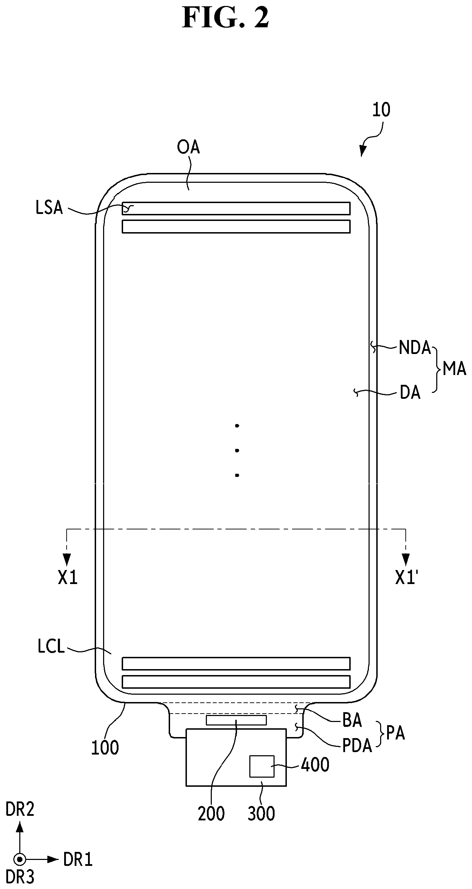

FIG. 1 is a perspective view showing a display device according to an embodiment. FIG. 2 is a plan view illustrating a display device according to an embodiment.

Referring to FIGS. 1 and 2, a display device 10, which is a device for displaying a moving image or a still image, may be used as a display screen of various devices, such as an automobile, a television, a laptop computer, a computer monitor, a digital billboard and an Internet-of-Things (IOT) device, as well as portable electronic devices such as a mobile phone, a smartphone, a tablet computer, a smart watch, a watch phone, a mobile communication terminal, an electronic notebook, an electronic book, a portable multimedia player (PMP), a navigation device, and an ultra-mobile PC (UMPC).

In some embodiments, when the display device 10 is used as a display screen of a vehicle, the display device 10 may be a vehicle display. The vehicle display may provide users with not only information about vehicle's operation and status, but also various services such as convenience functions and media content. When the display device 10 includes an input unit such as a touch panel, the user may operate various functions such as driving modes of the vehicle and convenience functions through the display device 10.

In this specification, a case where the display device 10 is a vehicle display is described as an example, but the present disclosure is not necessarily limited thereto, and when the display device 10 is used for a display screen of various products such as the above-described electronic devices.

The display device 10 may be any one of an organic light emitting display device, a liquid crystal display device, a plasma display device, a field emission display device, an electrophoretic display device, an electrowetting display device, a quantum dot light emitting display device, a micro LED display device, and the like. In the following description, it is assumed that the display device 10 is an organic light emitting display device, but the present disclosure is not necessarily limited thereto.

The display device 10, according to an embodiment, may include a display panel 100, a display driving circuit 250, a circuit board 300, and a touch driving circuit 400.

The display panel 100 may include a plurality of pixels PX arranged in a first direction DR1 and a second direction DR2. Each of the pixels PX may have a rectangular, square, or rhombic shape in a plan view. For example, as shown in the drawing, each of the pixels PX may have a square shape in a plan view. However, it is not necessarily limited thereto, and may have various shapes such as a polygon, a circle, and an ellipse in a plan view.

In the illustrated figure, the first direction DR1 and the second direction DR2 cross each other as horizontal directions. For example, the first direction DR1 and the second direction DR2 may be orthogonal to each other. In addition, a third direction DR3 crosses the first direction DR1 and the second direction DR2, and may be, for example, perpendicular directions orthogonal to each other. In the present disclosure, a direction indicated by each of the first to third directions DR1, DR2, and DR3 on the drawings may be referred to as one side, and an opposite direction thereto may be referred to as the other side. Unless otherwise specified, each direction may include both sides. Unless otherwise defined, in the present specification, directions indicated by arrows of the first to third directions DR1, DR2, and DR3 may be referred to as one side, and the opposite directions thereto may be referred to as the other side. Also, the terms "above," "upper side," "upper portion," "top," and "top surface," as used herein, refer to a direction indicated by an arrow in the drawing in the third direction DR3 based on the drawings, and the terms "below," "lower side," "lower portion," "bottom," and "bottom surface," as used herein, refer to a direction opposite to the direction indicated by the arrow in the third direction DR3 based on the drawings.

The display panel 100 may include a main region MA and a protrusion area PA protruding from one side of the main region MA.

The main region MA may, in a plan view, be formed in a rectangular shape having a pair of short sides extending primarily in the first direction DR1 and a pair of long sides extending primarily in the second direction DR2 crossing the first direction DR1. The corner where the short side in the first direction DR1 and the long side in the second direction DR2 meet may be rounded to have a predetermined curvature or may be right-angled. The planar shape of the display device 10 is not necessarily limited to a quadrilateral shape, and may be formed in another polygonal shape, a circular shape, or an elliptical shape. The main region MA may be formed flat, but is not necessarily limited thereto, and may include curved portions formed at left and right ends. In this case, the curved portions may have a constant curvature or a varying degree of curvature.

The main region MA may include a display area DA, where pixels are formed to display an image, and a non-display area NDA, which is a peripheral area of the display area DA.

In the display area DA, not only the pixels, but also scan lines, data lines, and power lines connected to the pixels may be disposed. When the main region MA includes a curved portion, the display area DA may be disposed on the curved portion. In this case, the image of the display panel 100 may also be seen on the curved portion.

The non-display area NDA may be defined as an area from the boundary of the display area DA to the edge of the display panel 100. A scan driver for applying scan signals to the scan lines and link lines connecting the data lines to the display driving circuit 250 may be disposed in the non-display area NDA.

The protrusion area PA may protrude from one side of the main region MA. For example, the protrusion area PA may protrude from the lower side of the main region MA as shown in FIG. 2. A length of the protrusion area PA in the first direction DR1 may be less than a length of the main region MA in the first direction DR1.

The protrusion area PA may include a bending area BA and a pad area PDA. In this case, the pad area PDA may be disposed on one side of the bending area BA, and the main region MA may be disposed on the other side of the bending area BA. For example, the pad area PDA may be disposed below the bending area BA, and the main region MA may be disposed above the bending area BA.

The display panel 100 may be formed flexibly such that it can be curved, bent, folded, or rolled to a noticeable extent without cracking or otherwise sustaining damage. Accordingly, the display panel 100 may be bent in the thickness direction, for example, in the third direction DR3 in the bending area BA. In this case, one surface of the pad area PDA of the display panel 100 faces upward before the display panel 100 is bent, but after the display panel 100 is bent, one surface of the pad area PDA of the display panel 100 faces downward. Accordingly, since the pad area PDA is disposed below the main region MA, the pad area PDA may overlap the main region MA.

Pads electrically connected to the display driving circuit 250 and the circuit board 300 may be disposed in the pad area PDA of the display panel 100.

The display driving circuit 250 outputs signals and voltages for driving the display panel 100. For example, the display driving circuit 250 may supply data voltages to data lines. Further, the display driving circuit 250 may supply a power voltage to the power line, and may supply scan control signals to the scan driver. The display driving circuit 250 may be formed as an integrated circuit (IC) and mounted on the display panel 100 in the pad area PDA by a chip on glass (COG) method, a chip on plastic (COP) method, or an ultrasonic bonding method, but the present disclosure is not necessarily limited thereto. For example, the display driving circuit 250 may be mounted on the circuit board 300.

The pads may include display pads electrically connected to the display driving circuit 250 and touch pads electrically connected to touch lines.

The circuit board 300 may be attached onto the pads using an anisotropic conductive film. Accordingly, lead lines of the circuit board 300 may be electrically connected to the pads. The circuit board 300 may be a flexible printed circuit board, a printed circuit board, or a flexible film such as a chip on film.

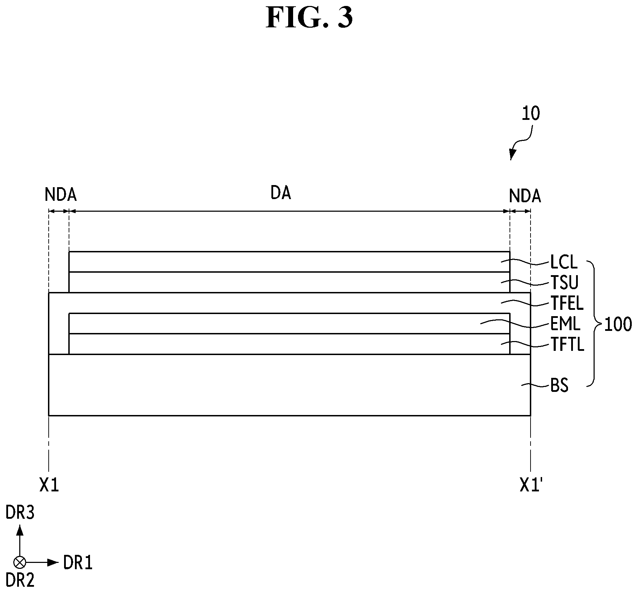

The touch driving circuit 400 may be connected to touch electrodes of a touch sensor layer TSU (see FIG. 3) of the display panel 100. The touch driving circuit 400 applies driving signals to the touch electrodes of the touch sensor layer TSU (see FIG. 3) and measures capacitance values of the touch electrodes. The driving signal may be a signal having a plurality of driving pulses. The touch driving circuit 400 may determine whether or not a touch is inputted based on the capacitance values, and may calculate touch coordinates at which a touch is inputted.

The touch driving circuit 400 may be disposed on the circuit board 300. The touch driving circuit 400 may be formed as an integrated circuit (IC) and mounted on the circuit board 300.

In the display device 10, according to the present embodiment, the display panel 100 may further include a light control layer LCL.

The light control layer LCL may be directly disposed on the main region MA of the display panel 100. For example, the light control layer LCL may be embedded in the display panel 100 and may be directly disposed on the main region MA of the display panel 100. By embedding the light control layer LCL in the display panel 100, the thickness and manufacturing cost of the display device 10 may be reduced compared to a case where a separate light control film is attached.

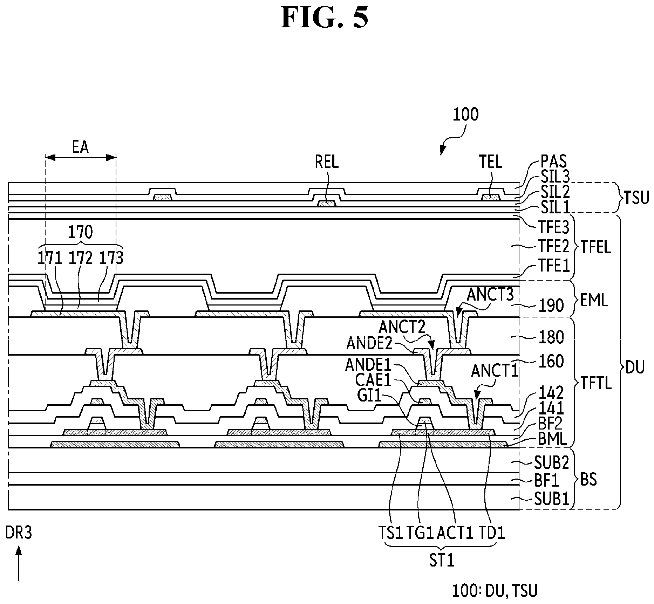

In some embodiments, the light control layer LCL may be disposed on the display area DA of the main region MA. The light control layer LCL may adjust the viewing angle of light emitted from a light emitting layer 172 (see FIG. 5) of the display panel 100.

However, the present invention is not necessarily limited thereto, and the size of the light control layer LCL may be larger than that of the display area DA in a plan view. In this case, the light control layer LCL may overlap both the display area DA and the non-display area NDA.

In some embodiments, the light control layer LCL may include a transmission area OA and a non-transmission area LSA.

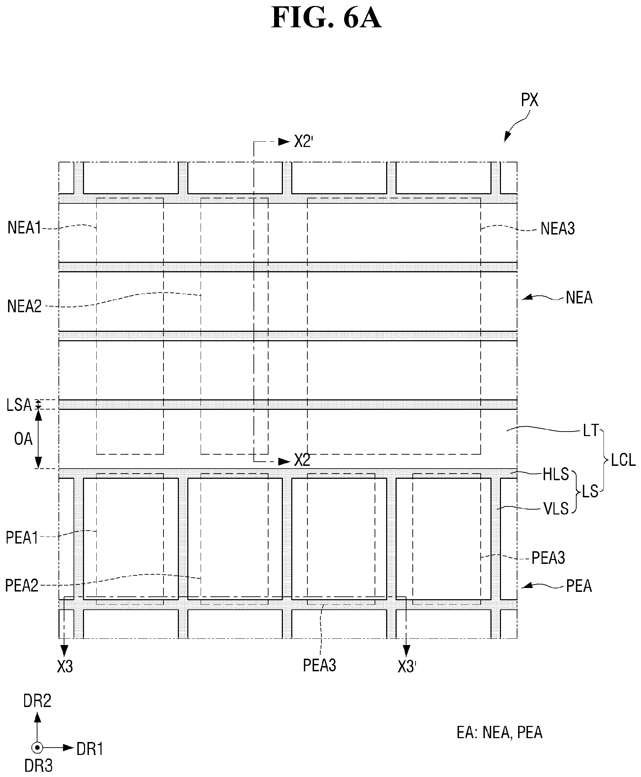

The transmission area OA may be an area where a light blocking film LS (see FIG. 6A) might not be disposed. The transmission area OA is an area that transmits light and may extend along the third direction DR3.

The transmission area OA may have a quadrilateral shape in a plan view, as illustrated in FIGS. 1 and 2, but is not necessarily limited thereto. The transmission area OA may have a circular shape, an elliptical shape, or a polygonal shape in a plan view. In some embodiments, the shape of the transmission area OA may substantially correspond to the shape of the display panel 100.

The non-transmission areas LSA may be the remaining areas of the light control layer LCL excluding the transmission areas OA. The non-transmission areas LSA may be areas in which the light blocking film LS (see FIG. 6A) is disposed.

In some embodiments, the non-transmission areas LSA may extend in the first direction DR1 or the second direction DR2. For example, as shown in FIG. 1, the non-transmission areas LSA may extend in the first direction DR1 and may be arranged along the second direction DR2. As an example, the non-transmission areas LSA may extend in the second direction DR2 and may be arranged along the first direction DR1. As an example, some of the non-transmission areas LSA may extend in the first direction DR1 and may be arranged along the second direction DR2, while the remainder of the non-transmission areas LSA may extend in the second direction DR2 and may be arranged along the first direction DR1.

In an embodiment, as shown in FIG. 1, when the non-transmission areas LSA are arranged along the second direction DR2, the viewing angle may be controlled in the second direction DR2. In an embodiment, when the non-transmission areas LSA are arranged along the first direction DR1, the viewing angle may be controlled in the first direction DR1. In the display device 10, according to this embodiment, the arrangement and shape of the transmission areas OA and the non-transmission areas LSA may be changed in various ways according to the required control direction of the viewing angle.

The drawing illustrates that the transmission area OA surround the non-transmission areas LSA, but the present disclosure is not necessarily limited thereto. In some embodiments, the transmission area OA may include a plurality of transmission areas OA, and the plurality of transmission areas OA may extend in the same direction as the non-transmission areas LSA, so that the transmission areas OA and the non-transmission areas LSA may be arranged alternately with each other. For example, as shown in FIG. 1, when the non-transmission areas LSA extend in the first direction DR1, the plurality of transmission areas OA may extend in the first direction DR1 and may be arranged alternately with the non-transmission areas LSA in the second direction DR2.

The light control layer LCL may include the light blocking film LS (see FIG. 6A) that blocks light emitted from the light emitting layer 172 (see FIG. 5) of the display panel 100, and a light transmitting film LT (see FIG. 6A) that transmits the light. A detailed structure of the light control layer LCL will be described later with reference to FIG. 6A and the like.

FIG. 3 is a schematic cross-sectional view of the display device taken along line X1-X1' of FIG. 2.

Referring to FIG. 3, the display device 10 may include the display panel 100 in which the light control layer LCL is embedded. The display panel 100 may include a base substrate BS, a thin film transistor layer TFTL, a light emitting element layer EML, a thin film encapsulation layer TFEL, the touch sensor layer TSU, and the light control layer LCL.

The base substrate BS may include a substrate. The substrate may be formed of an insulating material such as glass, quartz, or a polymer resin. Examples of a polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (TAC), cellulose acetate propionate (CAP), or a combination thereof. Alternatively, the substrate may include a metal material.

The substrate may be a rigid substrate or a flexible substrate which can be bent, folded or rolled to a noticeable extent without cracking or otherwise sustaining damage. When the substrate is a flexible substrate, the substrate may be formed of polyimide (PI), but is not necessarily limited thereto.

The thin film transistor layer TFTL may be disposed on the base substrate BS. In the thin film transistor layer TFTL, scan lines, data lines, power lines, scan control lines, and link lines connecting pads to data lines, as well as thin film transistors of each of the pixels, may be formed. Each of the thin film transistors may include a gate electrode, a semiconductor layer, a source electrode, and a drain electrode.

The thin film transistor layer TFTL may be disposed in the display area DA and the non-display area NDA. For example, thin film transistors, scan lines, data lines, and power lines of each of the pixels of the thin film transistor layer TFTL may be disposed in the display area DA. The scan control lines and the link lines of the thin film transistor layer TFTL may be disposed in the non-display area NDA.

The light emitting element layer EML may be disposed on the thin film transistor layer TFTL. The light emitting element layer EML may include pixels including a first electrode, a light emitting layer, and a second electrode, and a pixel defining layer defining the pixels. The light emitting layer may be an organic light emitting layer containing an organic material. In this case, the light emitting layer may include a hole transporting layer, an organic light emitting layer, and an electron transporting layer. When the first electrode is applied with a predetermined voltage through the thin film transistor of the thin film transistor layer TFTL and the second electrode is applied with a cathode voltage, holes and electrons are transferred to the organic light emitting layer through a hole transporting layer and an electron transporting layer, respectively and are combined with each other to emit light in the organic light emitting layer. The pixels of the light emitting element layer EML may be disposed in the display area DA.

The thin film encapsulation layer TFEL may be disposed on the light emitting element layer EML. The thin film encapsulation layer TFEL may serve to prevent oxygen or moisture from permeating into the light emitting element layer EML. To this end, the thin film encapsulation layer TFEL may include at least one inorganic film. The inorganic film may be a silicon nitride layer, a silicon oxynitride layer, a silicon oxide layer, a titanium oxide layer, or an aluminum oxide layer, but is not necessarily limited thereto. In addition, the thin film encapsulation layer TFEL may serve to protect the light emitting element layer EML from foreign substances such as dust. To this end, the thin film encapsulation layer TFEL may include at least one organic film. The organic film may include acryl resin, epoxy resin, phenolic resin, polyamide resin, or polyimide resin, but is not necessarily limited thereto.

The thin film encapsulation layer TFEL may be disposed in both the display area DA and the non-display area NDA. For example, the thin film encapsulation layer TFEL may cover the light emitting element layer EML in the display area DA and the non-display area NDA, and may cover the thin film transistor layer TFTL in the non-display area NDA.

The touch sensor layer TSU may be disposed on the thin film encapsulation layer TFEL. Since the touch sensor layer TSU is directly disposed on the thin film encapsulation layer TFEL, it has the advantage of reducing the thickness of the display device 10 compared to a case where a separate touch panel including the touch sensor layer TSU is attached on the thin film encapsulation layer TFEL.

The touch sensor layer TSU may include touch electrodes for sensing a user's touch in a capacitive manner and the touch lines connecting the pads to the touch electrodes. For example, the touch sensor layer TSU may sense a user's touch using a self-capacitance method or a mutual capacitance method.

The touch electrodes of the touch sensor layer TSU may be disposed in a touch sensor area overlapping the display area DA. The touch lines of the touch sensor layer TSU may be disposed in a touch peripheral area overlapping the non-display area NDA.

The light control layer LCL may be disposed on the touch sensor layer TSU. The light control layer LCL may overlap the display area DA. The light control layer LCL may serve to absorb or block light that travels out of a certain angle with respect to the third direction DR3 among light emitted from the light emitting element layer EML. For example, the light control layer LCL may control the viewing angle.

The display device 10 may further include a cover window. The cover window may be additionally disposed on the light control layer LCL, and in this case, the light control layer LCL and the cover window may be attached by a transparent adhesive such as an optically clear adhesive (OCA) film.

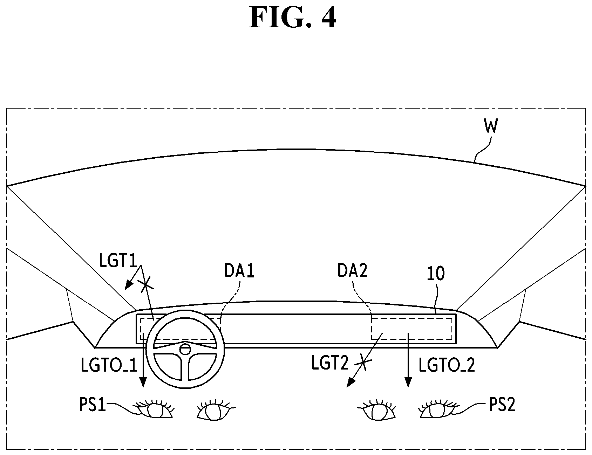

FIG. 4 is a schematic diagram illustrating a case in which a display device, according to an embodiment, is applied to a vehicle.

Referring to FIG. 4, the display device 10. according to an embodiment, may be, for example, the display device applied to the vehicle. The vehicle may include a body forming an exterior of the vehicle and an interior space defined by the body. The body may include a windshield W that protects a driver PS1 and a passenger PS2 from the outside and provides a view to the driver PS1. As illustrated in the drawing, the display device 10 may be provided in the interior space.

In some embodiments, the display device 10 may be disposed on a dashboard provided in the interior space. For example, as shown in FIG. 4, the display device 10 may extend from the dashboard disposed in front of the driver's seat to the dashboard disposed in front of the passenger's seat. For example, the display device 10 may be an integral display continued from the dashboard disposed in front of the driver's seat to the dashboard disposed in front of the passenger's seat.

In this case, the display device 10 may include a first display area DA1 disposed in front of the driver's seat and a second display area DA2 disposed in front of the passenger's seat. The first display area DA1 may be disposed on the dashboard in front of the driver's seat to provide speed information and the like to the driver PS1. The second display area DA2 may be disposed on the dashboard in front of the passenger's seat to provide entertainment content and the like to the passenger PS2. A third display area may be further included between the first display area DA1 and the second display area DA2.

As an example, the display devices 10 may be disposed on the dashboard in front of the driver's seat and the dashboard in front of the passenger's seat, respectively. For example, a first display device may be disposed on the dashboard in front of the driver's seat, and a second display device may be disposed on the dashboard in front of the passenger's seat.

The driver PS1 may visually recognize the display screen of the display device 10 through light LGTO_1 emitted from the display device 10 in front of the driver's seat toward the driver PS1. However, light LGT1, which is some of the light emitted from the display device 10 in front of the driver's seat, may be reflected on the surrounding windshield W and provided to the driver PS1. In this case, the image reflected on the windshield W may interfere with the driver PS1's driving. In the case of the display device 10, according to an embodiment, by adjusting the viewing angle of the lights emitted from the display device 10 in a front direction (direction facing the driver PS1), particularly, the vertical viewing angle, the light LGT1 that is some of the light emitted from the display device 10 in front of the driver's seat may be prevented from being reflected on the surrounding windshield W and provided to the driver PS1.

The passenger PS2 may visually recognize the display screen of the display device 10 through light LGTO_2 emitted from the display device 10 in front of the passenger's seat toward the passenger PS2. However, light LGT2, which is some of the light emitted from the display device 10 in front of the passenger's seat, may be provided toward the driver PS1. In this case, the driver PS1 may be restricted from viewing when the vehicle is in motion for safety reasons. In the case of the display device 10 according to an embodiment, by adjusting the viewing angle of the lights emitted from the display device 10 in the front direction (the direction facing the passenger PS2), particularly, the horizontal viewing angle, the light LGT2 that is some of the light emitted from the display device 10 in front of the passenger's seat may be prevented from being provided to the driver.

The drawing illustrates that the display device 10 in front of the driver's seat adjusts the vertical viewing angle, and the display device 10 in front of the passenger's seat adjusts the horizontal viewing angle, but the present disclosure is not necessarily limited thereto. For example, the display device 10 in front of the driver's seat may adjust the horizontal viewing angle, and the display device 10 in front of the passenger's seat may adjust the vertical viewing angle. As an example, the display device 10 in front of the driver's seat and the display device 10 in front of the passenger's seat may adjust both the vertical viewing angle and the horizontal viewing angle.

The viewing angles may be adjusted through the light control layer LCL. The viewing angles may be limited to a predetermined angle range through the light control layer LCL. For example, when an imaginary line that faces the driver PS1 or the passenger PS2 and extends in a direction perpendicular to the display surface of the display device 10 is taken as a normal line, the viewing angle may be within 35° from the normal line. In some embodiments, the angle within 35° from the normal line may be defined as an effective viewing angle, but the present disclosure is not necessarily limited thereto.

FIG. 5 is a cross-sectional view illustrating an example of a display panel according to an embodiment.

Referring to FIG. 5, the display panel 100 may include a display layer DU and the touch sensor layer TSU. The display layer DU may include the base substrate BS, the thin film transistor layer TFTL, the light emitting element layer EML, and the thin film encapsulation layer TFEL.

The base substrate BS may include a first substrate SUB1, a first buffer film BF1 disposed on the first substrate SUB1, and a second substrate SUB2 disposed on the first buffer film BF1.

The first substrate SUB1 and the second substrate SUB2 may be made of an insulating material such as glass, quartz, polymer resin or the like. Examples of a polymer material may include polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (TAC), cellulose acetate propionate (CAP), or a combination thereof. Alternatively, the substrate may include a metal material.

The first substrate SUB1 and the second substrate SUB2 may be a rigid substrate, or a flexible substrate which can be bent, folded or rolled to a noticeable extent without cracking or otherwise sustaining damage. When the substrate is a flexible substrate, the substrate may be formed of polyimide (PI), but is not necessarily limited thereto.

The first buffer film BF1 is a film for protecting a first thin film transistor ST1 and the light emitting layer 172 from moisture permeating through the first substrate SUB1 and the second substrate SUB2 which are susceptible to moisture permeation. The first buffer film BF1 may be formed of a plurality of inorganic films that are alternately stacked. For example, the first buffer film BF1 may be formed of multiple films in which one or more inorganic films of a silicon nitride layer, a silicon oxynitride layer, a silicon oxide layer, a titanium oxide layer and an aluminum oxide layer are alternately stacked.

The thin film transistor layer TFTL may include a lower metal layer BML, a second buffer film BF2, the first thin film transistor ST1, a first gate insulating film GI1, a first interlayer insulating film 141, a first capacitor electrode CAE1, a second interlayer insulating film 142, a first anode connection electrode ANDE1, a first organic film 160, a second anode connection electrode ANDE2, and a second organic film 180.

The lower metal layer BML may be disposed on the second substrate SUB2. The lower metal layer BML may overlap a first active layer ACT1 of the first thin film transistor ST1 in the third direction DR3 in order to prevent a leakage current from being generated when light is incident on the first active layer ACT1 of the first thin film transistor ST1. The lower metal layer BML may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. The lower metal layer BML may be omitted.

The second buffer film BF2 may be disposed on the lower metal layer BML. The second buffer film BF2 is a film for protecting the first thin film transistor ST1 and the light emitting layer 172 from moisture permeating through the first substrate SUB1 and the second substrate SUB2 which are susceptible to moisture permeation. The second buffer film BF2 may be formed of a plurality of inorganic films that are alternately stacked. For example, the second buffer film BF2 may be formed of multiple films in which one or more inorganic films of a silicon nitride layer, a silicon oxynitride layer, a silicon oxide layer, a titanium oxide layer and an aluminum oxide layer are alternately stacked.

The first active layer ACT1 of the first thin film transistor ST1 may be disposed on the second buffer film BF2. The first active layer ACT1 of the first thin film transistor ST1 includes polycrystalline silicon, monocrystalline silicon, low-temperature polycrystalline silicon, amorphous silicon, or an oxide semiconductor. The first active layer ACT1 of the first thin film transistor ST1, which is exposed without being covered by the first gate insulating film GI1, is doped with impurities or ions, and thus may have conductivity. Accordingly, a first source electrode TS1 and a first drain electrode TD1 of the first active layer ACT1 of the first thin film transistor ST1 may be formed.

The first gate insulating film GI1 may be disposed on the first active layer ACT1 of the first thin film transistor ST1. Although FIG. 5 illustrates that the first gate insulating film GI1 is disposed between the first active layer ACT1 and a first gate electrode TG1 of the first thin film transistor ST1, but is not necessarily limited thereto. The first gate insulating film GI1 may be disposed between the first interlayer insulating film 141 and the first active layer ACT1 and between the first interlayer insulating film 141 and the second buffer film BF2. The first gate insulating film GI1 may be formed of an inorganic film, for example, a silicon nitride layer, a silicon oxynitride layer, a silicon oxide layer, a titanium oxide layer, or an aluminum oxide layer.

The first gate electrode TG1 of the first thin film transistor ST1 may be disposed on the first gate insulating film GI1. The first gate electrode TG1 of the first thin film transistor ST1 may overlap the first active layer ACT1 in the third direction DR3. The first gate electrode TG1 of the first thin film transistor ST1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first interlayer insulating film 141 may be disposed on the first gate electrode TG1 of the first thin film transistor ST1. The first interlayer insulating film 141 may be formed of an inorganic film, for example, a silicon nitride layer, a silicon oxynitride layer, a silicon oxide layer, a titanium oxide layer, or an aluminum oxide layer. The first interlayer insulating film 141 may include a plurality of inorganic films.

The first capacitor electrode CAE1 may be disposed on the first interlayer insulating film 141. The first capacitor electrode CAE1 may overlap the first gate electrode TG1 of the first thin film transistor ST1 in the third direction DR3. Since the first interlayer insulating film 141 has a predetermined dielectric constant, the first capacitor electrode CAE1, the first gate electrode TG1, and the first interlayer insulating film 141 disposed therebetween may form a capacitor. The first capacitor electrode CAE1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second interlayer insulating film 142 may be disposed on the first capacitor electrode CAE1. The second interlayer insulating film 142 may be formed of an inorganic film, for example, a silicon nitride layer, a silicon oxynitride layer, a silicon oxide layer, a titanium oxide layer, or an aluminum oxide layer. The second interlayer insulating film 142 may include a plurality of inorganic films.

The first anode connection electrode ANDE1 may be disposed on the second interlayer insulating film 142. The first anode connection electrode ANDE1 may penetrate through the first interlayer insulating film 141 and the second interlayer insulating film 142 to be connected to the first drain electrode TD1 of the first thin film transistor ST1 via a first anode contact hole ANCT1 that exposes the first drain electrode TD1 of the first thin film transistor ST1. The first anode connection electrode ANDE1 may be formed as a single layer or multiple layers made of any one of molybdenum (Mo), aluminum (Al), chromium (Cr), gold (Au), titanium (Ti), nickel (Ni), neodymium (Nd) and copper (Cu), or an alloy thereof.

The first organic film 160 for planarization may be disposed on the first anode connection electrode ANDE1. The first organic film 160 may be formed of an organic film such as acryl resin, epoxy resin, phenolic resin, polyamide resin, polyimide resin and the like.

The second anode connection electrode ANDE2 may be disposed on the first organic film 160. The second anode connection electrode ANDE2 may be connected to the first anode connection electrode ANDE1 via the second anode contact hole ANCT2 penetrating the first organic film 160 to expose the first anode connection electrode ANDE1. The second anode connection electrode ANDE2 may be formed as a single layer or multiple layers made of any one of molybdenum (Mo), aluminum (Al), chromium (Cr), gold (Au), titanium (Ti), nickel (Ni), neodymium (Nd) and copper (Cu), or an alloy thereof.

The second organic film 180 may be disposed on the second anode connection electrode ANDE2. The second organic film 180 may be formed of an organic film such as acryl resin, epoxy resin, phenolic resin, polyamide resin, polyimide resin and the like.

Although FIG. 5 illustrates that the first thin film transistor ST1 is configured to be of a top gate type in which the first gate electrode TG1 is disposed on top of the first active layer ACT1, the present disclosure is not necessarily limited thereto. The first thin film transistor ST1 may be configured to be of a bottom gate type in which the first gate electrode TG1 is disposed under the first active layer ACT1, or a double gate type in which the first gate electrode TG1 is disposed on and under the first active layer ACT1.

The light emitting element layer EML may be disposed on the second organic film 180. The light emitting element layer EML may include light emitting elements 170 and a bank 190. Each of the light emitting elements 170 may include a first light emitting electrode 171, the light emitting layer 172, and a second light emitting electrode 173.

The first light emitting electrode 171 may be formed on the second organic film 180. The first light emitting electrode 171 may penetrate through the second organic film 180 to be connected to the second anode connection electrode ANDE2 via a third anode contact hole ANCT3 that exposes the second anode connection electrode ANDE2.

The first light emitting electrode 171 may be formed on the second organic film 180. The first light emitting electrode 171 may penetrate through the second organic film 180 to be connected to the second anode connection electrode ANDE2 via the third anode contact hole ANCT3 that exposes the second anode connection electrode ANDE2.

In a top emission structure in which light is emitted toward the second light emitting electrode 173 when viewed with respect to the light emitting layer 172, the first light emitting electrode 171 may be formed of a metal material having high reflectivity (i.e., a highly reflective material) to have a stacked structure (Ti/Al/Ti) of aluminum and titanium, a stacked structure (ITO/AI/ITO) of aluminum and ITO, an APC alloy, and a stacked structure (ITO/APC/ITO) of an APC alloy and ITO. The APC alloy is an alloy of silver (Ag), palladium (Pd) and copper (Cu).

The bank 190 may be formed on the second organic film 180 to partition the first light emitting electrode 171, thereby defining an emission area EA. The bank 190 may include an opening that exposes at least a part of the top surface of the first light emitting electrode 171. The bank 190 may cover the edge of the first light emitting electrode 171. The bank 190 may be formed of an organic film such as acryl resin, epoxy resin, phenolic resin, polyamide resin, polyimide resin and the like.

The emission area EA represents an area in which the first light emitting electrode 171, the light emitting layer 172, and the second light emitting electrode 173 are sequentially stacked, and holes from the first light emitting electrode 171 and electrons from the second light emitting electrode 173 are combined with each other in the light emitting layer 172 to emit light. The emission area EA may be defined by the opening of the bank 190.

The light emitting layer 172 is formed on the first light emitting electrode 171 and the bank 190. The light emitting layer 172 may be disposed in the opening of the bank 190, but is not necessarily limited thereto. The light emitting layer 172 may include an organic material to emit light of a predetermined color. For example, the light emitting layer 172 may include a hole transporting layer, an organic material layer, and an electron transporting layer.

The second light emitting electrode 173 may be disposed on the light emitting layer 172. The second light emitting electrode 173 may cover the light emitting layer 172. The second light emitting electrode 173 may be a common layer formed in common for all the emission areas EA. In some embodiments, a capping layer may be formed on the second light emitting electrode 173.

In the top emission structure, the second light emitting electrode 173 may be formed of transparent conductive oxide (TCO) such as indium tin oxide (ITO) and indium zinc oxide (IZO) capable of transmitting light or a semi-transmissive conductive material such as magnesium (Mg), silver (Ag), or an alloy of magnesium (Mg) and silver (Ag). When the second light emitting electrode 173 is formed of a semi-transmissive conductive material, the light emission efficiency can be increased due to a micro-cavity effect.

The thin film encapsulation layer TFEL may be disposed on the second light emitting electrode 173. The thin film encapsulation layer TFEL may include at least one inorganic film to prevent oxygen or moisture from permeating into the light emitting element layer. In addition, the thin film encapsulation layer TFEL may include at least one organic film to protect the light emitting element layer from foreign substances such as dust. For example, the thin film encapsulation layer TFEL may include a first encapsulation film TFE1, a second encapsulation film TFE2, and a third encapsulation film TFE3.

The first encapsulation film TFE1 (e.g., a first inorganic encapsulation film) may be disposed on the second light emitting electrode 173. The first encapsulation film TFE1 may be an inorganic film of a single layer or multiple layers. The first encapsulation film TFE1 may be formed as a single layer or a multilayer structure in which one or more inorganic films of a silicon nitride layer, a silicon oxynitride layer, a silicon oxide layer, a titanium oxide layer and an aluminum oxide layer are alternately stacked.

The second encapsulation film TFE2 (e.g., a first organic encapsulation film) may be disposed on the first encapsulation film TFE1. The second encapsulation film TFE2 may be an organic film of a single layer or multiple layers. The second encapsulation film TFE2 may include a polymer-based material. Polymer-based materials may include polyethylene terephthalate, polyethylene naphthalate, polycarbonate, polyimide, polyethylene sulfonate, polyoxymethylene, polyarylate, hexamethyldisiloxane, and acrylic resins (e.g., polymethyl methacrylate, polyacrylic acid, or the like), or any combination thereof.

The third encapsulation film TFE3 (e.g., a second inorganic encapsulation film) may be disposed on the second encapsulation film TFE2. The third encapsulation film TFE3 may be an inorganic film of a single layer or multiple layers. The third encapsulation film TFE3 may include the same material as the first encapsulation film TFE1. For example, the third encapsulation film TFE3 may be formed as a single layer or a multilayer structure in which one or more inorganic films of a silicon nitride layer, a silicon oxynitride layer, a silicon oxide layer, a titanium oxide layer and an aluminum oxide layer are alternately stacked.

The touch sensor layer TSU may be disposed on the thin film encapsulation layer TFEL. The touch sensor layer TSU may include a plurality of touch electrodes for sensing a user's touch in a capacitive manner and the touch lines connecting the plurality of touch electrodes to a touch driver. For example, the touch sensor layer TSU may sense the user's touch by using a mutual capacitance method or a self-capacitance method.

In an embodiment, the touch sensor layer TSU may be disposed on a separate substrate disposed on the display layer DU. In this case, the substrate supporting the touch sensor layer TSU may be an encapsulation member encapsulating the display layer DU.

The plurality of touch electrodes of the touch sensor layer TSU may be disposed in a touch sensor area overlapping the display area. The touch lines of the touch sensor layer TSU may be disposed in the touch peripheral area overlapping the non-display area.

The touch sensor layer TSU may include a first touch insulating film SIL1, a first touch electrode REL, a second touch insulating film SIL2, a second touch electrode TEL, and a third touch insulating film SIL3.

The first touch insulating film SIL1 may be disposed on the thin film encapsulation layer TFEL. The first touch insulating film SIL1 may have insulating and optical functions. The first touch insulating film SIL1 may include at least one inorganic film. For example, the first touch insulating film SIL1 may be an inorganic film containing at least one of a silicon nitride layer, a silicon oxynitride layer, a silicon oxide layer, a titanium oxide layer, or an aluminum oxide layer. Optionally, the first touch insulating film SIL1 may be omitted.

The first touch electrode REL may be disposed on the first touch insulating film SIL1. The first touch electrode REL might not overlap the light emitting element 170. The first touch electrode REL may be formed as a single layer containing molybdenum (Mo), titanium (Ti), copper (Cu), aluminum (Al), or indium tin oxide (ITO), or may have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The second touch insulating film SIL2 may cover the first touch electrode REL and the first touch insulating film SIL1. The second touch insulating film SIL2 may have insulating and optical functions. For example, the second touch insulating film SIL2 may be made of the material exemplified in association with the first touch insulating film SIL1.

The second touch electrode TEL may be disposed on the second touch insulating film SIL2. The second touch electrode TEL might not overlap the light emitting element 170. The second touch electrode TEL may be formed as a single layer containing molybdenum (Mo), titanium (Ti), copper (Cu), aluminum (Al), or indium tin oxide (ITO), or may have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The third touch insulating film SIL3 may cover the second touch electrode TEL and the second touch insulating film SIL2. The third touch insulating film SIL3 may have insulating and optical functions. The third touch insulating film SIL3 may be made of the material exemplified in association with the second touch insulating film SIL2.

In some embodiments, the first touch insulating film SIL1, the second touch insulating film SIL2, and the third touch insulating film SIL3 may be organic films. Each of the first touch insulating film SIL1, the second touch insulating film SIL2, and the third touch insulating film SIL3 may be an organic film such as acryl resin, epoxy resin, phenolic resin, polyamide resin, polyimide resin, or the like.

The touch sensor layer TSU may further include a planarization film PAS for planarization. The planarization film PAS may be formed of an organic film such as acryl resin, epoxy resin, phenolic resin, polyamide resin, polyimide resin and the like.

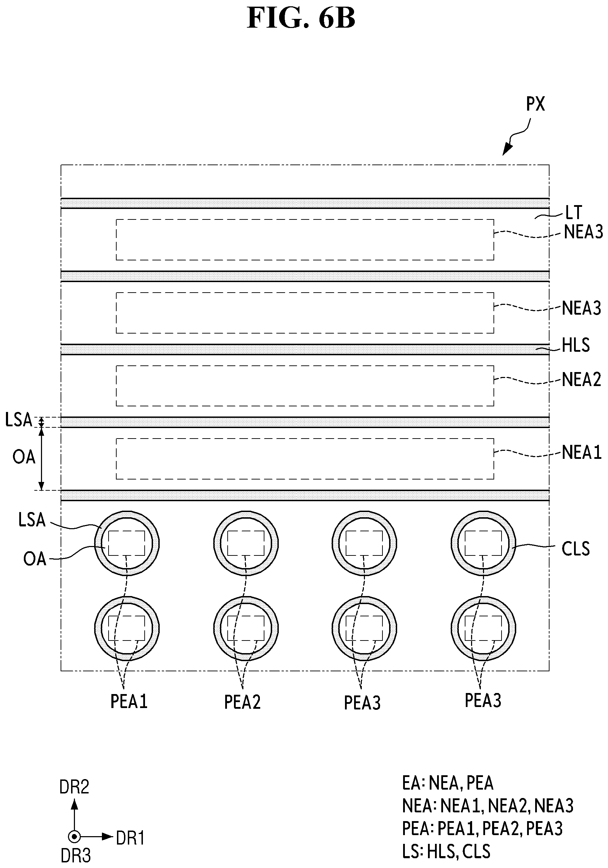

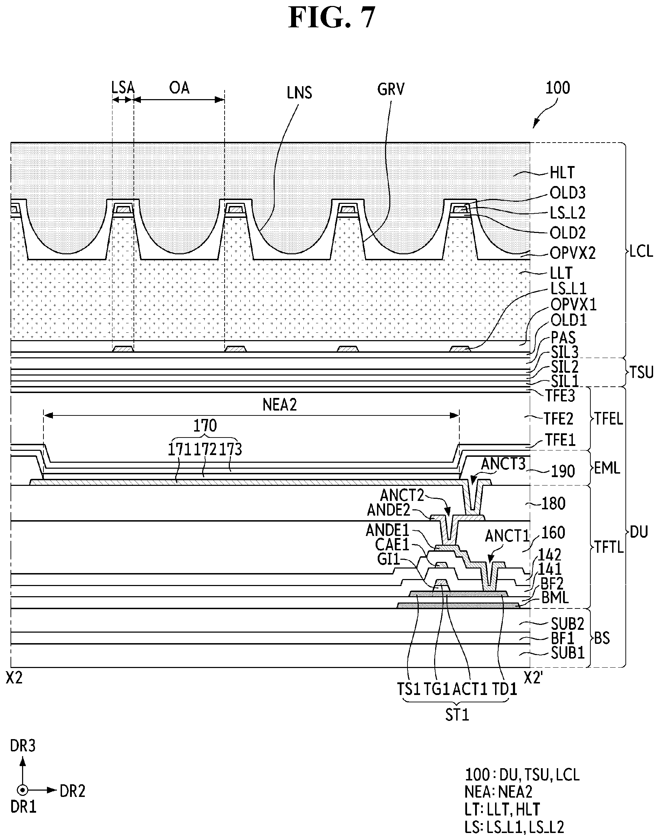

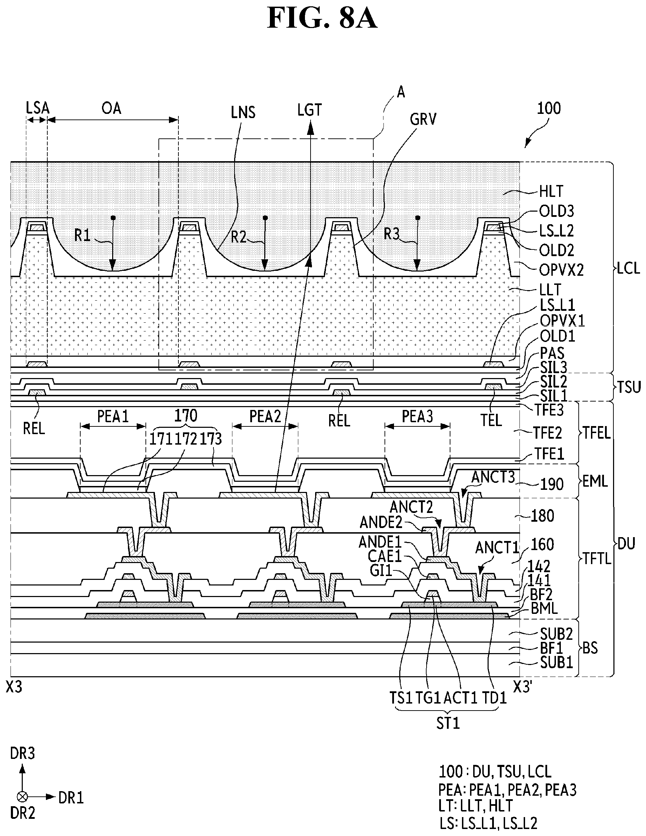

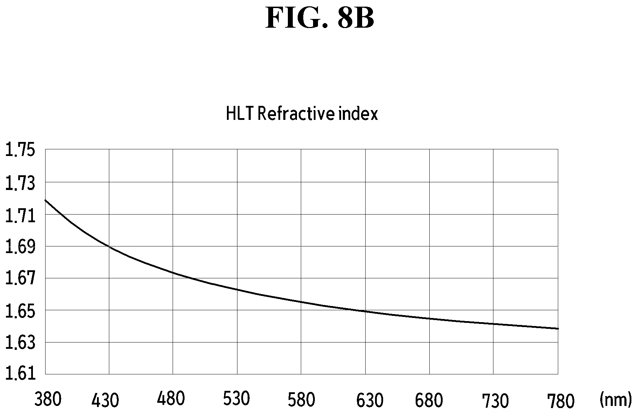

FIG. 6A is a cross-sectional view illustrating an example of a portion of a display area according to an embodiment. FIG. 6B is a plan view showing another example of a portion of a display area according to an embodiment. FIG. 7 is a cross-sectional view of a display panel taken along line X2-X2' of FIG. 6A. FIG. 8A is a cross-sectional view of a display panel taken along line X3-X3' of FIG. 6A. FIG. 8B is a graph showing changes in a refractive index of a high refractive transmitting film according to a wavelength of light.

Referring to FIGS. 6A, 6B, 7, 8A, and 8B in addition to FIG. 4, each of the pixels PX may include a plurality of emission areas EA. The emission area EA may be an area in which light generated by the light emitting element 170 is permitted to pass through.

The plurality of emission areas EA may be defined by the bank 190. For example, the plurality of emission areas EA may be areas overlapping the light emitting layer 172 disposed in openings of the bank 190. The emission area EA may be an area in which the first light emitting electrode 171, the light emitting layer 172, and the second light emitting electrode 173 are sequentially stacked while overlapping each other.

In some embodiments, the plurality of emission areas EA may include a normal mode area NEA and a privacy mode area PEA. The normal mode area NEA may include first to third emission areas NEA1, NEA2, and NEA3, and the privacy mode area PEA may include first to third emission areas PEA1, PEA2, and PEA3.

Although it is illustrated in the drawing that each of the normal mode area NEA and the privacy mode area PEA includes three types of emission areas EA, the present disclosure is not necessarily limited thereto. For example, each of the normal mode area NEA and the privacy mode area PEA may include fewer or more than three types of emission areas EA.

Although FIG. 6A illustrates that the normal mode area NEA includes one first emission area NEA1, one second emission area NEA2, and one third emission area NEA3, and the privacy mode area PEA includes one first emission area PEA1, one second emission area PEA2, and two third emission areas PEA3, the present disclosure is not necessarily limited thereto. Although FIG. 6B illustrates that the normal mode area NEA includes one first emission area NEA1, one second emission area NEA2, and two third emission areas NEA3, and the privacy mode area PEA includes two first emission areas PEA1, two second emission areas PEA2, and four third emission areas PEA3, the present disclosure is not necessarily limited thereto. For example, the number of emission areas EA may be variously changed.

In some embodiments, the first emission areas NEA1 and PEA1 may emit light of a first color, the second emission areas NEA2 and PEA2 may emit light of a second color, and the third emission areas NEA3 and PEA3 may emit light of a third color. The light of the first color may be light of a red wavelength band, the light of the second color may be light of a green wavelength band, and the light of the third color may be light of a blue wavelength band. The red wavelength band may be a wavelength band within a range of about 600 nm to 750 nm, inclusive, the green wavelength band may be a wavelength band within a range of about 480 nm to 560 nm, inclusive, and the blue wavelength band may be a wavelength band within a range of about 370 nm to 460 nm, inclusive, but the present disclosure is not necessarily limited thereto.

Each of the first to third emission areas NEA1, NEA2, NEA3, PEA1, PEA2, and PEA3 may have a rectangular, square, or rhombic planar shape. For example, as illustrated in the drawing, the first to third emission areas NEA1, NEA2, NEA3, PEA1, PEA2, and PEA3 may have a rectangular shape, but the present disclosure is not necessarily limited thereto.

In an embodiment, as illustrated in FIG. 6A, each of the first to third emission areas NEA1, NEA2, NEA3, PEA1, PEA2, and PEA3 may extend in the second direction DR2. In an embodiment, as illustrated in FIG. 6B, each of the first to third emission areas NEA1, NEA2, NEA3, PEA1, PEA2, and PEA3 may extend in the first direction DR1.

In an embodiment, the areas of the first to third emission areas NEA1, NEA2, NEA3, PEA1, PEA2, and PEA3 may be different from each other. For example, as illustrated in FIG. 6A, the area of the third emission area NEA3 of the normal mode area NEA may be greater than the areas of the first and second emission areas NEA1 and NEA2 of the normal mode area NEA, but the present disclosure is not necessarily limited thereto.

In an embodiment, the areas of the first to third emission areas NEA1, NEA2, NEA3, PEA1, PEA2, and PEA3 may be the same. For example, as illustrated in FIG. 6B, the areas of the first to third emission areas PEA1, PEA2, and PEA3 of the normal mode area NEA may be the same, but the present disclosure is not necessarily limited thereto.

For example, without necessarily being limited to that illustrated in the drawing, the areas of the first to third emission areas NEA1, NEA2, and NEA3 in the normal mode area NEA and the areas of the first to third emission areas PEA1, PEA2, and PEA3 in the privacy mode area PEA may be variously changed.

In some embodiments, as shown in FIG. 6A, the first to third emission areas NEA1, NEA2, NEA3, PEA1, PEA2, and PEA3 may be arranged side by side along the first direction DR1. For example, the first to third emission areas NEA1, NEA2, and NEA3 may be arranged in that order along the first direction DR1 in the normal mode area NEA, and the first to third emission areas PEA1, PEA2, and PEA3 may be arranged in that order along the first direction DR1 in the privacy mode area PEA.

In an embodiment, as illustrated in FIG. 6B, the first to third emission areas NEA1, NEA2, and NEA3 may be arranged side by side along the second direction DR2. In an embodiment, the first to third emission areas NEA1, NEA2, NEA3, PEA1, PEA2, and PEA3 may be arranged to overlap in both the first direction DR1 and the second direction DR2. For example, the arrangement of the first to third emission areas NEA1, NEA2, NEA3, PEA1, PEA2, and PEA3 may be variously changed.

The emission areas EA may overlap the transmission area OA and the non-transmission area LSA in the third direction DR3. For example, the first to third emission areas NEA1, NEA2, NEA3, PEA1, PEA2, and PEA3 may overlap the transmission area OA and the non-transmission area LSA in the third direction DR3.

The transmission area OA may be an area in which the light blocking film LS of the light control layer LCL is not disposed. The non-transmission area LSA may be an area in which the light blocking film LS of the light control layer LCL is disposed.

In an embodiment, as illustrated in FIG. 6A, in the normal mode area NEA, the transmission area OA and the non-transmission area LSA may extend in the first direction DR1, and in the privacy mode area PEA, the non-transmission area LSA may extend in the first direction DR1 and the second direction DR2 and surround the transmission area OA.

In an embodiment, as illustrated in FIG. 6B, in the normal mode area NEA, the transmission area OA and the non-transmission area LSA may extend in the first direction DR1, and in the privacy mode area PEA, the non-transmission area LSA may surround the first to third emission areas PEA1, PEA2, and PEA3.

In some embodiments, in the normal mode area NEA, the transmission area OA and the non-transmission area LSA may extend along the first direction DR1, and may be arranged alternately in the second direction DR2. In the privacy mode area PEA, the transmission area OA may be surrounded by the non-transmission area LSA. For example, as illustrated in FIG. 6A, the non-transmission area LSA may have a quadrilateral shape extending in the first direction DR1 and the second direction DR2. For example, as illustrated in FIG. 6B, the non-transmission area LSA may have a circular shape surrounding the transmission area OA. The shape of the non-transmission area LSA is not necessarily limited to a quadrilateral shape or a circular shape.

As illustrated in FIGS. 7 and 8A, the light control layer LCL may be disposed on the display layer DU or the touch sensor layer TSU. The light control layer LCL may control a viewing angle of light emitted from the light emitting layer 172. For example, when the light emitted from the light emitting layer 172 travels at a predetermined angle or less with respect to the third direction DR3, it may be permitted to pass through. When the light emitted from the light emitting layer 172 travels beyond a predetermined angle with respect to the third direction DR3, it may be absorbed or blocked by the light blocking film LS and might not be permitted to pass through.

The light control layer LCL may include the light transmitting film LT and the light blocking film LS.

As illustrated in FIGS. 7 and 8A, the light blocking film LS may be disposed on the display layer DU or the touch sensor layer TSU. The light blocking film LS may be disposed in the non-transmission area LSA. The light blocking film LS may absorb or block the light emitted from the light emitting layer 172. The light blocking film LS may include a light blocking organic material. For example, the light blocking film LS may be a photosensitive resin capable of absorbing or blocking light, and may include an organic material containing an organic black pigment such as carbon black.

In some embodiments, as illustrated in FIG. 6A, the light blocking film LS may extend along the first direction DR1 in the normal mode area NEA, and may extend along the first direction DR1 and the second direction DR2 in the privacy mode area PEA. In this case, the light blocking film LS may include a horizontal light blocking film HLS extending in the first direction DR1, and a vertical light blocking film VLS extending in the second direction DR2.

In this specification, the horizontal direction and the vertical direction of the horizontal light blocking film HLS and the vertical light blocking film VLS may refer to the first direction DR1 and the second direction DR2 in the drawing, respectively, but this is an example, and the extension direction of the light blocking film LS is not necessarily limited to the horizontal direction and the vertical direction.

In the normal mode area NEA, the horizontal light blocking films HLS may be spaced apart from each other along the second direction DR2. In the privacy mode area PEA, the vertical light blocking films VLS may be spaced apart from each other along the first direction DR1, and the horizontal light blocking films HLS may be spaced apart from each other along the second direction DR2. In the privacy mode area PEA, the vertical light blocking films VLS and the horizontal light blocking films HLS may be directly connected to each other, but the present disclosure is not necessarily limited thereto.

In an embodiment, as illustrated in FIG. 6B, the light blocking film LS may extend along the first direction DR1 in the normal mode area NEA, and may have a circular shape or a donut shape surrounding the first to third emission areas PEA1, PEA2, and PEA3 in the privacy mode area PEA. In this case, the light blocking film LS may include the horizontal light blocking film HLS extending in the first direction DR1 and a donut-shaped circumferential light blocking film CLS.

In the normal mode area NEA, the horizontal light blocking films HLS may be spaced apart from each other along the second direction DR2. In the privacy mode area PEA, the circumferential light blocking films CLS may be spaced apart from each other along the first direction DR1 and the second direction DR2.

The display device 10, according to the present embodiment, may adjust and change upper and lower viewing angles and left and right viewing angles according to the extension direction and driving method of the light blocking film LS in the normal mode area NEA and the privacy mode area PEA.

For example, in the embodiment of FIG. 6A, in the normal mode area NEA and the privacy mode area PEA, the horizontal light blocking films HLS may minimize the light LGT1 reflected on the windshield W of FIG. 4 by controlling the viewing angle in the second direction DR2. In the privacy mode area PEA, the vertical light blocking films VLS may minimize the light LGT2 provided toward the driver PS1 or the passenger PS2 of FIG. 4 by controlling the viewing angle in the first direction DR1.

Alternatively, in the embodiment of FIG. 6B, the horizontal light blocking films HLS of the normal mode area NEA and the circumferential light blocking films CLS of the privacy mode area PEA may minimize the light LGT1 reflected on the windshield W of FIG. 4 by controlling the viewing angle in the second direction DR2. In the privacy mode area PEA, the circumferential light blocking films CLS may minimize the light LGT2 provided toward the driver PS1 or the passenger PS2 of FIG. 4 by controlling the viewing angle in the first direction DR1.

As illustrated in FIGS. 7 and 8A, the light transmitting film LT may be disposed on the display layer DU or the touch sensor layer TSU. The light transmitting film LT may be disposed in the transmission area OA and the non-transmission area. The light transmitting film LT may transmit the light emitted from the light emitting layer 172. The light transmitting film LT may include a transparent organic material. For example, the light transmitting film LT may include an organic film such as acryl resin, epoxy resin, phenolic resin, polyamide resin, polyimide resin and the like. In an embodiment, the light transmitting film LT may include silicon oxynitride or silicon oxide.

In some embodiments, the light transmitting film LT may extend along the first direction DR1 in the normal mode area NEA, and may be surrounded by the light blocking film LS in the privacy mode area PEA. For example, the light transmitting film LT may be disposed between the horizontal light blocking films HLS in the normal mode area NEA, and may be surrounded by the horizontal light blocking films HLS and the vertical light blocking films VLS in the privacy mode area PEA.

The light control layer LCL may include a first medium layer OLD1, a first light blocking layer LS_L1, a first light transmitting lower film OPVX1, a low refractive transmitting film LLT, a second medium layer OLD2, a second light blocking layer LS_L2, a third medium layer OLD3, a second light transmitting lower film OPVX2, and a high refractive transmitting film HLT. The first light blocking layer LS_L1 and the second light blocking layer LS_L2 may be included in the light blocking film LS. The low refractive transmitting film LLT and the high refractive transmitting film HLT may be included in the light transmitting film LT.

The first medium layer OLD1 may be disposed on the display layer DU or the touch sensor layer TSU. The first medium layer OLD1 may include a transparent inorganic material. For example, the first medium layer OLD1 may include at least one of silicon oxide (SiOₓ), silicon nitride (SiNₓ), or silicon oxynitride (SiOₓN_{y}). In an embodiment, the first medium layer OLD1 may include silicon nitride (SiNₓ), and the thickness of the first medium layer OLD1 may be within a range of about 500 Å to 1000 Å, inclusive, but is not necessarily limited thereto. Here, the thickness of the first medium layer OLD1 refers to a distance in the third direction DR3 from the top surface to the bottom surface of the first medium layer OLD1.

The first medium layer OLD1 may be disposed between the first light transmitting lower film OPVX1 and the organic film (e.g., the planarization film PAS of the touch sensor layer TSU) to increase interfacial properties so that the first light transmitting lower film OPVX1 may be easily deposited on the organic film during the deposition process of the first light transmitting lower film OPVX1. For example, when the first light transmitting lower film OPVX1 is directly deposited on the organic film having interfacial properties different from those of the first light transmitting lower film OPVX1, deposition particles might not be easily deposited on the organic film. When the first medium layer OLD1 is disposed on the organic film, the deposition particles of the first light transmitting lower film OPVX1 may be easily deposited on the first medium layer OLD1.

The first light blocking layer LS_L1 may be disposed on the first medium layer OLD1. The first light blocking layer LS_L1 may absorb or block the light emitted from the light emitting layer 172. The first light blocking layer LS_L1 may include a light blocking organic material. In an embodiment, the thickness of the first light blocking layer LS_L1 may be within a range of approximately 1 µm to 2 µm, inclusive, but is not necessarily limited thereto. Here, the thickness of the first light blocking layer LS_L1 refers to a distance in the third direction DR3 from the top surface to the bottom surface of the first light blocking layer LS_L1.

The first light blocking layer LS_L1 may include a plurality of first light blocking patterns. The plurality of first light blocking patterns may be spaced apart from each other in the first direction DR1 or the second direction DR2. The plurality of first light blocking patterns may be arranged in the non-transmission area LSA. In some embodiments, as illustrated in FIG. 7, some of the plurality of first light blocking patterns may overlap the light emitting element 170 of the normal mode area NEA. As illustrated in FIG. 8A, the plurality of first light blocking patterns might not overlap the light emitting element 170 of the privacy mode area PEA. The plurality of first light blocking patterns may overlap the bank 190 disposed between the privacy mode areas PEA, and may overlap the first touch electrode REL and the second touch electrode TEL.

The first light transmitting lower film OPVX1 may be disposed on the first medium layer OLD1. The first light transmitting lower film OPVX1 may cover the top surfaces and side surfaces of the plurality of first light blocking patterns of the first light blocking layer LS_L1. The first light transmitting lower film OPVX1 may transmit light emitted from the light emitting layer 172. The first light transmitting lower film OPVX1 may include a transparent organic material. In an embodiment, the thickness of the first light transmitting lower film OPVX1 may be within a range of approximately 2.5 µm to 5 µm, inclusive, but is not necessarily limited thereto. Here, the thickness of the first light transmitting lower film OPVX1 refers to a distance in the third direction DR3 from the top surface to the bottom surface of the first light transmitting lower film OPVX1.

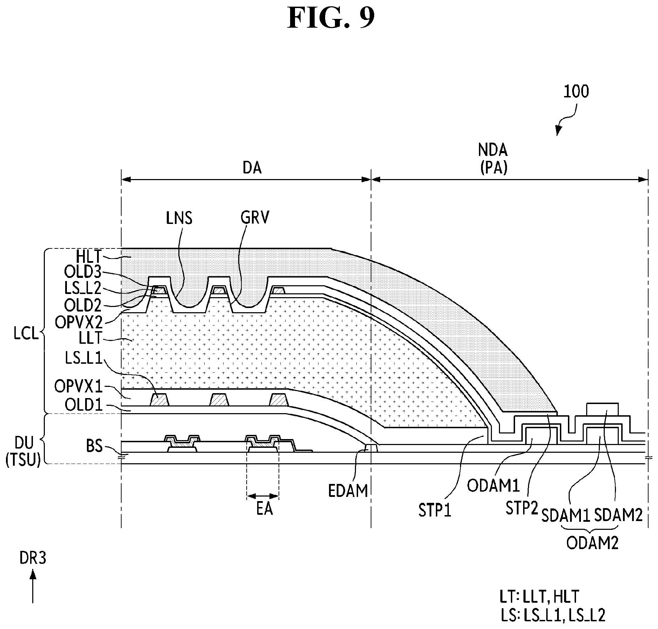

The first light transmitting lower film OPVX1 may be a lower film for preventing overflow of the light transmitting film LT at the outer portion of the display panel 100. For example, the first light transmitting lower film OPVX1 may prevent overflow of the low refractive transmitting film LLT at the outer portion of the display panel 100. The prevention of the overflow of the first light transmitting lower film OPVX1 will be described with reference to FIG. 9.

The low refractive transmitting film LLT may be disposed on the first light transmitting lower film OPVX1. The low refractive transmitting film LLT may transmit the light emitted from the light emitting layer 172. The low refractive transmitting film LLT may include a transparent organic material. In an embodiment, the thickness of the low refractive transmitting film LLT may be within a range of approximately 15 µm to 30 µm, inclusive, but is not necessarily limited thereto. Here, the thickness of the low refractive transmitting film LLT refers to a distance in the third direction DR3 from the top surface disposed at the uppermost end of the low refractive transmitting film LLT to the bottom surface disposed at the lowermost end of the low refractive transmitting film LLT.

In some embodiments, the low refractive transmitting film LLT may be formed by an inkjet printing process and a dry etching process. The first light transmitting lower film OPVX1 may be formed by a deposition process and a photolithography process. The low refractive transmitting film LLT may include a material different from that of the first light transmitting lower film OPVX1. For example, the low refractive transmitting film LLT may include at least one of an ester-based compound or a phosphine oxide compound. For example, the number of carbon atoms of the ester-based compound may be 30 or less. The first light transmitting lower film OPVX1 may include at least one of propylene glycol methyl ether acetate, methacrylic acid-benzylmethacrylic acid copolymer, multi-functional acrylate, or a photo initiator.

The low refractive transmitting film LLT may include a plurality of grooves GRV. The plurality of grooves GRV may have a shape that is recessed in a direction opposite to the third direction DR3 from the top surface disposed at the uppermost end of the low refractive transmitting film LLT. The plurality of grooves GRV may be spaced apart from each other in the first direction DR1 or the second direction DR2. A partition wall may be disposed between the plurality of grooves GRV spaced apart from each other. The plurality of grooves GRV may be arranged between the first light blocking patterns of the first light blocking layer LS_L1 and second light blocking patterns of the second light blocking layer LS_L2. The plurality of grooves GRV may provide a space for disposing a lens unit LNS of the high refractive transmitting film HLT to be described later. In an embodiment, the depth of the plurality of grooves GRV may be within a range of approximately 5 µm to 10 µm, inclusive, but is not necessarily limited thereto. Here, the depth of the grooves GRV refers to a length in the third direction DR3 from the top surface disposed at the uppermost end of the low refractive transmitting film LLT to the bottom surfaces of the grooves GRV.

The second medium layer OLD2 may be disposed on the low refractive transmitting film LLT. For example, the second medium layer OLD2 may be disposed on the top surface disposed at the uppermost end of the low refractive transmitting film LLT. The second medium layer OLD2 may be disposed on the partition walls of the low refractive transmitting film LLT. The second medium layer OLD2 might not overlap the plurality of grooves GRV of the low refractive transmitting film LLT.

The second medium layer OLD2 may include a transparent inorganic material. For example, the second medium layer OLD2 may include at least one of silicon oxide (SiOₓ), silicon nitride (SiNₓ), or silicon oxynitride (SiOₓN_{y}). In an embodiment, the second medium layer OLD2 may include silicon oxide (SiOₓ) or silicon oxynitride (SiOₓN_{y}), and the thickness of the second medium layer OLD2 may be within a range of approximately 500 Å to 1000 Å, inclusive, but is not necessarily limited thereto. Here, the thickness of the second medium layer OLD2 refers to a distance in the third direction DR3 from the top surface to the bottom surface of the second medium layer OLD2.

The second light blocking layer LS_L2 may be disposed on the second medium layer OLD2. The second light blocking layer LS_L2 may be disposed on the top surface disposed at the uppermost end of the low refractive transmitting film LLT. The second light blocking layer LS_L2 may be disposed on the partition walls of the low refractive transmitting film LLT. The second light blocking layer LS_L2 may absorb or block the light emitted from the light emitting layer 172. The second light blocking layer LS_L2 may include a light blocking organic material. In an embodiment, the thickness of the second light blocking layer LS_L2 may be within a range of approximately 1 µm to 2 µm, inclusive, but is not necessarily limited thereto. Here, the thickness of the second light blocking layer LS_L2 refers to a distance in the third direction DR3 from the top surface to the bottom surface of the second light blocking layer LS_L2.

The second light blocking layer LS_L2 may include the plurality of second light blocking patterns. The plurality of second light blocking patterns may be spaced apart from each other in the first direction DR1 or the second direction DR2. The plurality of first light blocking patterns may be arranged in the non-transmission area LSA. The plurality of second light blocking patterns may overlap the plurality of first light blocking patterns in the third direction DR3. In some embodiments, as illustrated in FIG. 7, some of the second light blocking patterns may overlap the light emitting element 170 of the normal mode area NEA. As illustrated in FIG. 8A, the plurality of second light blocking patterns might not overlap the light emitting element 170 of the privacy mode area PEA. The plurality of second light blocking patterns may overlap the bank 190 disposed between the privacy mode areas PEA, and may overlap the first touch electrode REL and the second touch electrode TEL.

The third medium layer OLD3 may be disposed on the second light blocking layer LS_L2. For example, the third medium layer OLD3 may be disposed on the top surface disposed at the uppermost end of the low refractive transmitting film LLT. The third medium layer OLD3 may be disposed on the partition walls of the low refractive transmitting film LLT. The third medium layer OLD3 might not overlap the plurality of grooves GRV of the low refractive transmitting film LLT. The third medium layer OLD3 may cover the top surface and the side surface of the second light blocking layer LS_L2.

The third medium layer OLD3 may include a transparent inorganic material. For example, the third medium layer OLD3 may include at least one of silicon oxide (SiOₓ), silicon nitride (SiNₓ), or silicon oxynitride (SiOₓN_{y}). In an embodiment, the third medium layer OLD3 may include silicon oxide (SiOₓ) or silicon oxynitride (SiOₓN_{y}), and the thickness of the third medium layer OLD3 may be within a range of approximately 500 Å to 1500 Å, inclusive, but is not necessarily limited thereto. Here, the thickness of the third medium layer OLD3 refers to a distance in the third direction DR3 between the top surface of the second light blocking layer LS_L2 and the top surface of the third medium layer OLD3.

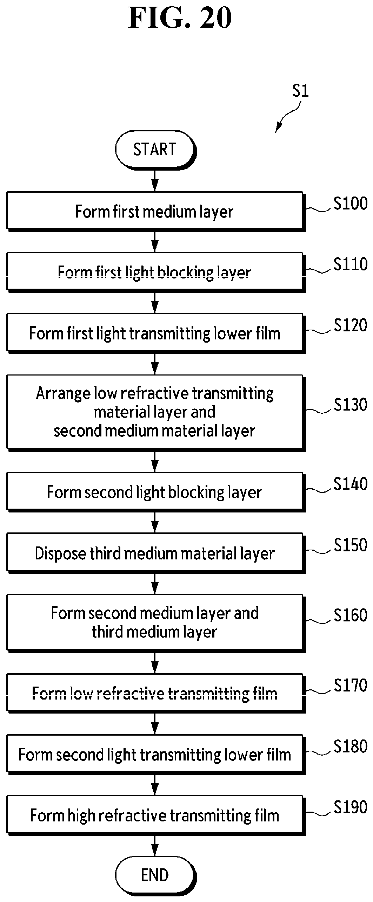

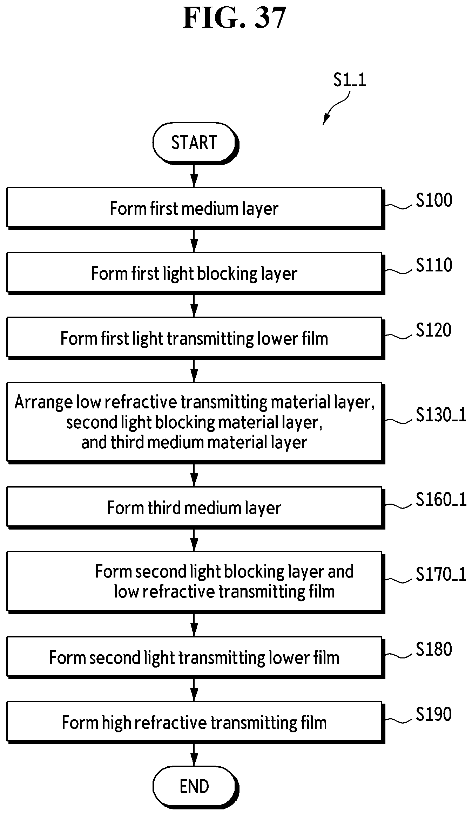

The second medium layer OLD2 and the third medium layer OLD3 may be disposed between the second light transmitting lower film OPVX2 and the organic film (e.g., the low refractive transmitting film LLT) to increase interfacial properties so that the second light transmitting lower film OPVX2 may be easily deposited on the organic film during the deposition process of the second light transmitting lower film OPVX2. Further, the second medium layer OLD2 and the third medium layer OLD3 may serve as a photomask or a photoresist in a process of forming the second light blocking layer LS_L2 or the groove GRV of the low refractive transmitting film LLT. This will be described with reference to FIG. 20 and the like together with methods S1 and S1_1 for manufacturing a display device (see FIGS. 20 and 37).

The second light transmitting lower film OPVX2 may be disposed on the low refractive transmitting film LLT and the third medium layer OLD3. The second light transmitting lower film OPVX2 may transmit light emitted from the light emitting layer 172. The second light transmitting lower film OPVX2 may include a transparent organic material. In an embodiment, the thickness of the second light transmitting lower film OPVX2 may be within a range of approximately 2.5 µm to 5 µm, inclusive, but is not necessarily limited thereto. Here, the thickness of the second light transmitting lower film OPVX2 refers to a distance in the third direction DR3 from the top surface of the second light transmitting lower film OPVX2 to the top surface of the third medium layer OLD3.

The second light transmitting lower film OPVX2 may be conformally disposed along the groove GRV of the low refractive transmitting film LLT, the side surface of the second medium layer OLD2, and the third medium layer OLD3. For example, the shape of the bottom surface of the second light transmitting lower film OPVX2 may correspond to the shapes of the groove GRV of the low refractive transmitting film LLT, the side surface of the second medium layer OLD2, and the side surface and top surface of the third medium layer OLD3.

The shape of the top surface of the second light transmitting lower film OPVX2 may be a shape that is concave, bending toward the display layer DU. For example, a portion of the top surface of the second light transmitting lower film OPVX2 that overlaps the groove GRV of the low refractive transmitting film LLT may have a shape that is concave, bending toward the display layer DU, and a portion of the top surface of the second light transmitting lower film OPVX2 that overlaps the partition wall of the low refractive transmitting film LLT may have a flat shape.

The second light transmitting lower film OPVX2 may be a lower film for preventing overflow of the light transmitting film LT at the outer portion of the display panel 100. For example, the second light transmitting lower film OPVX2 may prevent overflow of the high refractive transmitting film HLT at the outer portion of the display panel 100. The prevention of the overflow of the second light transmitting lower film OPVX2 will be described with reference to FIG. 9.

The high refractive transmitting film HLT may be disposed on the second light transmitting lower film OPVX2. The high refractive transmitting film HLT may transmit the light emitted from the light emitting layer 172. The high refractive transmitting film HLT may include a transparent organic material. In an embodiment, the thickness of the high refractive transmitting film HLT may be within a range of approximately 20 µm to 30 µm, inclusive, but is not necessarily limited thereto. Here, the thickness of the high refractive transmitting film HLT refers to a distance in the third direction DR3 from the top surface to the bottom surface of the high refractive transmitting film HLT including the lens unit LNS.

In some embodiments, the high refractive transmitting film HLT may be formed by an inkjet printing process. The second light transmitting lower film OPVX2 may be formed by a deposition process or a photolithography process. The high refractive transmitting film HLT may include a material different from that of the second light transmitting lower film OPVX2. For example, the high refractive transmitting film HLT may include at least one of an ester-based compound or a phosphine oxide compound. For example, the number of carbon atoms of the ester-based compound may be 30 or less. The second light transmitting lower film OPVX2 may include at least one of propylene glycol methyl ether acetate, methacrylic acid-benzylmethacrylic acid copolymer, multi-functional acrylate, or a photo initiator.

The high refractive transmitting film HLT may include a plurality of lens units LNS. The plurality of lens units LNS may be disposed in the plurality of grooves GRV of the low refractive transmitting film LLT. The plurality of lens units LNS may correspond to the shape of the top surface of the second light transmitting lower film OPVX2. The plurality of lens units LNS may have a shape protruding in the opposite direction of the third direction DR3 from the upper layer portion of the high refractive transmitting film HLT. Here, the upper layer portion refers to a portion that is disposed on the lens unit LNS, and is disposed in the entire surface of the display panel 100 across the transmission area OA and the non-transmission area LSA. In an embodiment, the thickness of the lens unit LNS may be within a range of approximately 5 µm to 10 µm, inclusive, but is not necessarily limited thereto. Here, the thickness of the lens unit LNS refers to a distance in the third direction DR3 from the boundary where the upper layer portion of the high refractive transmitting film HLT and the lens unit LNS meet to the bottom surface disposed at the lowermost end of the lens unit LNS.

The plurality of lens units LNS may be spaced apart from each other in the first direction DR1 or the second direction DR2. The plurality of lens units LNS may be arranged in the transmission area OA. The partition wall of the low refractive transmitting film LLT, the second medium layer OLD2, the second light blocking layer LS_L2, and the third medium layer OLD3 may be arranged between the plurality of lens units LNS spaced apart from each other. In some embodiments, as illustrated in FIG. 7, the plurality of lens units LNS may overlap the light emitting element 170 of the normal mode area NEA. As illustrated in FIG. 8A, the plurality of lens units LNS may overlap the light emitting element 170 of the privacy mode area PEA.

In some embodiments, the refractive index of the high refractive transmitting film HLT may be greater than the refractive index of the low refractive transmitting film LLT. For example, a difference in refractive index of the high refractive transmitting film HLT and the low refractive transmitting film LLT may be approximately 0.1 or more. In an embodiment, the refractive index of the high refractive transmitting film HLT may be within a range of approximately 1.5 to 1.8, 1.6 to 1.9 inclusive, and the refractive index of the low refractive transmitting film LLT may be within a range of approximately 1.2 to 1.5, 1.4 to 1.7, inclusive.

In the present disclosure, the refractive index refers to an absolute refractive index measured using sodium D-lines (yellow light with a wavelength λ of approximately 589 nm) at room temperature and humidity (temperature of 20±15°C, humidity of 65±20%). For example, in the present specification, the refractive index may be an absolute refractive index measured based on a wavelength of 589 nm according to Cauchy's model using a refractive index meter (e.g., the advanced spectroscopic ellipsometer, M-2000 ellipsometer, developed and produced by J.A. Woollam Co., Inc.) under a temperature of 25°C and a relative humidity of 65%.

In some embodiments, the size of the lens unit LNS overlapping the first emission areas NEA1 and PEA1, the size of the lens unit LNS overlapping the second emission areas NEA2 and PEA2, and the size of the lens unit LNS overlapping the third emission areas NEA3 and PEA3 may be different from each other. For example, when the lens unit LNS has a circular shape, a first radius of curvature R1 of the lens unit LNS overlapping the first emission areas NEA1 and PEA1, a second radius of curvature R2 of the lens unit LNS overlapping the second emission areas NEA2 and PEA2, and a third radius of curvature R3 of the lens unit LNS overlapping the third emission areas NEA3 and PEA3 may be different from each other. In another example, when the lens unit LNS has an elliptical shape, a first semi-minor axis (or semi-major axis) of the lens unit LNS overlapping the first emission areas NEA1 and PEA1, a second semi-minor axis (or semi-major axis) of the lens unit LNS overlapping the second emission areas NEA2 and PEA2, and a third semi-minor axis (or semi-major axis) of the lens unit LNS overlapping the third emission areas NEA3 and PEA3 may be different from each other.

In some embodiments, the average curvature of the lens unit LNS overlapping the first emission areas NEA1 and PEA1, the average curvature of the lens unit LNS overlapping the second emission areas NEA2 and PEA2, and the average curvature of the lens unit LNS overlapping the third emission areas NEA3 and PEA3 may be different from each other.

As shown in FIG. 8B, the refractive index of the high refractive transmitting film HLT may vary depending on the wavelength of light. Therefore, in the display device 10 according to the present embodiment, at least one of the size or the average curvature of the lens unit LNS overlapping each of the first to third emission areas NEA1, PEA1, NEA2, PEA2, NEA3, and PEA3 may be different. Accordingly, at least one of the size or the average curvature of the lens unit LNS is different depending on the wavelength of light emitted from the first to third emission areas NEA1, PEA1, NEA2, PEA2, NEA3, and PEA3, so that the refractive effect of the lens unit LNS may be maintained the same for each emission area EA.

The display device 10, according to the present embodiment, includes the lens unit LNS of the high refractive transmitting film HLT, and thus may improve the viewing angle control characteristics. For example, as illustrated in FIG. 8A, some of the light LGT emitted from the light emitting layer 172 may be emitted at an angle inclined with respect to the third direction DR3. The light LGT may be emitted at an angle parallel to the third direction DR3 (or in a direction close to the third direction DR3) by a concave lens effect at the interface between the lens unit LNS and the second light transmitting lower film OPVX2. Accordingly, the viewing angle control characteristics of the display device 10 may be increased.

FIG. 9 is a cross-sectional view showing a display area, a non-display area, and a protrusion area of a display panel according to an embodiment.

Referring to FIG. 9 in addition to FIGS. 6A, 6B, 7, and 8A, the light control layer LCL may extend to the non-display area NDA or the protrusion area PA as well as the display area DA. For example, the first medium layer OLD1, the second medium layer OLD2, the third medium layer OLD3, the first light transmitting lower film OPVX1, the second light transmitting lower film OPVX2, the low refractive transmitting film LLT, and the high refractive transmitting film HLT may be arranged to extend to the non-display area NDA or the protrusion area PA as well as the display area DA.

One end of the first medium layer OLD1 may extend further from the display area DA toward the non-display area NDA or the protrusion area PA than one end of the first light transmitting lower film OPVX1. For example, one end of the first light transmitting lower film OPVX1 may be positioned closer to the display area DA than one end of the first medium layer OLD1. One end of the first light transmitting lower film OPVX1 may be positioned closer to an encapsulation dam EDAM to be described later than one end of the first medium layer OLD1.

One end of the second medium layer OLD2 and one end of the third medium layer OLD3 may extend further from the display area DA toward the non-display area NDA or the protrusion area PA than one end of the second light transmitting lower film OPVX2. For example, one end of the second light transmitting lower film OPVX2 may be positioned closer to the display area DA than one end of the second medium layer OLD2 and one end of the third medium layer OLD3. One end of the second light transmitting lower film OPVX2 may be positioned closer to the encapsulation dam EDAM to be described later than one end of the second medium layer OLD2 and one end of the third medium layer OLD3.

Although it is illustrated in the drawing that the plurality of first light blocking patterns of the first light blocking layer LS_L1 and the plurality of second light blocking patterns of the second light blocking layer LS_L2 are arranged only in the display area DA, the present disclosure is not necessarily limited thereto. For example, the plurality of first light blocking patterns of the first light blocking layer LS_L1 and the plurality of second light blocking patterns of the second light blocking layer LS_L2 may be arranged in the non-display area NDA and/or the protrusion area PA as well as the display area DA.

The display panel 100 may further include the encapsulation dam EDAM and light transmitting film dams ODAM1 and ODAM2.

The encapsulation dam EDAM may be positioned closer to the inner side of the display panel 100 than the light transmitting film dams ODAM1 and ODAM2. For example, the encapsulation dam EDAM may be disposed closer to the display area DA than the light transmitting film dams ODAM1 and ODAM2.

Although it is illustrated in the drawing that the encapsulation dam EDAM is disposed in the display area DA and the non-display area NDA, and the light transmitting film dams ODAM1 and ODAM2 are arranged in the non-display area NDA or the protrusion area PA, the present disclosure is not necessarily limited thereto. In an embodiment, the encapsulation dam EDAM and the light transmitting film dams ODAM1 and ODAM2 may all be arranged in the non-display area NDA or the protrusion area PA, or may all be arranged in the display area DA.

The encapsulation dam EDAM may be disposed on the base substrate BS. The encapsulation dam EDAM may prevent the second encapsulation film TFE2 of the thin film encapsulation layer TFEL from overflowing to the non-display area NDA or the outside. Although it is illustrated in the drawing that the display panel 100 includes one encapsulation dam EDAM, the present disclosure is not necessarily limited thereto. The display panel 100 may include two or more encapsulation dams EDAM.

The encapsulation dam EDAM may have a structure in which at least one layer is laminated. In some embodiments, the at least one layer of the encapsulation dam EDAM may include the same material as at least one of the first organic film 160, the second organic film 180, or the bank 190, and may be disposed in the same layer.

The light transmitting film dams ODAM1 and ODAM2 may be disposed on the first medium layer OLD1. The light transmitting film dams ODAM1 and ODAM2 may be positioned closer to the outer side of the display panel 100 than the encapsulation dam EDAM. For example, the light transmitting film dams ODAM1 and ODAM2 may be disposed closer to the non-display area NDA or the protrusion area PA than the encapsulation dam EDAM.

In some embodiments, the light transmitting film dams ODAM1 and ODAM2 may include the first light transmitting film dam ODAM1 and the second light transmitting film dam ODAM2. The second light transmitting film dam ODAM2 may include a first sub-dam SDAM1 and a second sub-dam SDAM2.

Although it is illustrated in the drawing that the display panel 100 includes two light transmitting film dams ODAM1 and ODAM2, the present disclosure is not necessarily limited thereto. The display panel 100 may include one or three or more light transmitting film dams ODAM1 and ODAM2.

The first light transmitting film dam ODAM1 may be positioned closer to the outer side than one end of the first light transmitting lower film OPVX1. For example, the first light transmitting film dam ODAM1 may be disposed closer to the non-display area NDA or the protrusion area PA than one end of the first light transmitting lower film OPVX1. One end of the first light transmitting lower film OPVX1 may be spaced apart from the first light transmitting film dam ODAM1.

The second light transmitting film dam ODAM2 may be positioned closer to the outer side than one end of the second light transmitting lower film OPVX2. For example, the second light transmitting film dam ODAM2 may be disposed closer to the non-display area NDA or the protrusion area PA than one end of the second light transmitting lower film OPVX2. One end of the second light transmitting lower film OPVX2 may be spaced apart from the second light transmitting film dam ODAM2.

The light transmitting film dams ODAM1 and ODAM2 may prevent the light transmitting film LT from overflowing to the non-display area NDA or the outside. For example, the first light transmitting film dam ODAM1 may prevent the low refractive transmitting film LLT from overflowing to the non-display area NDA or the outside, and the second light transmitting film dam ODAM2 may prevent the high refractive transmitting film HLT from overflowing to the non-display area NDA or the outside.

The first light transmitting film dam ODAM1 and the first sub-dam SDAM1 of the second light transmitting film dam ODAM2 may include the same material as the first light transmitting lower film OPVX1, and may be disposed in the same layer. The second sub-dam SDAM2 of the second light transmitting film dam ODAM2 and the second light transmitting lower film OPVX2 may include the same material, and may be disposed in the same layer.

For example, the light transmitting film dams ODAM1 and ODAM2 may include propylene glycol methyl ether acetate, a methacrylic acid-benzyl methacrylic acid copolymer, a multi-functional acrylate, and a photoinitiator.

The light transmitting film dams ODAM1 and ODAM2 may be formed together by the same process when the first light transmitting lower film OPVX1 and the second light transmitting lower film OPVX2 are formed. For example, the light transmitting film dams ODAM1 and ODAM2 may be formed together with the first light transmitting lower film OPVX1 and the second light transmitting lower film OPVX2 by a deposition process or a photolithography process.

The display device 10 according to the present embodiment may include stoppers STP1 and STP2. The stoppers STP1 and STP2 may include the first stopper STP1 and the second stopper STP2. The stoppers STP1 and STP2 may be disposed under the light transmitting film LT. For example, the first stopper STP1 may be disposed under the low refractive transmitting film LLT, and the second stopper STP2 may be disposed under the high refractive transmitting film HLT.

The stoppers STP1 and STP2 may be a structure that prevents the overflow of the light transmitting film LT. For example, the end of the light transmitting film LT might not cross the ends of the stoppers STP1 and STP2. For example, the end of the light transmitting film LT may coincide with the ends of the stoppers STP1 and STP2 or may be positioned closer to the inner side than the ends of the stoppers STP1 and STP2.

The stoppers STP1 and SPT2 may be a part of the first light transmitting lower film OPVX1 and a part of the second light transmitting lower film OPVX2, respectively. The stoppers STP1 and SPT2 refer to one ends of the first light transmitting lower film OPVX1 and the second light transmitting lower film OPVX2, respectively, and the end of the light transmitting film LT disposed on the stoppers STP1 and STP2 might not cross the stoppers STP1 and STP2 due to the surface tension of the light transmitting film LT itself and the change in the film quality caused by the disconnection of the first light transmitting lower film OPVX1 and the second light transmitting lower film OPVX2 at the stoppers STP1 and STP2.

The first stopper STP1 may be a part of the first light transmitting lower film OPVX1. The first stopper STP1 may be one end of the first light transmitting lower film OPVX1 that is adjacent to the first light transmitting film dam ODAM1. One end of the low refractive transmitting film LLT may be disposed on the first stopper STP1, and the first stopper SPT1 may prevent overflow of the low refractive transmitting film LLT.

The one end of the low refractive transmitting film LLT might not cross one end of the first stopper STP1. The one end of the low refractive transmitting film LLT may coincide with one end of the first stopper STP1 or may be positioned closer to the inner side than one end of the first stopper STP1.

The second stopper STP2 may be a part of the second light transmitting lower film OPVX2. The second stopper STP2 may be one end of the second light transmitting lower film OPVX2 that is adjacent to the second light transmitting film dam ODAM2. One end of the high refractive transmitting film HLT may be disposed on the second stopper STP2, and the second stopper SPT2 may prevent overflow of the high refractive transmitting film HLT.

One end of the high refractive transmitting film HLT might not cross one end of the second stopper STP2. One end of the high refractive transmitting film HLT may coincide with one end of the second stopper STP2 or may be positioned closer to the inner side than one end of the second stopper STP2.

The display device 10 according to the present embodiment includes the first stopper STP1 and the second stopper STP2 disposed under one end of the low refractive transmitting film LLT and one end of the high refractive transmitting film HLT, respectively, so that the low refractive transmitting film LLT and the high refractive transmitting film HLT may be prevented from overflowing when the low refractive transmitting film LLT and the high refractive transmitting film HLT are formed by an inkjet process.

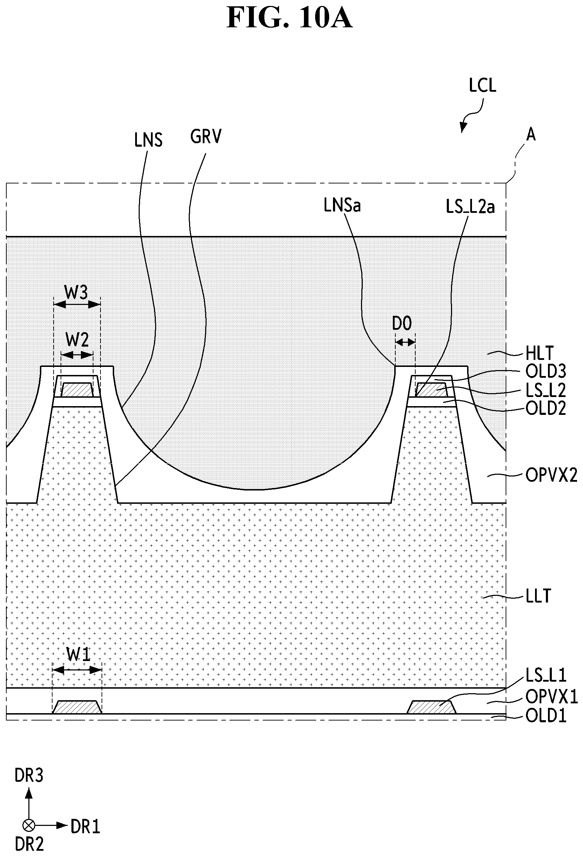

FIG. 10A is an enlarged view of area A of FIG. 8A.

Referring to FIG. 10A in addition to FIG. 8A, in the display device 10 according to an embodiment, a width W1 of the first light blocking pattern of the first blocking layer LS_L1 may be different from a width W2 of the second light blocking pattern of the second light blocking layer LS_L2. For example, the width W1 of the first light blocking pattern may be greater than the width W2 of the second light blocking pattern.

Further, in the display device 10, according to an embodiment, a width W3 of the third medium layer OLD3 may be greater than the width W2 of the second light blocking pattern. The third medium layer OLD3 may cover the side surface and the top surface of the second light blocking pattern.

In the display device 10, according to an embodiment, one end LNSa (e.g., a point where the bottom surface of the upper layer portion and the lens unit LNS meet) of the lens unit LNS and one end LS_L2a of the second light blocking pattern of the second light blocking layer LS_L2, which are adjacent to each other, may be spaced apart from each other by a first distance D0 in the first direction DR1.

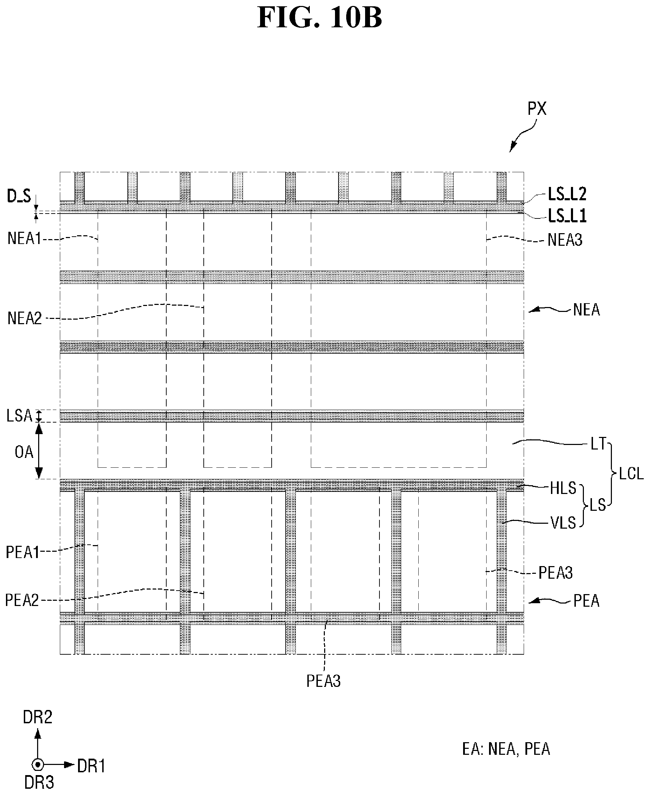

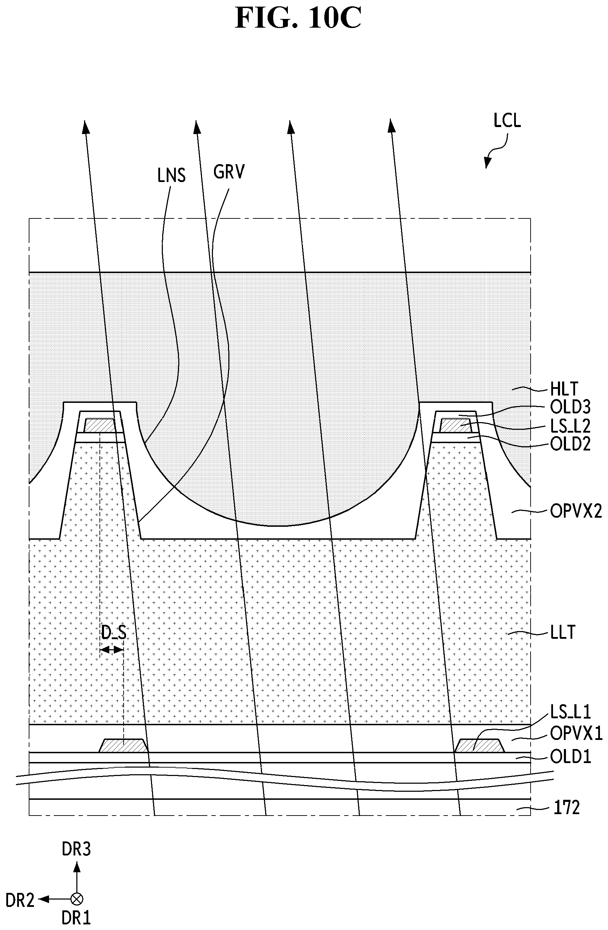

FIG. 10B is a plan view illustrating a portion of a display area according to an embodiment. FIG. 10C is a cross-sectional view illustrating a portion of a display panel according to an embodiment.

Referring to FIGS. 10B and 10C, the display device 10 according to the present embodiment is different from the display device 10 according to the embodiment described with reference to FIG. 6A and the like in that the second light blocking layer LS_L2 and the lens unit LNS are misaligned with the first light blocking layer LS_L1.

For example, the second light blocking layer LS_L2 may be more shifted in the second direction DR2 than in the first light blocking layer LS_L1. For example, as illustrated in FIG. 10B, a part of the upper portion of the horizontal light blocking film HLS of the second light blocking layer LS_L2 might not overlap the horizontal light blocking film HLS of the first light blocking layer LS_L1 in the third direction DR3, and a part of the lower portion of the horizontal light blocking film HLS of the first light blocking layer LS_L1 might not overlap the horizontal light blocking film HLS of the second light blocking layer LS_L2 in the third direction DR3.

As illustrated in the drawing, the horizontal light blocking film HLS of the first light blocking layer LS_L1 and the horizontal light blocking film HLS of the second light blocking layer LS_L2 may overlap each other in some areas in the third direction DR3, but the present disclosure is not necessarily limited thereto. When the degree of shift of the second light blocking layer LS_L2 in the second direction DR2 is greater than the width of the first light blocking layer LS_L1 in the second direction DR2, the horizontal light blocking film HLS of the second light blocking layer LS_L2 might not overlap the horizontal light blocking film HLS of the first light blocking layer LS_L1.

When the second light blocking layer LS_L2 is shifted in the second direction DR2, the vertical light blocking film VLS of the second light blocking layer LS_L2 and the vertical light blocking film VLS of the first light blocking layer LS_L1 may still overlap.

Although FIG. 10B illustrates as an example that the second light blocking layer LS_L2 is more shifted in the second direction DR2 than the first light blocking layer LS_L1, the present disclosure is not necessarily limited thereto. For example, the second light blocking layer LS_L2 may be more shifted in the first direction DR1 than the first light blocking layer LS_L1. Hereinafter, for simplicity of description, a case where the second light blocking layer LS_L2 is more shifted in the second direction DR2 than the first light blocking layer LS_L1 will be described as an example.

Although FIG. 10B illustrates that the entire horizontal light blocking film HLS of the second light blocking layer LS_L2 is more shifted in one direction than the entire horizontal light blocking film HLS of the first light blocking layer LS_L1, the present disclosure is not necessarily limited thereto. In some embodiments, at least some of the plurality of horizontal light blocking films HLS of the second light blocking layer LS_L2 may be more shifted in one direction than at least some of the plurality of horizontal light blocking films HLS of the first light blocking layer LS_L1.

As illustrated in FIG. 10C, similarly to the shifted second light blocking layer LS_L2, the groove GRV of the low refractive transmitting film LLT and the lens unit LNS of the high refractive transmitting film HLT may also be more shifted in the second direction DR2 than the first light blocking layer LS_L1.

For example, the central portion of the first light blocking pattern of the first light blocking layer LS_L1 and the central portion of the second light blocking pattern of the second light blocking layer LS_L2 may be misaligned by a first shift distance D_S in the second direction DR2. Accordingly, the groove GRV and the lens unit LNS disposed between the second light blocking patterns of the second light blocking layer LS_L2 may also be misaligned by the first shift distance D_S from the midpoint of the first light blocking patterns in the second direction DR2.

In some embodiments, at least some of the plurality of second light blocking patterns of the second light blocking layer LS_L2 may be more shifted in one direction (e.g., in the second direction DR2) than at least some of the plurality of first light blocking patterns of the first light blocking layer LS_L1. Similarly, at least some of the plurality of grooves GRV and at least some of the plurality of lens units LNS positioned between the plurality of second light blocking patterns of the second light blocking layer LS_L2 may be more shifted in one direction (e.g., in the second direction DR2) than at least some of the plurality of first light blocking patterns of the first light blocking layer LS_L1.

In some embodiments, at least some of the plurality of second light blocking patterns of the second light blocking layer LS_L2 may be more shifted in the second direction DR2 than at least some of the plurality of first light blocking patterns of the first light blocking layer LS_L1, and at least some others of the plurality of second light blocking patterns of the second light blocking layer LS_L2 may be more shifted in a direction different from the second direction DR2 (e.g., in a direction opposite to the second direction DR2) than at least some others of the plurality of first light blocking patterns of the first light blocking layer LS_L1. For example, some of the second light blocking patterns may be shifted in one direction with respect to the first light blocking patterns, and some others of the second light blocking patterns may be shifted in a direction different from one direction with respect to the first light blocking patterns.

In the display device 10, according to the present embodiment, the lens unit LNS and the second light blocking pattern of the second light blocking layer LS_L2 are shifted to one side from the first light blocking pattern of the first light blocking layer LS_L1, so that the light exit direction of the light emitted from the light emitting layer 172 may be changed to a diagonal direction (e.g., diagonal direction defined by the second direction DR2 and the third direction DR3) other than a front direction (e.g., the third direction DR3).

Accordingly, when the display device 10 is applied to a vehicle display of an automobile, even if the display device 10 is installed at a position lower than a user's visual field, the user may visually recognize the image of the display device 10 more clearly.

In some embodiments, at least some of the plurality of second light blocking patterns of the second light blocking layer LS_L2 may be more shifted by the first shift distance D_S in the second direction DR2 than at least some of the plurality of first light blocking patterns of the first light blocking layer LS_L1, and at least some others of the plurality of second light blocking patterns of the second light blocking layer LS_L2 may be more shifted by a second shift distance in the second direction DR2 than at least some others of the plurality of first light blocking patterns of the first light blocking layer LS_L1. A second shift distance may be different from the first shift distance D_S. For example, the light exit direction (or angle) of the light emitted from the light emitting layer 172 may be different between a part of the display area DA (see FIG. 1) and another part thereof.

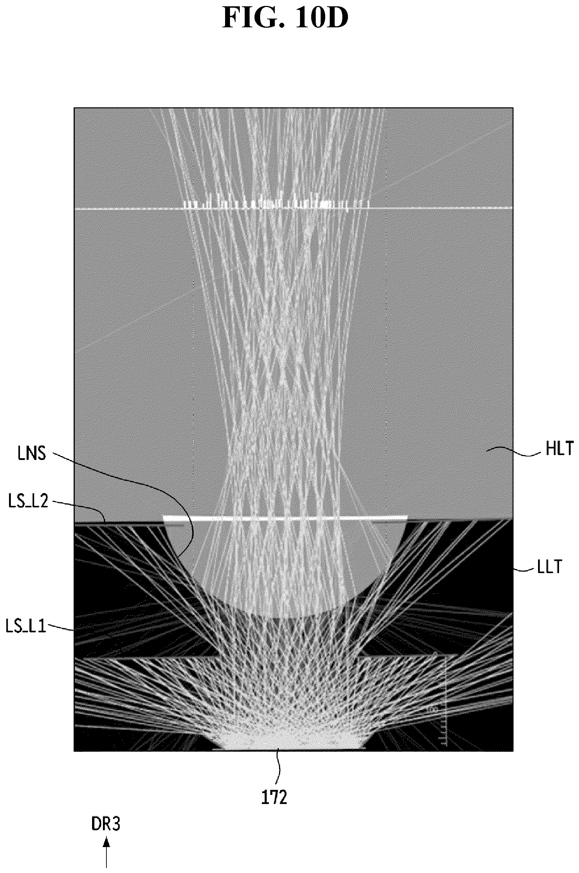

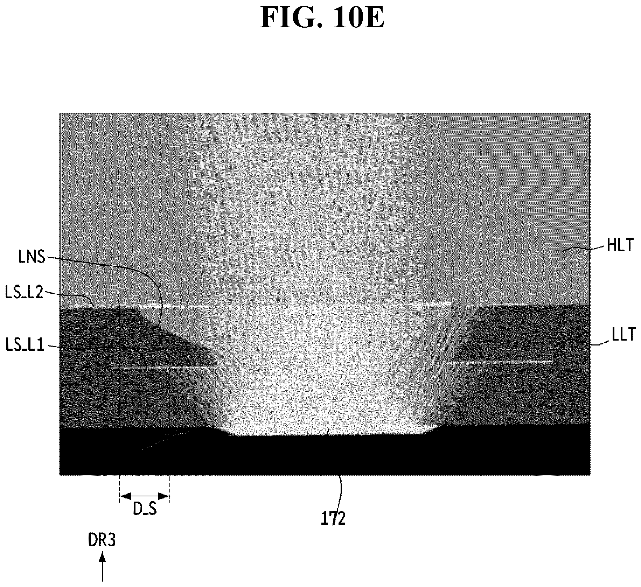

FIG. 10D is a simulated image showing a movement path of light in the display panel according to the embodiment of FIG. 10A. FIG. 10E is a simulated image showing a movement path of light in the display panel according to the embodiment of FIGS. 10B and 10C.

Referring to FIGS. 10D and 10E in addition to FIGS. 10A to 10C, the display device 10, according to the present embodiment, may effectively control the viewing angle while minimizing a decrease in luminance due to the arrangement of the light control layer LCL.

For example, as shown in FIG. 10D, according to the movement path of light in the display panel 100 according to the embodiment of FIG. 10A, the viewing angle of the light emitted from the lens unit LNS may be substantially within 30 degrees with respect to the front direction (e.g., the third direction DR3) due to a light collecting effect. Among the light incident on the lens unit LNS from the light emitting layer 172, some of the lights having an incident angle greater than 30 degrees with respect to the third direction DR3 may be collected on the surface of the lens unit LNS and emitted with a viewing angle of less than 30 degrees. Accordingly, the display device 10, according to the present embodiment, may have a light emission efficiency and a luminance higher than those of the display panel 100 according to a comparative embodiment that does not include the lens unit LNS.

As illustrated in FIG. 10E, in the display panel 100, according to the embodiment of FIGS. 10B and 10C, the lens unit LNS and the second light blocking pattern of the second light blocking layer LS_L2 are shifted by the first shift distance D_S from the first light blocking pattern of the first light blocking layer LS_L1, so that the lights that have passed through the lens unit LNS are emitted while being inclined in the shifted direction.

Accordingly, as described above, when the display device 10 is applied to a vehicle display of an automobile, even if the display device 10 is installed at a position lower than a user's visual field, the user may visually recognize the image of the display device 10 more clearly.

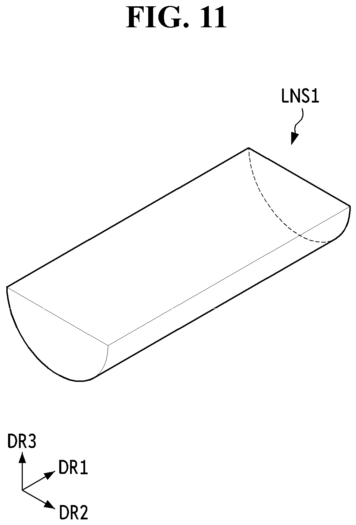

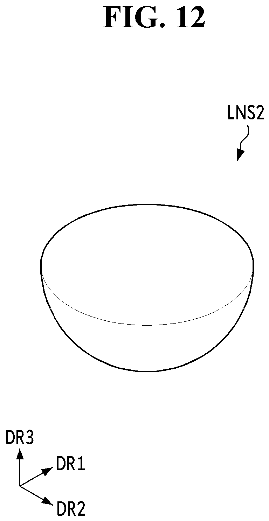

FIG. 11 is a perspective view showing a first lens unit according to an embodiment. FIG. 12 is a perspective view showing a second lens unit according to an embodiment.

Referring to FIGS. 11 and 12 in addition to FIGS. 6A and 6B, the lens unit LNS may include a first lens LNS1 or a second lens LNS2. The first lens LNS1 may have a semi-cylindrical shape, and the second lens LNS2 may have a hemispherical shape.

For example, in the case of the embodiment shown in FIG. 6A, the transmission area OA has a shape extending in the first direction DR1 in the normal mode area NEA, so that the lens unit LNS may have a semi-cylindrical shape similarly to the first lens LNS1. Further, the transmission area OA has a shape extending in the second direction DR2 in the privacy mode area PEA, so that the lens unit LNS may have a semi-cylindrical shape similarly to the first lens LNS1, and may have a semi-cylindrical shape whose length in the second direction DR2 is greater than that in the first direction DR1.

For example, in the case of the embodiment shown in FIG. 6B, the transmission area OA has a shape extending in the first direction DR1 in the normal mode area NEA, so that the lens unit LNS may have a semi-cylindrical shape similarly to the first lens LNS1. The transmission area OA has a circular shape in a plan view in the privacy mode area PEA, so that the lens unit LNS may have a hemispherical shape similarly to the second lens LNS2.

Hereinafter, other embodiments of the display device according to an embodiment will be described. In the following embodiments, description of the same components as those of the above-described embodiment, which are denoted by like reference numerals, and to the extent that an element is not described in detail with respect to this figure, it may be understood that the element is at least similar to a corresponding element that has been described elsewhere within the present disclosure.

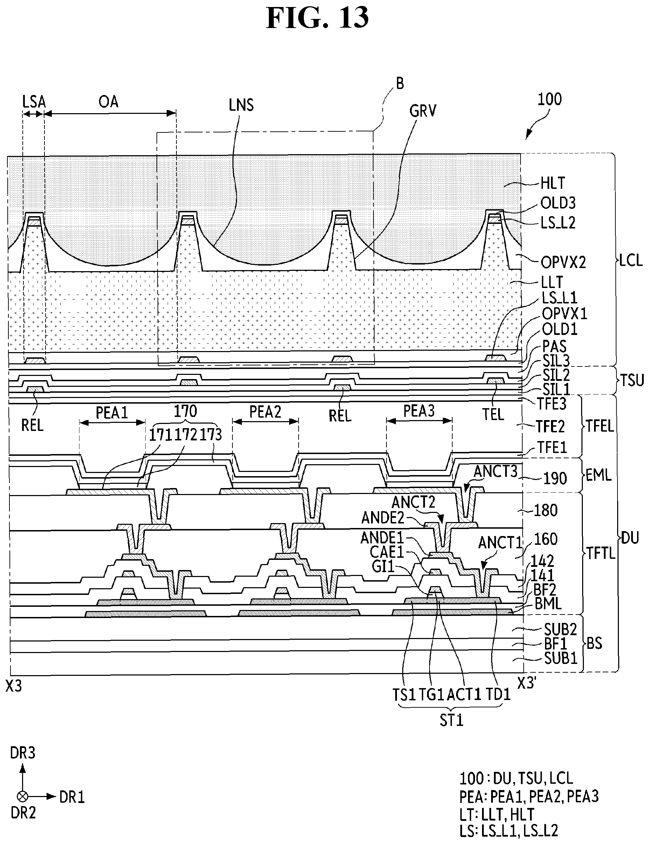

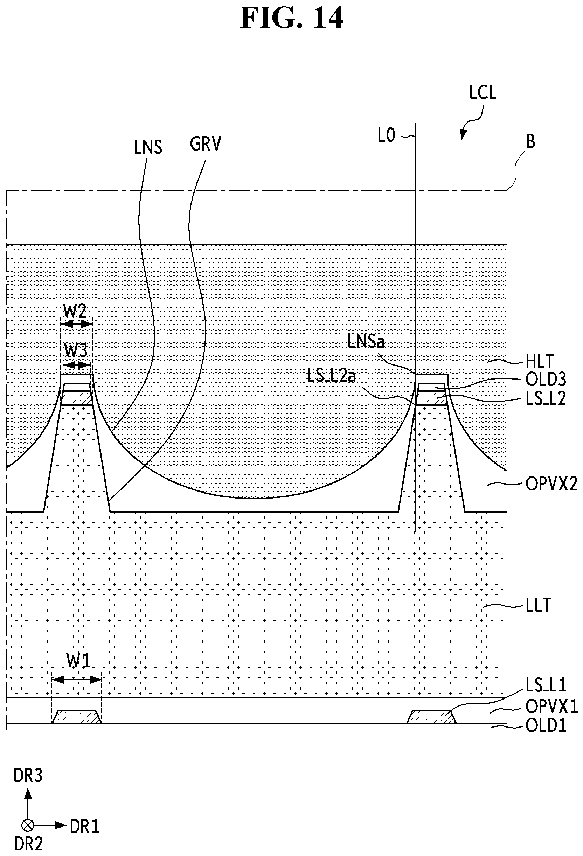

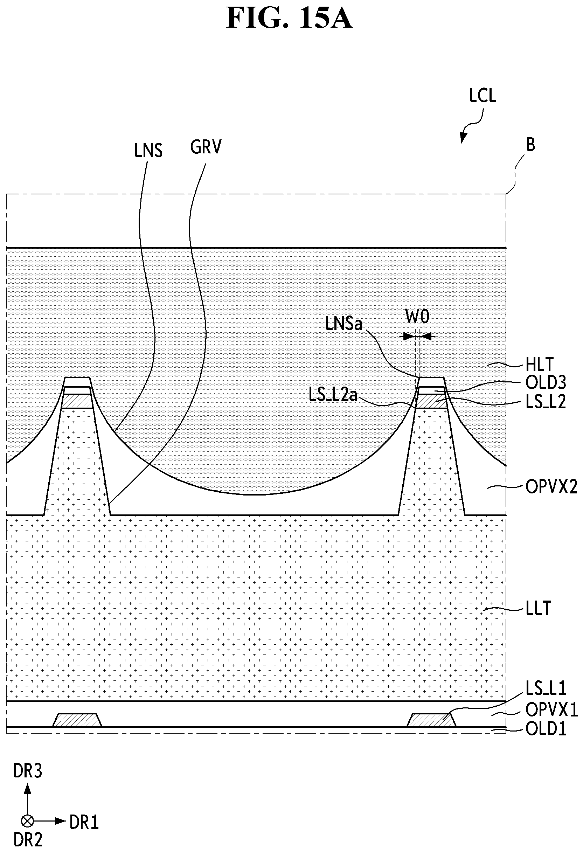

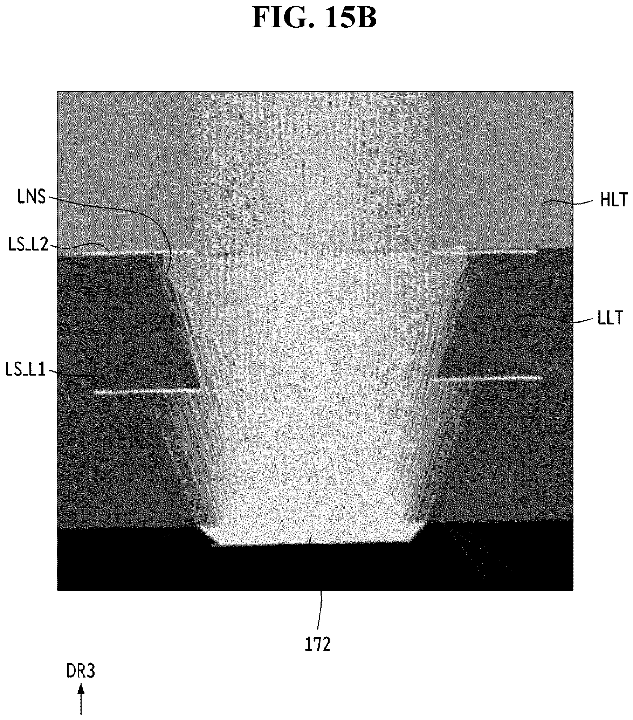

FIG. 13 is a cross-sectional view showing a display panel according to an embodiment. FIGS. 14 and 15A are enlarged views of area B of FIG. 13. FIG. 15B is a simulated image showing a movement path of light in the display panel according to the embodiment of FIGS. 14 and 15A.

Referring to FIGS. 13, 14, 15A, and 15B, the display device, 10 according to the present embodiment, is different from the display device 10 according to the embodiment described with reference to FIG. 8A and the like in that it does not include the second medium layer OLD2.

For example, the light control layer LCL may include the first medium layer OLD1, the first light blocking layer LS_L1, the first light transmitting lower film OPVX1, the low refractive transmitting film LLT, the second light blocking layer LS_L2, the third medium layer OLD3, the second light transmitting lower film OPVX2, and the high refractive transmitting film HLT.

The second light blocking layer LS_L2 may be disposed on the low refractive transmitting film LLT. The second light blocking layer LS_L2 may be directly disposed on the top surface disposed at the uppermost end of the low refractive transmitting film LLT. The second light blocking layer LS_L2 may be directly disposed on the partition walls of the low refractive transmitting film LLT. For example, the second light blocking layer LS_L2 may be in direct contact with the top surface disposed at the uppermost end of the low refractive transmitting film LLT and the partition walls of the low refractive transmitting film LLT.

The third medium layer OLD3 may be disposed on the second light blocking layer LS_L2. The third medium layer OLD3 may be disposed on the top surface of the second light blocking layer LS_L2. The third medium layer OLD3 may be in direct contact with the top surface of the second light blocking layer LS_L2. Unlike the display device 10 according to the embodiment described with reference to FIG. 8A and the like, in the display device 10, according to the present embodiment, the third medium layer OLD3 might not cover the side surface of the second light blocking layer LS_L2, and might not be in direct contact therewith.

The second light transmitting lower film OPVX2 may be disposed on the low refractive transmitting film LLT and the third medium layer OLD3. The second light transmitting lower film OPVX2 may be conformally disposed along the groove GRV of the low refractive transmitting film LLT, the side surface of the second light blocking layer LS_L2, and the third medium layer OLD3. For example, the shape of the bottom surface of the second light transmitting lower film OPVX2 may correspond to the shapes of the groove GRV of the low refractive transmitting film LLT, the side surface of the second light blocking layer LS_L2, and the side surface and top surface of the third medium layer OLD3.

Unlike the display device 10 according to the embodiment described with reference to FIG. 8A and the like, in the display device 10, according to the present embodiment, the second light transmitting lower film OPVX2 may be in direct contact with the side surface of the second light blocking layer LS_L2.

As illustrated in FIGS. 14 and 15A, in the display device 10, according to the present embodiment, the width W3 of the third medium layer OLD3 may be less than the width W2 of the second light blocking pattern. The third medium layer OLD3 may be disposed only on the top surface of the second light blocking layer LS_L2, and might not cover the side surface of the second light blocking layer LS_L2.

Accordingly, the first distance D0 in the display device 10, according to the embodiment described with reference to FIG. 8A, may be reduced or eliminated. For example, as illustrated in FIG. 14, one end LNSa of the lens unit LNS and one end LS_L2a of the second light blocking pattern of the second light blocking layer LS_L2, which are adjacent to each other, may be positioned on a virtual reference line L0 extending in the third direction DR3. For example, one end LNSa of the lens unit LNS and one end LS_L2a of the second light blocking pattern of the second light blocking layer LS_L2, which are adjacent to each other, may be positioned on the same line in the third direction DR3.

For example, as illustrated in FIG. 15A, one end LNSa of the lens unit LNS may overlap the second light blocking pattern in the third direction DR3, and one end LS_L2a of the second light blocking pattern may overlap the lens unit LNS in the third direction DR3. For example, the lens unit LNS and the second light blocking pattern may overlap by a first overlapping distance WO.

The display device 10, according to the present embodiment, may be manufactured by the method S1_1 for manufacturing a display device according to an embodiment to be described later (see FIG. 37). According to the display device 10, according to the present embodiment, the distance between one end LNSa of the lens unit LNS and one end LS_L2a of the second light blocking pattern of the second light blocking layer LS_L2, which are adjacent to each other, may be reduced, or the lens unit LNS and the second light blocking pattern of the second light blocking layer LS_L2 may overlap. Accordingly, light that does not pass through the lens unit LNS is blocked by the second light blocking layer LS_L2, and light that is not blocked by the second light blocking layer LS_L2 is allowed to pass through the lens unit LNS, thereby further increasing the viewing angle control characteristics of the display device 10.

For example, as shown in FIG. 15B, according to the movement path of light in the display panel 100 according to the embodiment of FIGS. 14 and 15A, the viewing angle of lights emitted from the lens unit LNS may be substantially within 15 degrees with respect to the front direction (e.g., the third direction DR3). Since the end of the lens unit LNS coincides with the end of the second light blocking pattern of the second light blocking layer LS_L2 in the third direction DR3 or the lens unit LNS overlaps the second light blocking pattern of the second light blocking layer LS_L2 in the third direction DR3, the light exit viewing angle control characteristics with respect to the front direction may be further increased.

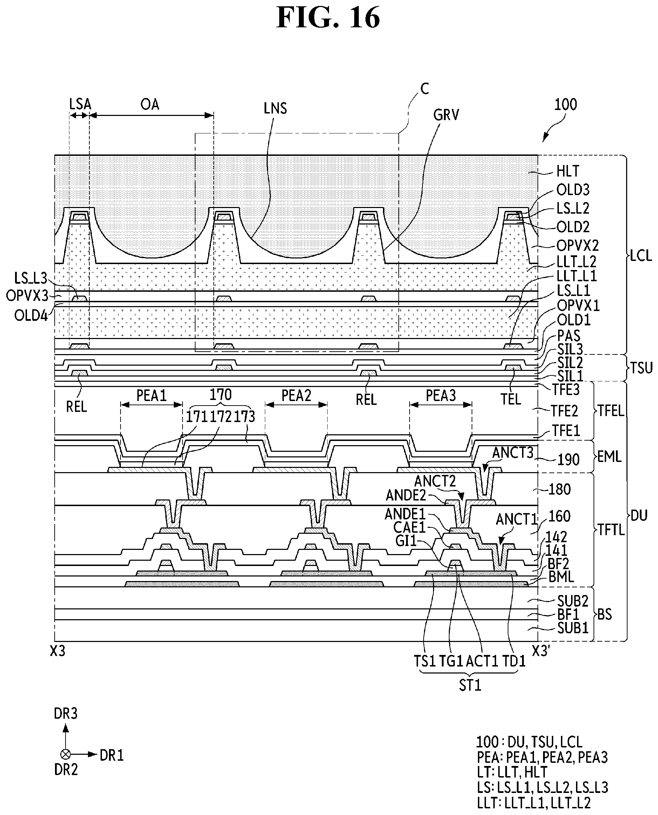

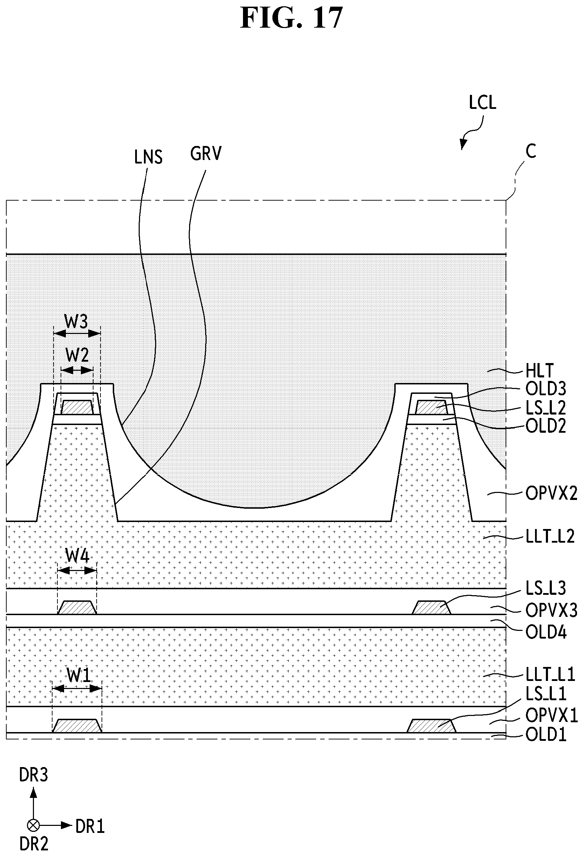

FIG. 16 is a cross-sectional view showing a display panel according to an embodiment. FIG. 17 is an enlarged view of area C of FIG. 16.

Referring to FIGS. 16 and 17, the display device 10, according to the present embodiment, is different from the display device 10 according to the embodiment described with reference to FIG. 8A and the like in that it further includes a third light blocking layer LS_L3.

For example, the light control layer LCL of the display device 10 according to the present embodiment may include the first medium layer OLD1, the first light blocking layer LS_L1, the first light transmitting lower film OPVX1, a first low refractive transmitting layer LLT_L1, a fourth medium layer OLD4, the third light blocking layer LS_L3, a third light transmitting lower film OPVX3, a second low refractive transmitting layer LLT_L2, the second medium layer OLD2, the second light blocking layer LS_L2, the third medium layer OLD3, the second light transmitting lower film OPVX2, and the high refractive transmitting film HLT. The first light blocking layer LS_L1 and the second light blocking layer LS_L2 may be included in the light blocking film LS. The first low refractive transmitting layer LLT_L1 and the second low refractive transmitting layer LLT_L2 may be included in the low refractive transmitting film LLT. The low refractive transmitting film LLT and the high refractive transmitting film HLT may be included in the light transmitting film LT.

The first light transmitting lower film OPVX1 may be a lower film for preventing overflow of the light transmitting film LT at the outer portion of the display panel 100. For example, the first light transmitting lower film OPVX1 may prevent overflow of the first low refractive transmitting layer LLT_L1 at the outer portion of the display panel 100.

The first low refractive transmitting layer LLT_L1 may be disposed on the first light transmitting lower film OPVX1. The first low refractive transmitting layer LLT_L1 may transmit the light emitted from the light emitting layer 172. The first low refractive transmitting layer LLT_L1 may include a transparent organic material. In an embodiment, the thickness of the first low refractive transmitting layer LLT_L1 may be within a range of approximately 7 µm to 15 µm, but is not necessarily limited thereto. Here, the thickness of the first low refractive transmitting layer LLT_L1 refers to a distance in the third direction DR3 from the top surface to the bottom surface of the first low refractive transmitting layer LLT_L1.

The fourth medium layer OLD4 may be disposed on the first low refractive transmitting layer LLT_L1. The fourth medium layer OLD4 may include a transparent inorganic material. For example, the fourth medium layer OLD4 may include at least one of silicon oxide (SiOₓ), silicon nitride (SiNₓ), or silicon oxynitride (SiOₓN_{y}). In an embodiment, the fourth medium layer OLD4 may include silicon oxide (SiOₓ) or silicon oxynitride (SiOₓN_{y}), and the thickness of the fourth medium layer OLD4 may be within a range of approximately 500 Å to 1000 Å, inclusive, but is not necessarily limited thereto. Here, the thickness of the fourth medium layer OLD4 refers to a distance in the third direction DR3 between the top surface and the bottom surface of the fourth medium layer OLD4.

The fourth medium layer OLD4 may be disposed between the third light transmitting lower film OPVX3 and the organic film (e.g., the first low refractive transmitting layer LLT_L1) to increase interfacial properties so that the third light transmitting lower film OPVX3 may be easily deposited on the organic film during the deposition process of the third light transmitting lower film OPVX3.

The third light blocking layer LS_L3 may be disposed on the fourth medium layer OLD4. The third light blocking layer LS_L3 may absorb or block the light emitted from the light emitting layer 172. The third light blocking layer LS_L3 may include a light blocking organic material. In an embodiment, the thickness of the third light blocking layer LS_L3 may be within a range of approximately 1 µm to 2 µm, inclusive, but is not necessarily limited thereto. Here, the thickness of the third light blocking layer LS_L3 refers to a distance in the third direction DR3 from the top surface to the bottom surface of the third light blocking layer LS_L3.

The third light blocking layer LS_L3 may include a plurality of third light blocking patterns. The plurality of third light blocking patterns may be spaced apart from each other in the first direction DR1 or the second direction DR2. The plurality of third light blocking patterns may be arranged in the non-transmission area LSA. The plurality of third light blocking patterns may overlap the plurality of first light blocking patterns and the plurality of second light blocking patterns in the third direction DR3.

The third light transmitting lower film OPVX3 may be disposed on the fourth medium layer OLD4. The third light transmitting lower film OPVX3 may cover the top surfaces and side surfaces of the plurality of third light blocking patterns of the third light blocking layer LS_L3. The third light transmitting lower film OPVX3 may transmit light emitted from the light emitting layer 172. The third light transmitting lower film OPVX3 may include a transparent organic material. In an embodiment, the thickness of the third light transmitting lower film OPVX3 may be within a range of approximately 2.5 µm to 5 µm, inclusive, but is not necessarily limited thereto. Here, the thickness of the third light transmitting lower film OPVX3 refers to a distance in the third direction DR3 from the top surface to the bottom surface of the third light transmitting lower film OPVX3.

The third light transmitting lower film OPVX3 may be a lower film for preventing overflow of the light transmitting film LT at the outer portion of the display panel 100. For example, the third light transmitting lower film OPVX3 may prevent overflow of the second low refractive transmitting layer LLT_L2 at the outer portion of the display panel 100.

The second low refractive transmitting layer LLT_L2 may be disposed on the third light transmitting lower film OPVX3. The second low refractive transmitting layer LLT_L2 may transmit the light emitted from the light emitting layer 172. The second low refractive transmitting layer LLT_L2 may include a transparent organic material. In an embodiment, the thickness of the second low refractive transmitting layer LLT_L2 may be within a range of approximately 7 µm to 15 µm, inclusive, but is not necessarily limited thereto. Here, the thickness of the second low refractive transmitting layer LLT_L2 refers to a distance in the third direction DR3 from the top surface disposed at the uppermost end of the second low refractive transmitting layer LLT_L2 to the bottom surface disposed at the lowest end of the second low refractive transmitting layer LLT_L2. The second low refractive transmitting layer LLT_L2 may include a plurality of grooves GRV.

The second medium layer OLD2 may be disposed on the second low refractive transmitting layer LLT_L2. For example, the second medium layer OLD2 may be disposed on the top surface disposed at the uppermost end of the second low refractive transmitting layer LLT_L2. The second medium layer OLD2 may be disposed on the partition walls of the second low refractive transmitting layer LLT_L2. The second medium layer OLD2 might not overlap the plurality of grooves GRV of the second low refractive transmitting layer LLT_L2.

The second light blocking layer LS_L2 may be disposed on the second medium layer OLD2. The second light blocking layer LS_L2 may be disposed on the top surface disposed at the uppermost end of the second low refractive transmitting layer LLT_L2. The second light blocking layer LS_L2 may be disposed on the partition walls of the second low refractive transmitting layer LLT_L2.

The third medium layer OLD3 may be disposed on the second light blocking layer LS_L2. For example, the third medium layer OLD3 may be disposed on the top surface disposed at the uppermost end of the second low refractive transmitting layer LLT_L2. The third medium layer OLD3 may be disposed on the partition walls of the second low refractive transmitting layer LLT_L2. The third medium layer OLD3 might not overlap the plurality of grooves GRV of the second low refractive transmitting layer LLT_L2.

The second light transmitting lower film OPVX2 may be disposed on the second low refractive transmitting layer LLT_L2 and the third medium layer OLD3.

The second light transmitting lower film OPVX2 may be conformally disposed along the groove GRV of the second low refractive transmitting layer LLT_L2, the side surface of the second medium layer OLD2, and the third medium layer OLD3. For example, the shape of the bottom surface of the second light transmitting lower film OPVX2 may correspond to the shapes of the groove GRV of the second low refractive transmitting layer LLT_L2, the side surface of the second medium layer OLD2, and the side surface and top surface of the third medium layer OLD3.

The shape of the top surface of the second light transmitting lower film OPVX2 may be a shape that is concave, bending toward the display layer DU. For example, a portion of the top surface of the second light transmitting lower film OPVX2 that overlaps the groove GRV of the second low refractive transmitting layer LLT_L2 may have a shape that is concave, bending toward the display layer DU, and a portion of the top surface of the second light transmitting lower film OPVX2 that overlaps the partition wall of the second low refractive transmitting layer LLT_L2 may have a flat shape.

The high refractive transmitting film HLT may include a plurality of lens units LNS. The plurality of lens units LNS may be disposed in the plurality of grooves GRV of the second low refractive transmitting layer LLT_L2. The partition wall of the second low refractive transmitting layer LLT_L2, the second medium layer OLD2, the second light blocking layer LS_L2, and the third medium layer OLD3 may be arranged between the plurality of lens units LNS spaced apart from each other.

In some embodiments, as illustrated in FIG. 17, in the display device 10, according to the present embodiment, a width W4 of the third blocking pattern of the third light blocking layer LS_L3 may be less than the width W1 of the first light blocking pattern of the first blocking layer LS_L1, and may be greater than the width W2 of the second light blocking pattern of the second light blocking layer LS_L2.

Since the display device 10, according to the present embodiment, further includes the third light blocking layer LS_L3, the viewing angle control characteristics of the display device 10 may be increased.

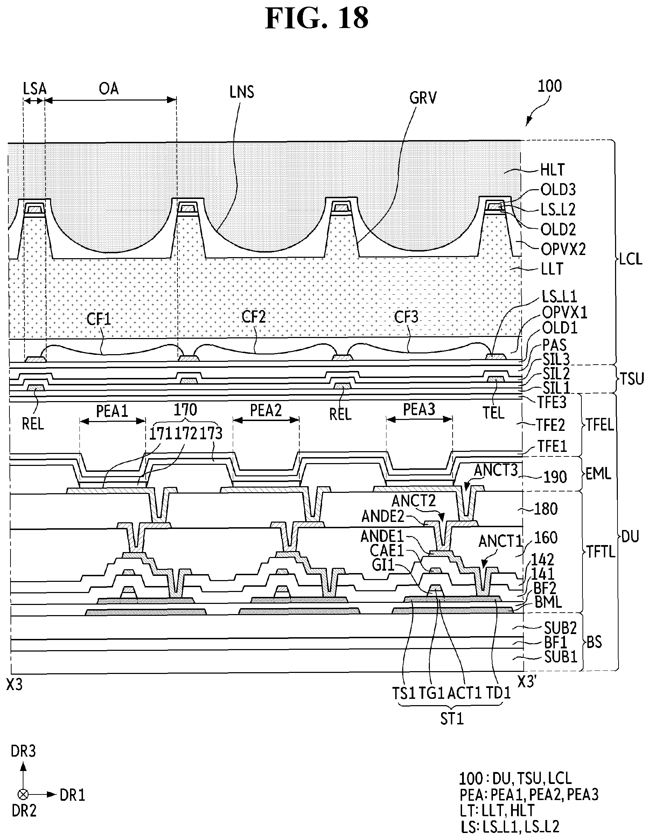

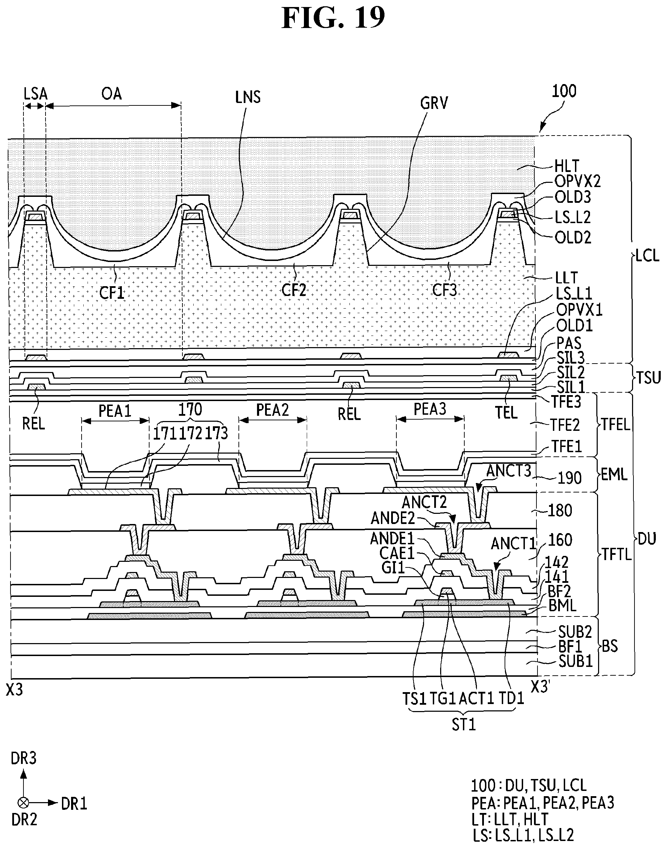

FIG. 18 is a cross-sectional view showing a display panel according to an embodiment. FIG. 19 is a cross-sectional view showing a display panel according to an embodiment.

Referring to FIGS. 18 and 19, the display device 10, according to the present embodiment, is different from the display device 10, according to the embodiment described with reference to FIG. 8A, and the like in that it further includes color filters CF1, CF2, and CF3.

For example, the display device, 10 according to the present embodiment, may further include the color filters CF1, CF2, and CF3 arranged in the light control layer LCL. The color filters CF1, CF2, and CF3 may include the first color filter CF1 overlapping the first emission area PEA1 of the privacy mode area PEA, the second color filter CF2 overlapping the second emission area PEA2 of the privacy mode area PEA, and the third color filter CF3 overlapping the third emission area PEA3 of the privacy mode area PEA.

The color filters CF1, CF2, and CF3 may contain a colorant, such as a dye or a pigment, that absorbs light in a wavelength band other than a specific wavelength band, and may be arranged to correspond to the color of the light emitted by the light emitting element 170. For example, the first color filter CF1 may be a red color filter that transmits only the red first light, the second color filter CF2 may be a green color filter that transmits only the green second light, and the third color filter CF3 may be a blue color filter that transmits only the blue third light.

Although only the color filters CF1, CF2, and CF3 that overlap the emission areas PEA1, PEA2, and PEA3 of the privacy mode area PEA are illustrated in the drawing, the color filters CF1, CF2, and CF3 overlapping the emission areas NEA1, NEA2, and NEA3 (see FIG. 6A) of the normal mode area NEA (see FIG. 6A) may be further included.

In an embodiment, as illustrated in FIG. 18, the color filters CF1, CF2, and CF3 may be arranged on the first light blocking layer LS_L1. For example, the color filters CF1, CF2, and CF3 may be arranged between the first light blocking layer LS_L1 and the first light transmitting lower film OPVX1. The color filters CF1, CF2, and CF3 may be covered by the first light transmitting lower film OPVX1.

In this case, the color filters CF1, CF2, and CF3 may be arranged between the plurality of first light blocking patterns of the first light blocking layer LS_L1. Both ends of the color filters CF1, CF2, and CF3 may at least partially overlap the plurality of first light blocking patterns. The width of the color filters CF1, CF2, and CF3 may be greater than the separation distance of the first light blocking patterns.

In an embodiment, as illustrated in FIG. 19, the color filters CF1, CF2, and CF3 may be arranged on the low refractive transmitting film LLT and the third medium layer OLD3. For example, the color filters CF1, CF2, and CF3 may be arranged between the low refractive transmitting film LLT and the third medium layer OLD3 and the second light transmitting lower film OPVX2. The color filters CF1, CF2, and CF3 may be covered by the second light transmitting lower film OPVX2. A part of each of the color filters CF1, CF2, and CF3 may be disposed in the groove GRV, and another portion thereof may be disposed on the third medium layer OLD3.

In this case, the color filters CF1, CF2, and CF3 may be arranged between the plurality of second light blocking patterns of the second light blocking layer LS_L2. Both ends of the color filters CF1, CF2, and CF3 may at least partially overlap the plurality of second light blocking patterns. The width of the color filters CF1, CF2, and CF3 may be greater than the separation distance of the second light blocking patterns.

The display device 10, according to the present embodiment, may include the color filters CF1, CF2, and CF3 disposed on the display layer DU to reduce the intensity of reflected light caused by external light. Furthermore, the color of the reflected light by the external light may be controlled by adjusting the arrangement, shape, and area of the color filters CF1, CF2, and CF3 in a plan view.

Hereinafter, a method of manufacturing a display device according to an embodiment will be described.

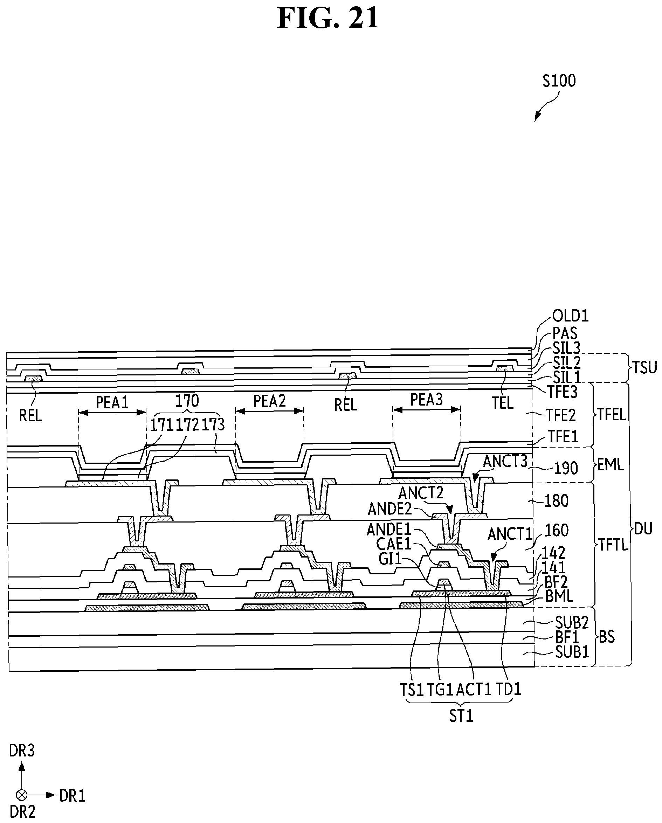

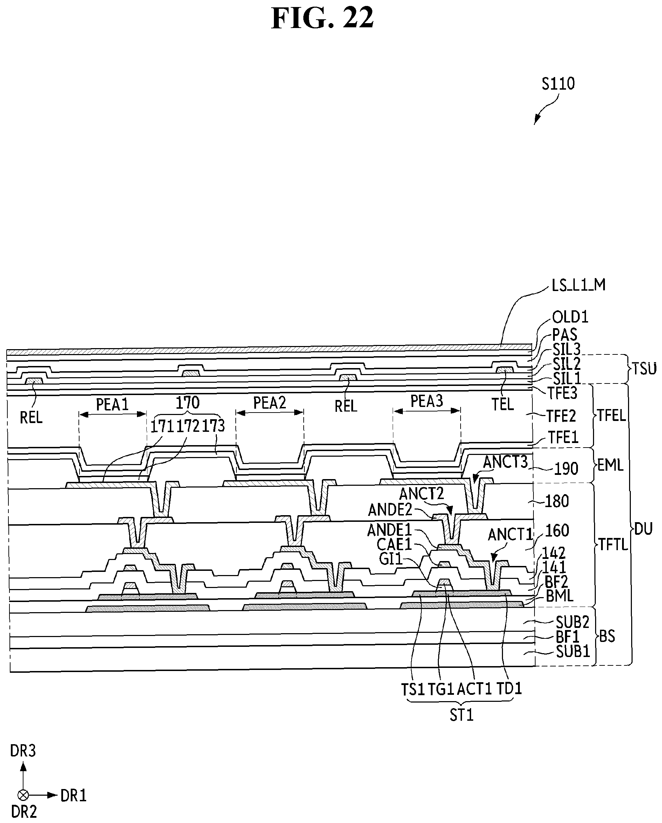

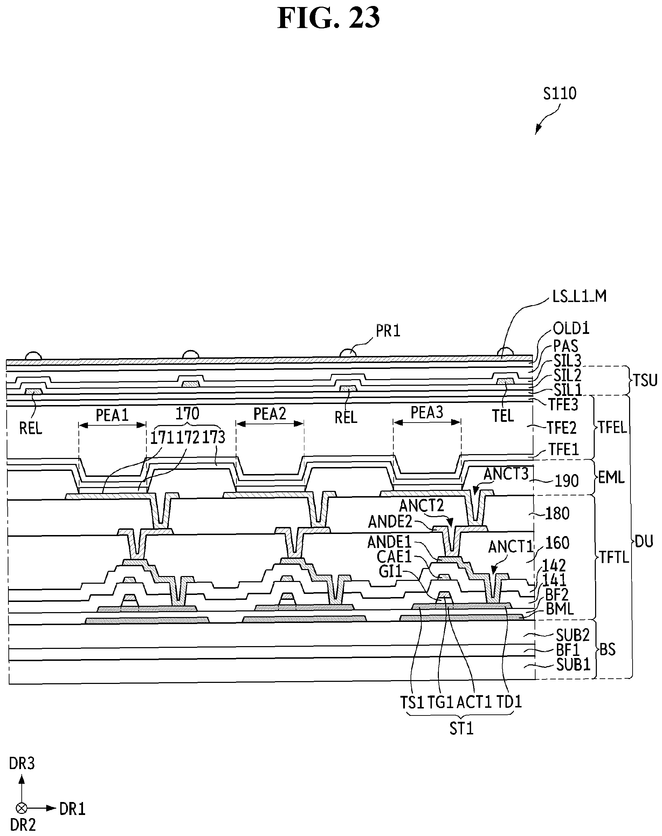

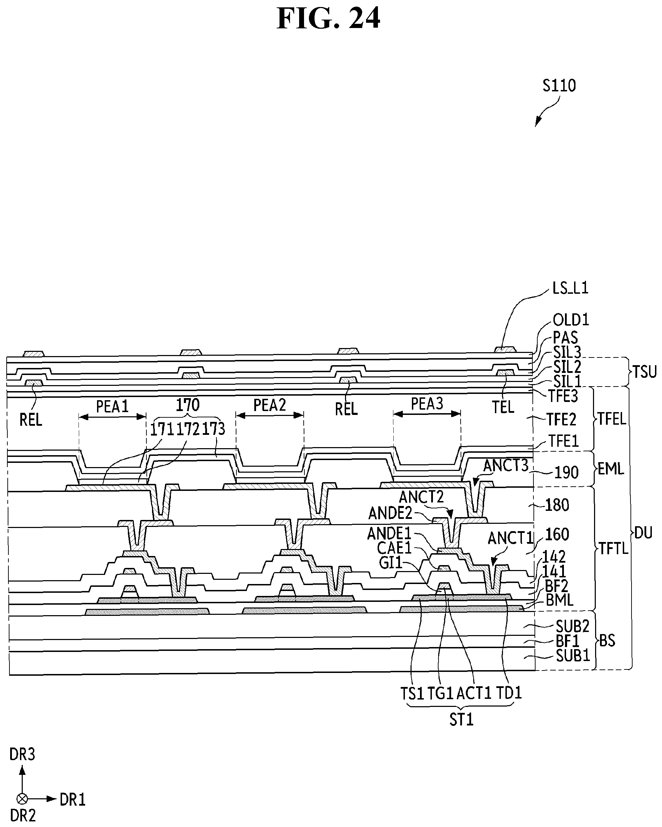

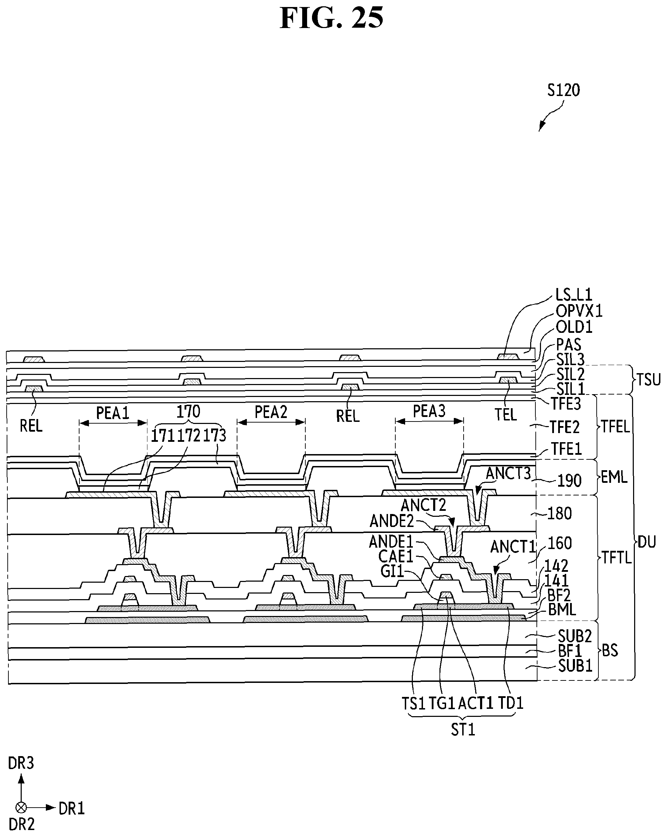

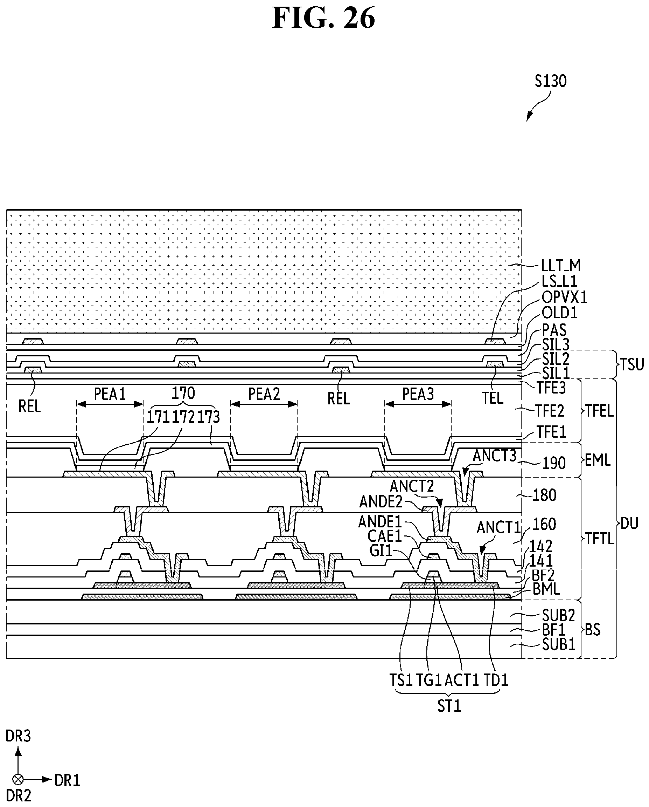

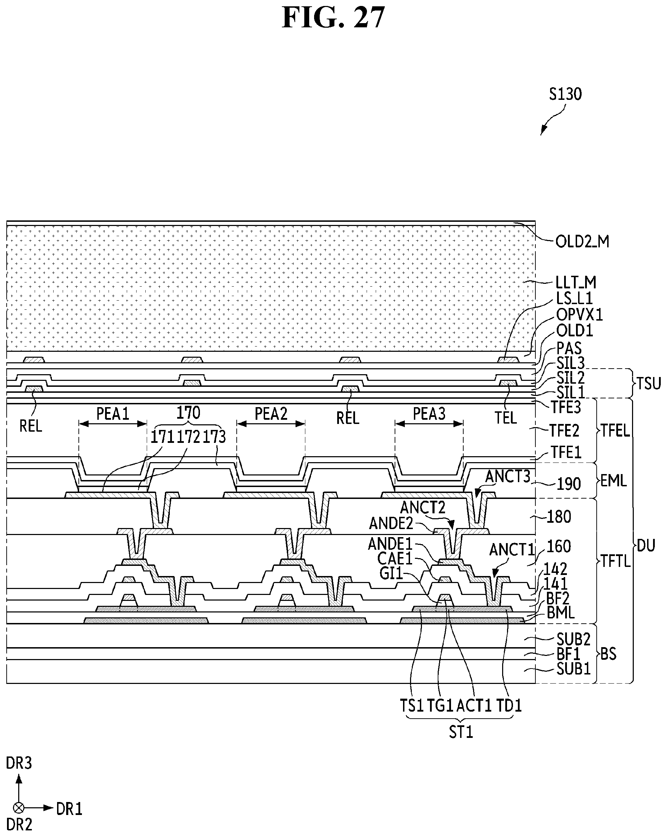

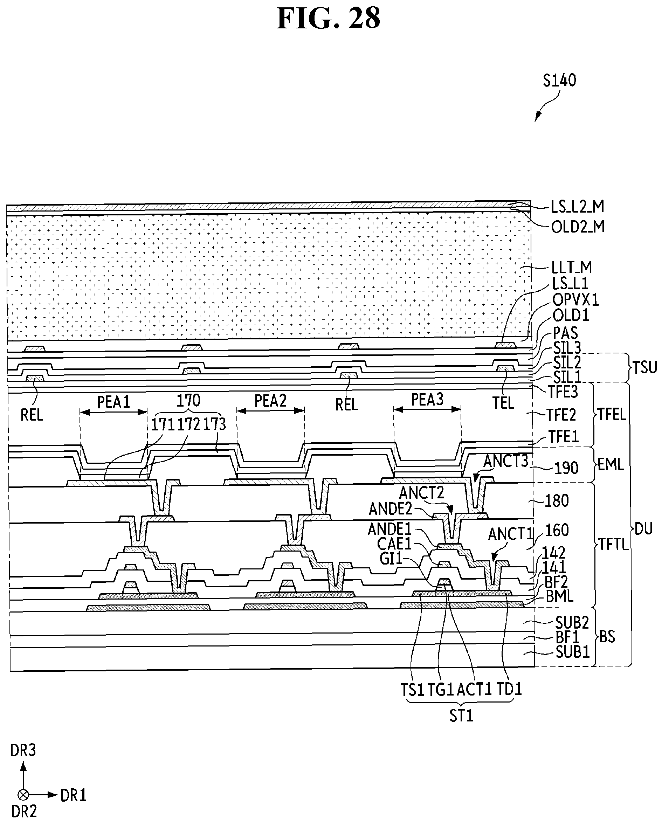

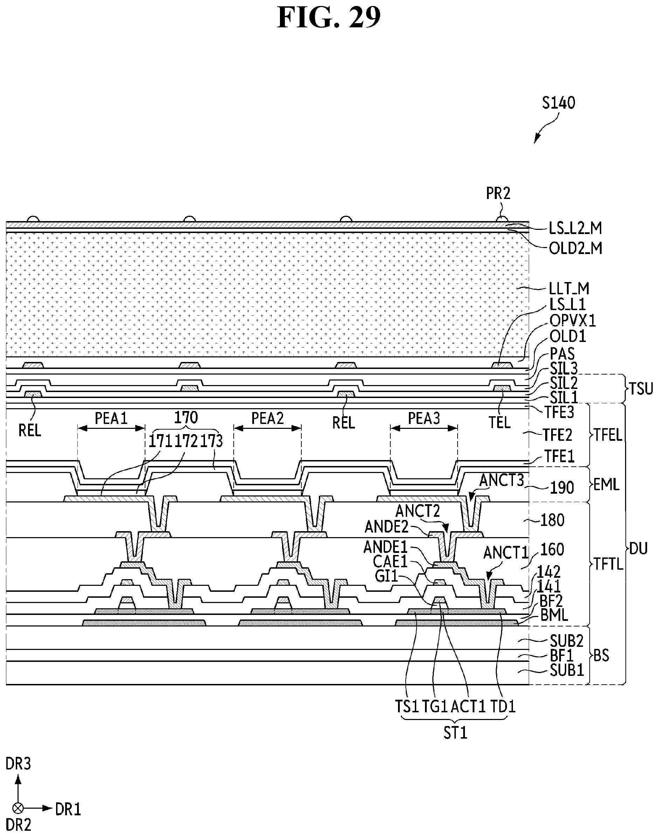

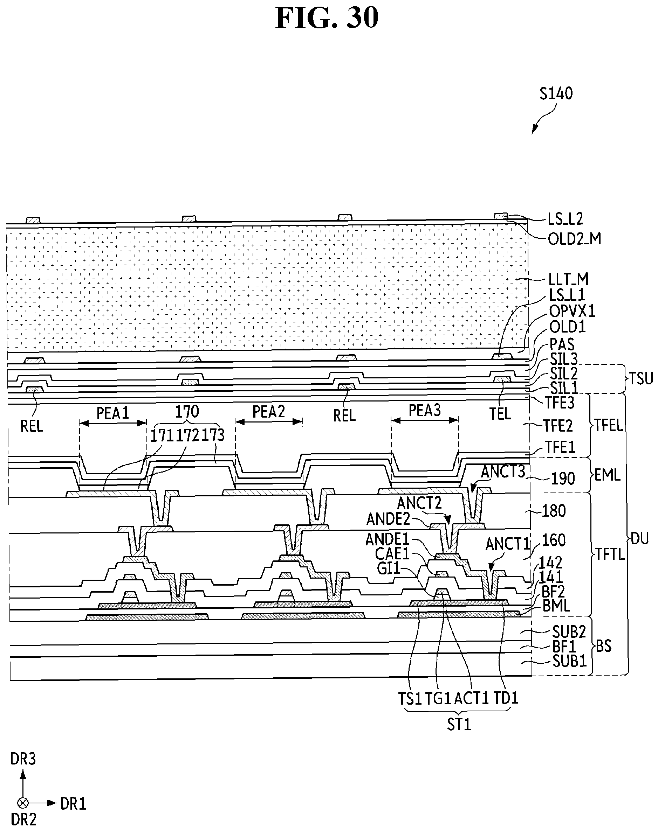

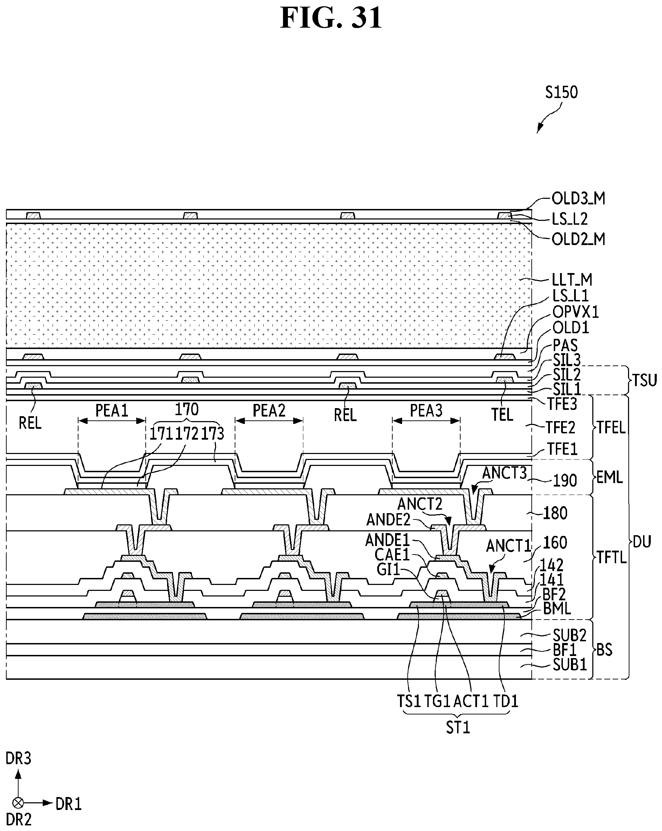

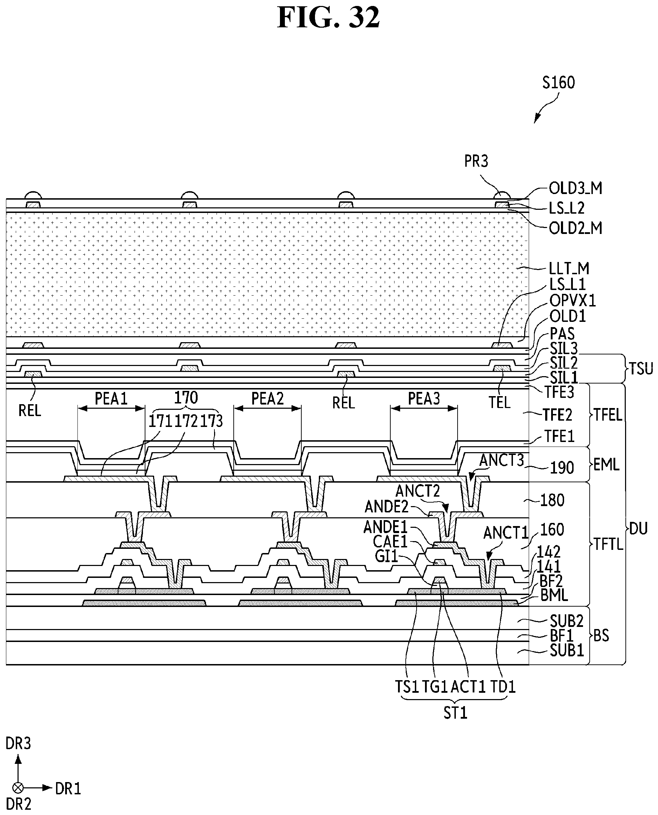

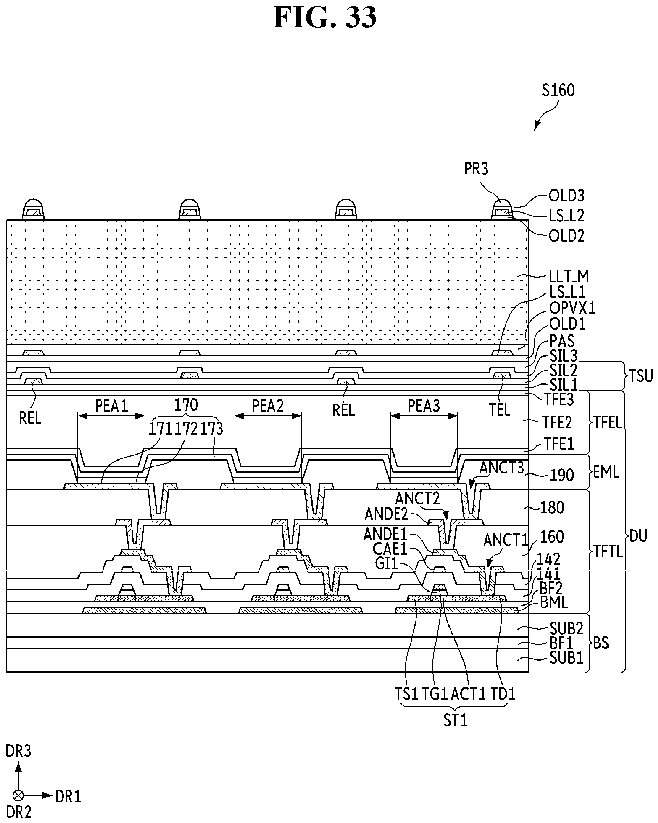

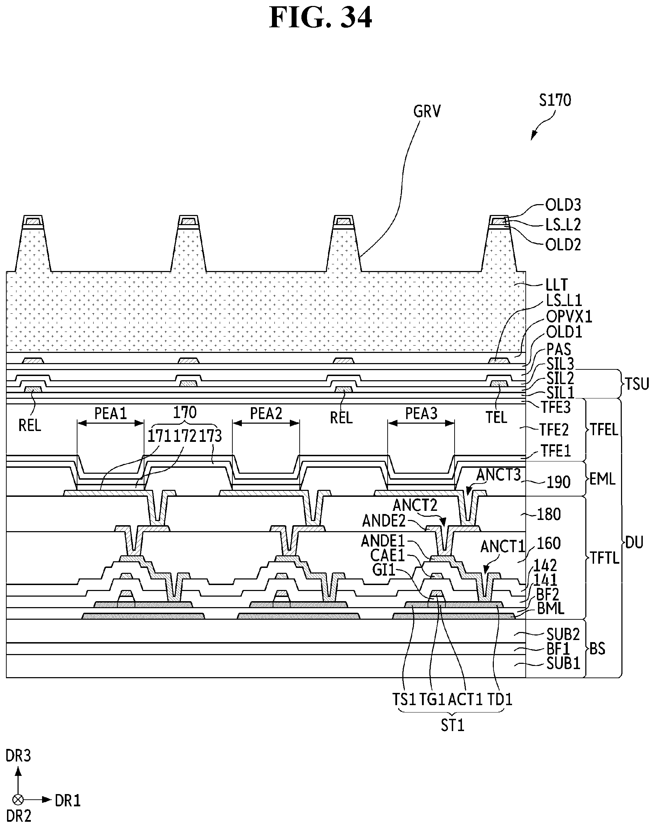

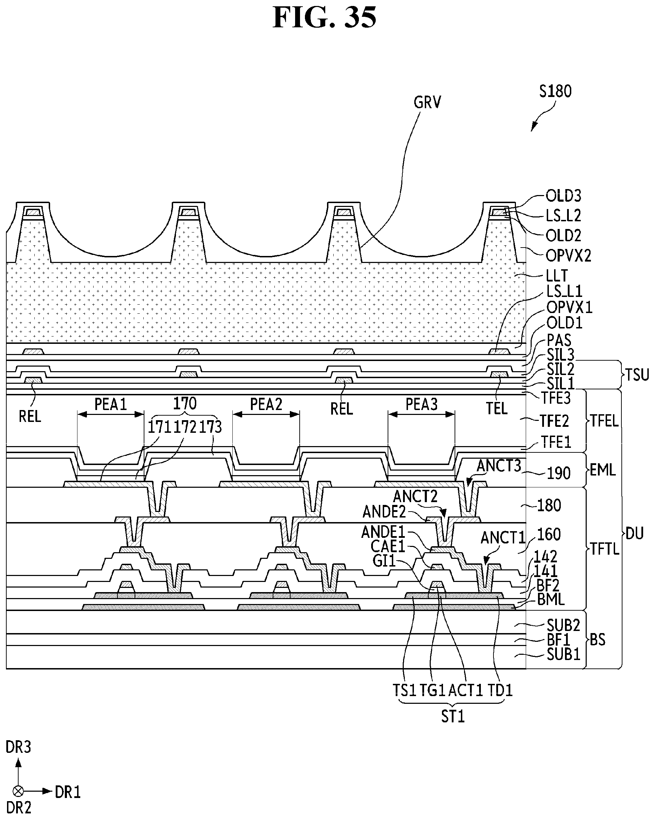

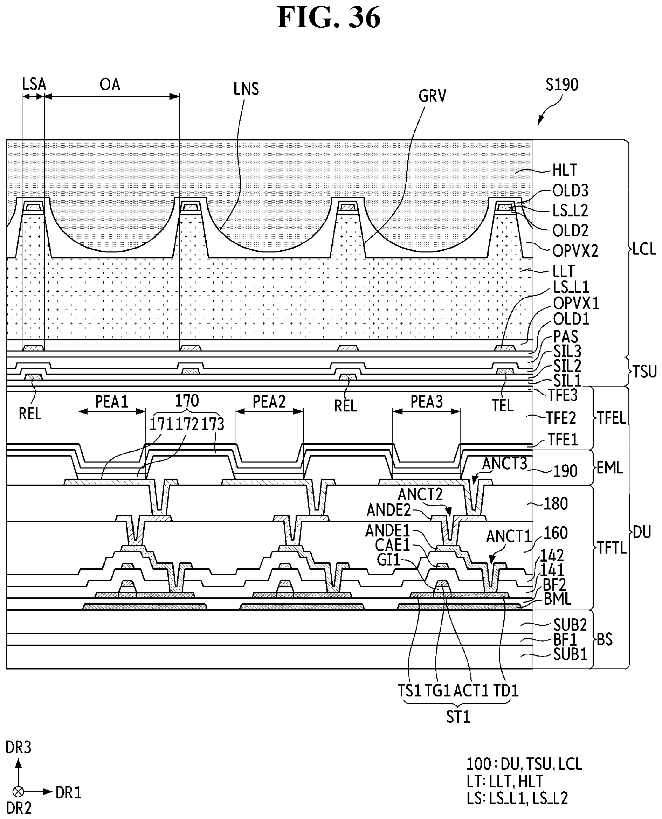

FIG. 20 is a flowchart showing a method for manufacturing a display device according to an embodiment. FIG. 21 is a cross-sectional view showing step S100 of FIG. 20. FIGS. 22 to 24 are cross-sectional views showing step S110 of FIG. 20. FIG. 25 is a cross-sectional view showing step S120 of FIG. 20. FIGS. 26 and 27 are cross-sectional views showing step S130 of FIG. 20. FIGS. 28 to 30 are cross-sectional views showing step S140 of FIG. 20. FIG. 31 is a cross-sectional view showing step S150 of FIG. 20. FIGS. 32 and 33 are cross-sectional views showing step S160 of FIG. 20. FIG. 34 is a cross-sectional view showing step S170 of FIG. 20. FIG. 35 is a cross-sectional view showing step S180 of FIG. 20. FIG. 36 is a cross-sectional view showing step S190 of FIG. 20.

Referring to FIGS. 20 to 36, the method S1 for manufacturing a display device according to an embodiment may include forming a first medium layer (step S100), forming a first light blocking layer (step S110), forming a first light transmitting lower film (step S120), arranging a low refractive transmitting material layer and a second medium material layer (step S130), forming a second light blocking layer (step S140), disposing a third medium material layer (step S150), forming a second medium layer and a third medium layer (step S160), forming a low refractive transmitting film (step S170), forming a second light transmitting lower film (step S180), and forming a high refractive transmitting film (step S190).

Firstly, as illustrated in FIG. 21, in the step S100 of forming the first medium layer, the first medium layer OLD1 may be disposed on the display layer DU or the touch sensor layer TSU. The first medium layer OLD1 may include at least one of silicon oxide (SiOₓ), silicon nitride (SiNₓ), or silicon oxynitride (SiOₓN_{y}). The first medium layer OLD1 may be formed by a deposition process or a photolithography process.

Secondly, as illustrated in FIGS. 22 to 24, in the step S110 of forming the first light blocking layer, a first light blocking material layer LS_L1_M may be disposed on the first medium layer OLD1. The first light blocking material layer LS_L1_M may include an organic material including a light blocking organic material, for example, an organic black pigment such as carbon black. The first light blocking material layer LS_L1_M may be formed by a deposition process.

Next, the first light blocking material layer LS_L1_M may be patterned to form the first light blocking layer LS_L1. For example, a first photoresist PR1 may be disposed on the first light blocking material layer LS_L1_M. The first light blocking material layer LS_L1_M may be patterned by a photolithography process using the first photoresist PR1, thereby forming the first light blocking layer LS_L1. After the first light blocking layer LS_L1 is formed, the first photoresist PR1 may be removed by a separate strip process.

Thirdly, as illustrated in FIG. 25, in the step S120 of forming the first light transmitting lower film, the first light transmitting lower film OPVX1 may be disposed on the first medium layer OLD1 and the first light blocking layer LS_L1. The first light transmitting lower film OPVX1 may include propylene glycol methyl ether acetate, a methacrylic acid-benzyl methacrylic acid copolymer, a multi-functional acrylate, and a photoinitiator. The first light transmitting lower film OPVX1 may be formed by a deposition process or a photolithography process.

Fourthly, as illustrated in FIGS. 26 and 27, in the step S130 of arranging the low refractive transmitting material layer and the second medium material layer, a low refractive transmitting material layer LLT_M may be disposed on the first light transmitting lower film OPVX1. The low refractive transmitting material layer LLT_M may include an ester-based compound and a phosphine oxide compound. For example, the number of carbon atoms of the ester-based compound may be 30 or less. The low refractive transmitting material layer LLT_M may be formed by an inkjet printing process.

Next, a second medium material layer OLD2_M may be disposed on the low refractive transmitting material layer LLT_M. The second medium material layer OLD2_M may include at least one of silicon oxide (SiOₓ), silicon nitride (SiNₓ), or silicon oxynitride (SiOₓN_{y}). The second medium material layer OLD2_M may be formed by a deposition process.

Fifthly, as illustrated in FIGS. 28 to 30, in the step S140 of forming the second light blocking layer, a second light blocking material layer LS_L2_M may be disposed on the second medium material layer OLD2_M. The second light blocking material layer LS_L2_M may include an organic material including a light blocking organic material, for example, an organic black pigment such as carbon black. The second light blocking material layer LS_L2_M may be formed by a deposition process.

Next, the second light blocking material layer LS_L2_M may be patterned to form the second light blocking layer LS_L2. For example, a second photoresist PR2 may be disposed on the second light blocking material layer LS_L2_M. In this case, the second photoresist PR2 may overlap the plurality of first light blocking patterns of the first light blocking layer LS_L1. The second light blocking material layer LS_L2_M may be patterned by a photolithography process using the second photoresist PR2, thereby forming the second light blocking layer LS_L2. After the second light blocking layer LS_L2 is formed, the second photoresist PR2 may be removed by a separate strip process.

Sixthly, as illustrated in FIG. 31, in the step S150 of disposing the third medium material layer, a third medium material layer OLD3_M may be disposed on the second medium material layer OLD2_M and the second light blocking layer LS_L2. The third medium material layer OLD3_M may include at least one of silicon oxide (SiOₓ), silicon nitride (SiNₓ), or silicon oxynitride (SiOₓN_{y}). The third medium material layer OLD3_M may be formed by a deposition process.

Seventhly, as illustrated in FIGS. 32 and 33, in the step S160 of forming the second medium layer and the third medium layer, the second medium material layer OLD2_M and the third medium material layer OLD3_M may be patterned to form the second medium layer OLD2 and the third medium layer OLD3. For example, a third photoresist PR3 may be disposed on the third medium material layer OLD3_M. In this case, the third photoresist PR3 may overlap the plurality of second light blocking patterns of the second light blocking layer LS_L2. The second medium material layer OLD2_M and the third medium material layer OLD3_M may be simultaneously patterned by a photolithography process using the third photoresist PR3, thereby forming the second medium layer OLD2 and the third medium layer OLD3.

In an embodiment, similarly to the first photoresist PR1 and the second photoresist PR2, the third photoresist PR3 may be removed by a separate strip process. In an embodiment, unlike the first photoresist PR1 and the second photoresist PR2, the third photoresist PR3 might not be removed by a separate strip process, and may be etched and removed together with the low refractive transmitting material layer LLT_M in the step S170 of forming the low refractive transmitting film to be described later.

Eighthly, as illustrated in FIG. 34, in the step S170 of forming the low refractive transmitting film, the low refractive transmitting film LLT may be formed by forming the groove GRV in the low refractive transmitting material layer LLT_M while using the second medium layer OLD2 and the third medium layer OLD3 as a mask. For example, a dry etching process may be performed using an etchant having a high etching rate for the low refractive transmitting film LLT including an organic film and a low etching rate for the second medium layer OLD2 and the third medium layer OLD3 that include an inorganic film. In this process, the third photoresist PR3 may be removed together.

Ninthly, as illustrated in FIG. 35, in the step S180 of forming the second light transmitting lower film, the second light transmitting lower film OPVX2 may be disposed on the low refractive transmitting film LLT and the third medium layer OLD3. The second light transmitting lower film OPVX2 may include propylene glycol methyl ether acetate, a methacrylic acid-benzyl methacrylic acid copolymer, a multi-functional acrylate, and a photoinitiator. The second light transmitting lower film OPVX2 may be formed by a deposition process or a photolithography process. When the second light transmitting lower film OPVX2 is deposited, the top surface of the second light transmitting lower film OPVX2 may be deposited in a shape that is concave, bending toward the display layer DU.

Tenthly, as illustrated in FIG. 36, in the step S190 of forming the high refractive transmitting film, the high refractive transmitting film HLT may be disposed on the second light transmitting lower film OPVX2. The high refractive transmitting film HLT may include an ester-based compound and a phosphine oxide compound. For example, the number of carbon atoms of the ester-based compound may be 30 or less. The high refractive transmitting film HLT may be formed by an inkjet printing process. The high refractive transmitting film HLT may include the lens unit LNS formed along the top surface of the second light transmitting lower film OPVX2.

Hereinafter, other embodiments of the method for manufacturing the display device according to an embodiment will be described. In the following embodiments, description of the same components as those of the above-described embodiment, which are denoted by like reference numerals, and to the extent that an element is not described in detail with respect to this figure, it may be understood that the element is at least similar to a corresponding element that has been described elsewhere within the present disclosure.

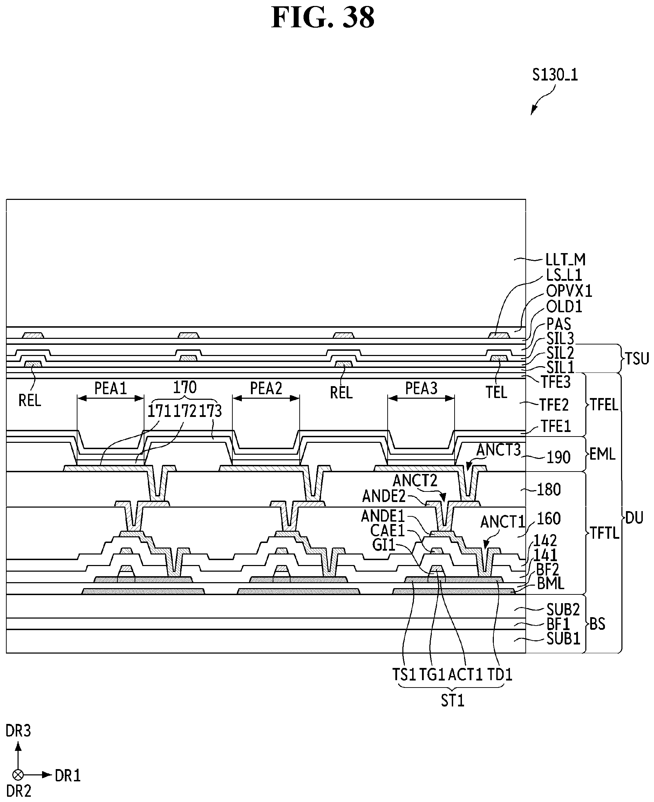

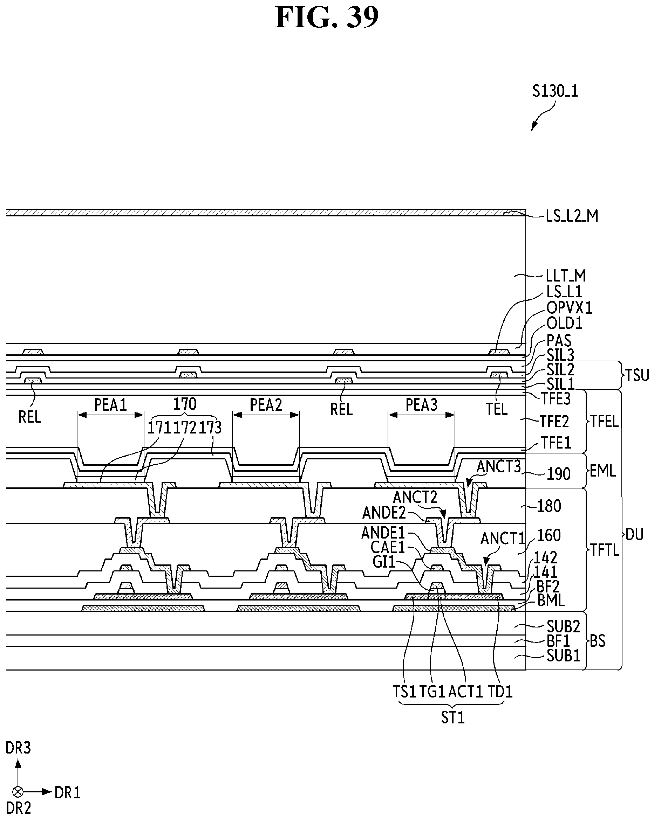

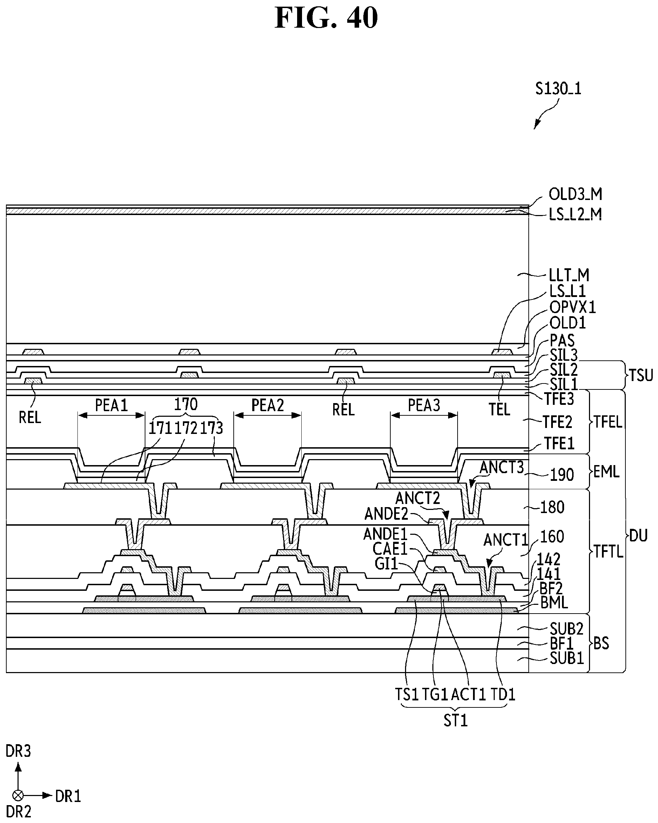

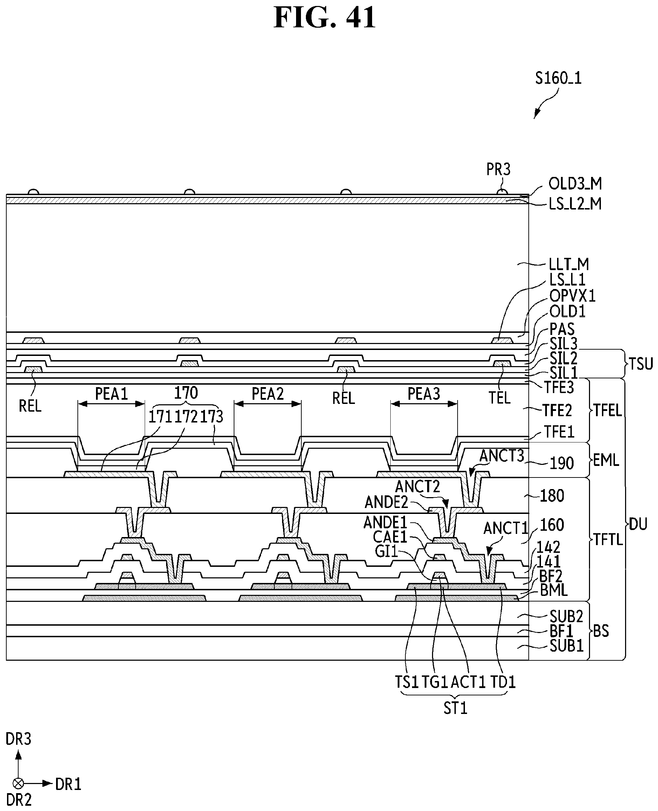

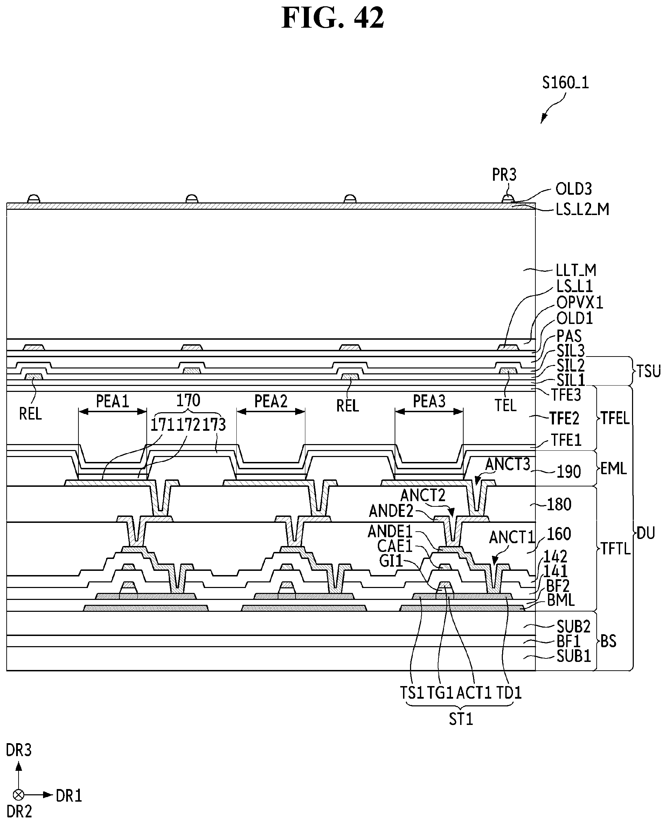

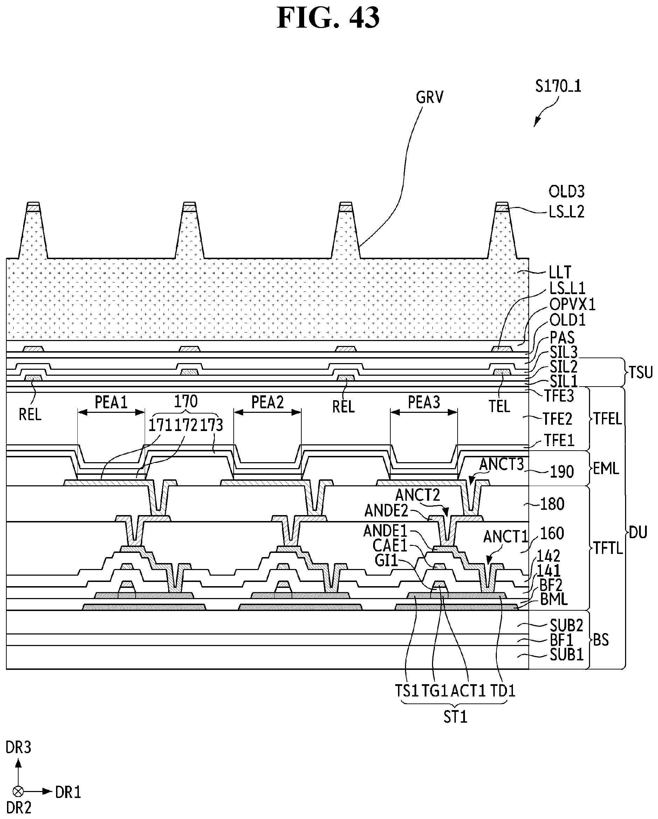

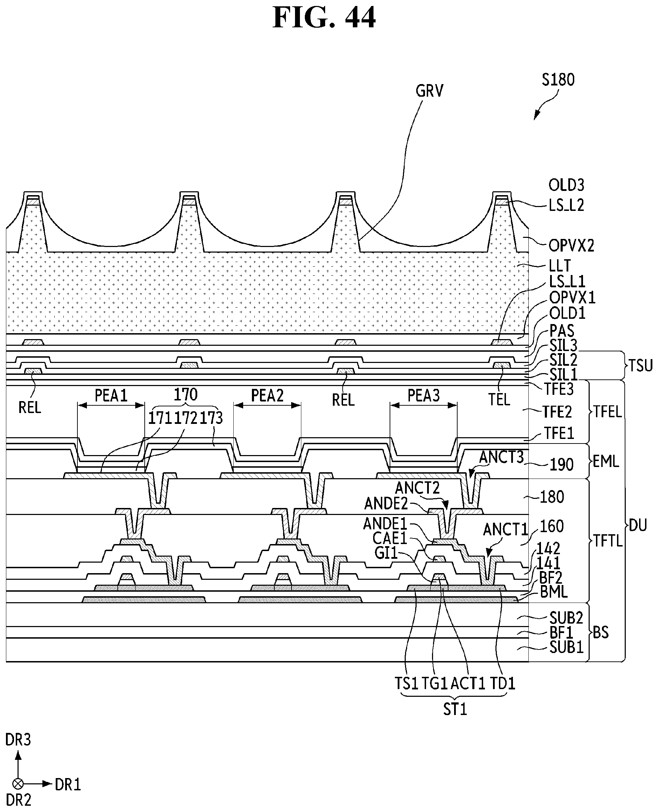

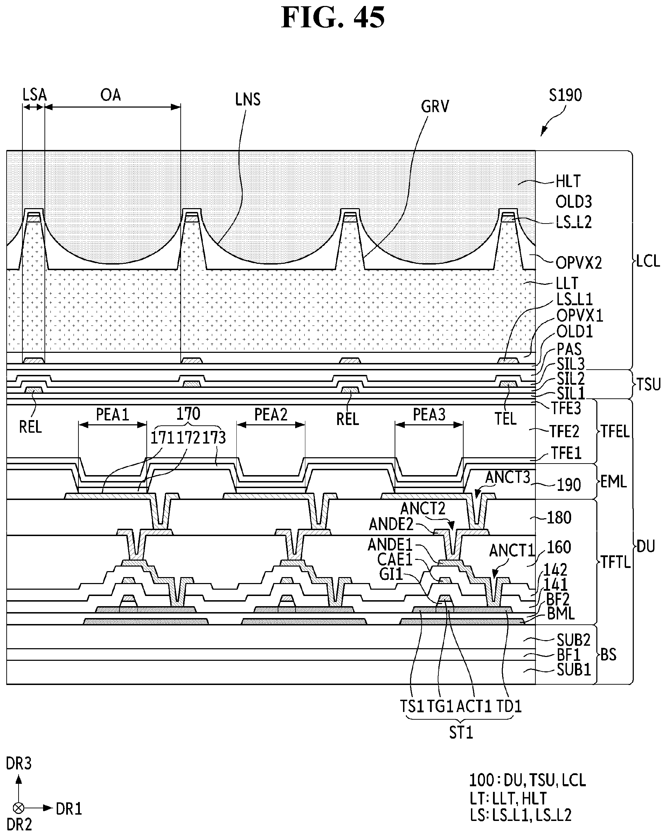

FIG. 37 is a flowchart illustrating a method for manufacturing a display device according to an embodiment. FIGS. 38 to 40 are cross-sectional views showing step S130_1 of FIG. 37. FIGS. 41 and 42 are cross-sectional views showing step S160_1 of FIG. 37. FIG. 43 is a cross-sectional view showing step S170_1 of FIG. 37. FIG. 44 is a cross-sectional view showing step S180 of FIG. 37. FIG. 45 is a cross-sectional view showing step S190 of FIG. 37.

Referring to FIGS. 37 to 45, the method S1_1 for manufacturing a display device according to the present embodiment is different from the method S1 for manufacturing a display device according to an embodiment described with reference to FIG. 20 and the like in that the step of forming the second light blocking layer LS_L2 by patterning the second light blocking material layer LS_L2_M and the step of forming the low refractive transmitting film LLT by etching the low refractive transmitting material layer LLT_M are performed simultaneously, and the second medium layer OLD2 is not included (i.e., is omitted).

For example, the method S1_1 for manufacturing a display device according to an embodiment may include forming a first medium layer (step S100), forming a first light blocking layer (step S110), forming a first light transmitting lower film (step S120), arranging a low refractive transmitting material layer, a second light blocking material layer, and a third medium material layer (step S130_1), forming a third medium layer (step S160_1), forming a second light blocking layer and a low refractive transmitting film (step S170_1), forming a second light transmitting lower film (step S180), and forming a high refractive transmitting film (step S190).

The description of the step S100 of forming the first medium layer, the step S110 of forming the first light blocking layer, and the step S120 of forming the first light transmitting lower film is the same as that in the method S1 for manufacturing a display device according to an embodiment described with reference to FIG. 20, and to the extent that an element is not described in detail with respect to this figure, it may be understood that the element is at least similar to a corresponding element that has been described elsewhere within the present disclosure.

Firstly, as illustrated in FIGS. 38 to 40, in the step S130_1 of arranging the low refractive transmitting material layer, the second light blocking material layer, and the third medium material layer, the low refractive transmitting material layer LLT_M may be disposed on the first light transmitting lower film OPVX1. Next, the second light blocking material layer LS_L2_M may be disposed on the low refractive transmitting material layer LLT_M. Next, the third medium material layer OLD3_M may be disposed on the second light blocking material layer LS_L2_M.

In this case, instead of disposing the second medium material layer OLD2_M on the low refractive transmitting material layer LLT_M, the second light blocking material layer LS_L2_M may be directly disposed on the low refractive transmitting material layer LLT_M.

Further, instead of disposing the third medium material layer OLD3_M after the second light blocking layer LS_L2 is formed by patterning the second light blocking material layer LS_L2_M, the third medium material layer OLD3 may be disposed without patterning the second light blocking material layer LS_L2_M after the second light blocking material layer LS_L2_M is disposed.

Secondly, as illustrated in FIGS. 41 and 42, in the step S160_1 of forming the third medium layer, the third medium material layer OLD3_M may be patterned to form the third medium layer OLD3. For example, the third photoresist PR3 may be disposed on the third medium material layer OLD3_M. In this case, the third photoresist PR3 may overlap the plurality of first light blocking patterns of the first light blocking layer LS_L1. The third medium material layer OLD3_M may be patterned by a photolithography process using the third photoresist PR3, thereby forming the third medium layer OLD3.

Thirdly, as illustrated in FIG. 43, in the step S170_1 of forming the second light blocking layer and the low refractive transmitting film, the second light blocking material layer LS_L2_M and the low refractive transmitting material layer LLT_M may be simultaneously etched using the third medium layer OLD3 as a mask. For example, since a dry etching process is performed using the third medium layer OLD3 as a mask, the second light blocking material layer LS_L2_M may be patterned to form the second light blocking layer LS_L2, and the low refractive transmitting material layer LLT_M may be partially etched to form the groove GRV.

Thereafter, as illustrated in FIGS. 44 and 45, the step S180 of forming the second light transmitting lower film and the step S190 of forming the high refractive transmitting film may be performed. The description of the step S180 of forming the second light transmitting lower film and the step S190 of forming the high refractive transmitting film is the same as that in the method S1 for manufacturing a display device according to an embodiment described with reference to FIG. 20 and the like, and to the extent that an element is not described in detail with respect to this figure, it may be understood that the element is at least similar to a corresponding element that has been described elsewhere within the present disclosure.

In the method S1_1 for manufacturing a display device according to the present embodiment, the second medium layer OLD2 is not included (i.e., is omitted), and the step of forming the second light blocking layer LS_L2 and the step of forming the low refractive transmitting film LLT are performed simultaneously, so that the process efficiency may be increased. In addition, as described with reference to FIG. 13 and the like, in the display device 10 manufactured according to the method S1_1 for manufacturing a display device according to the present embodiment, the distance between one end LNSa of the lens unit LNS and one end LS_L2a of the second light blocking pattern of the second light blocking layer LS_L2, which are adjacent to each other, may be reduced, or the lens unit LNS and the second light blocking pattern of the second light blocking layer LS_L2 may overlap. Accordingly, light that does not pass through the lens unit LNS is blocked by the second light blocking layer LS_L2, and light that is not blocked by the second light blocking layer LS_L2 is allowed to pass through the lens unit LNS, thereby increasing the viewing angle control characteristics of the display device 10.

In concluding the detailed description, those skilled in the art will appreciate that many variations and modifications can be made to the preferred embodiments without substantially departing from the principles of the present disclosure.

## Claims

1. A display device (10), comprising:
a substrate;
a light emitting element layer (EML) disposed on the substrate and comprising a plurality of light emitting elements (170); and
a light control layer (LCL) disposed on the light emitting element layer,
wherein the light control layer (LCL) comprises:
a first light blocking layer (LS_L1) comprising a plurality of first light blocking patterns;
a low refractive transmitting film (LLT) disposed on the first light blocking layer (LS_L1) and comprising a plurality of grooves formed therein;
a second light blocking layer (LS_L2) disposed on the low refractive transmitting film and comprising a plurality of second light blocking patterns; and
a high refractive transmitting film (HLT) disposed on the second light blocking layer (LS_L2) and comprising a plurality of lens units (LNS) having a shape that is concave, curving toward the plurality of grooves.

2. The display device (10) of claim 1, further comprising a first medium layer (OLD1) disposed between the light emitting element layer and the first light blocking layer (LS_L1) and comprising an inorganic material.

3. The display device (10) of claim 1 or 2, further comprising a first light transmitting lower film (OPVX1) disposed between the first light blocking layer (LS_L1) and the low refractive transmitting film,
wherein the low refractive transmitting film (LLT) and the first light transmitting lower film (OPVX1) comprise different materials,
wherein the low refractive transmitting film (LLT) comprises at least one of an ester-based compound or a phosphine oxide compound, and
wherein the first light transmitting lower film comprises at least one of propylene glycol methyl ether acetate, methacrylic acid-benzylmethacrylic acid copolymer, multi-functional acrylate, or a photo initiator.

4. The display device (10) of any of the preceding claims, further comprising a second light transmitting lower film (OPVX2) disposed between the second light blocking layer (LS_L2) and the high refractive transmitting film,
wherein the high refractive transmitting film (HLT) and the second light transmitting lower film comprise different materials,
wherein the high refractive transmitting film (HLT) comprises at least one of an ester-based compound or a phosphine oxide compound, and
wherein the second light transmitting lower film comprises at least one of propylene glycol methyl ether acetate, methacrylic acid-benzylmethacrylic acid copolymer, multi-functional acrylate, or a photo initiator.

5. The display device (10) of any of the preceding claims, wherein the plurality of lens units are respectively disposed between the plurality of second light blocking patterns, and/or
wherein the low refractive transmitting film (LLT) comprises a plurality of partition walls disposed between the plurality of grooves, and
wherein the plurality of second light blocking patterns are respectively disposed on the plurality of partition walls.

6. The display device (10) of any of the preceding claims, wherein a refractive index of the high refractive transmitting film (HLT) is greater than a refractive index of the low refractive transmitting film (LLT), and
wherein a difference in refractive index of the high refractive transmitting film (HLT) and the low refractive transmitting film (LLT) is 0.1 or more.

7. The display device (10) of any of the preceding claims 1 to 3, 5, and 6, further comprising a second light transmitting lower film disposed between the second light blocking layer (LS_L2) and the high refractive transmitting film (HLT),
wherein a side surface of the second light blocking layer (LS_L2) is in direct contact with the second light transmitting lower film.

8. The display device (10) of claim 7, further comprising a third medium layer disposed between the second light blocking layer (LS_L2) and the second light transmitting lower film,
wherein a top surface of the second light blocking layer is in direct contact with the third medium layer, and
wherein a bottom surface of the second light blocking layer (LS_L2) is in direct contact with the low refractive transmitting film.

9. The display device (10) of any of the preceding claims, wherein one end of each of the plurality of lens units and one end of each of the plurality of second light blocking patterns, which are adjacent to each other, are positioned on a same line, and/or wherein the plurality of lens units and the plurality of second light blocking patterns, which are adjacent to each other, overlap each other.

10. The display device (10) of any of the preceding claims, wherein the low refractive transmitting film (HLT) comprises a first low refractive transmitting layer and a second low refractive transmitting layer disposed on the first low refractive transmitting layer,
wherein the display device (10) further comprising a third light blocking layer (LS_L3) disposed between the first low refractive transmitting layer and the second low refractive transmitting layer and comprising a plurality of third light blocking patterns, and
wherein the plurality of grooves are disposed in the second low refractive transmitting layer.

11. The display device (10) of any of the preceding claims, further comprising a color filter disposed between the plurality of first light blocking patterns, or further comprising a color filter disposed between the plurality of second light blocking patterns.

12. The display device (10) of any of the preceding claims, wherein at least a part of the plurality of second light blocking patterns are disposed further in one direction than at least a part of the plurality of first light blocking patterns,
wherein central portions of the at least a part of the plurality of second light blocking patterns are misaligned with central portions of the at least a part of the plurality of first light blocking patterns,
wherein at least some of the plurality of lens units are disposed further in one direction than the at least a part of the plurality of first light blocking patterns, and
wherein central portions of the at least a part of the plurality of lens units are misaligned with the central portions of the at least a part of the plurality of first light blocking patterns, and/or, wherein the plurality of light emitting elements (170) comprise a first light emitting element (170) and a second light emitting element (170) that emit light of different colors,
wherein the plurality of lens units comprise a first lens overlapping the first light emitting element (170) and a second lens overlapping the second light emitting element (170), and
wherein an average curvature of the first lens is different from an average curvature of the second lens.

13. A method for manufacturing a display device (10) of any of the preceding claims, comprising:
forming a first light blocking layer (LS_L1) on a light emitting element layer;
disposing a low refractive transmitting material layer on the first light blocking layer;
forming a second light blocking layer (LS_L2) on the low refractive transmitting material layer;
forming a medium layer on the second light blocking layer;
patterning the low refractive transmitting material layer using the medium layer to form a low refractive transmitting film; and
forming a high refractive transmitting film (HLT) on the low refractive transmitting film (LLT) and the second light blocking layer.

14. An automobile, comprising:
a body comprising a windshield;
an interior space disposed within the body;
a dashboard disposed within the interior space, proximate to the windshield; and
a display panel (100) disposed on the dashboard,
wherein the display panel (100) comprises:
a substrate;
a light emitting element layer disposed on the substrate and comprising a plurality of light emitting elements (170); and
a light control layer disposed on the light emitting element layer,
wherein the light control layer comprises:
a first light blocking layer (LS_L1) comprising a plurality of first light blocking patterns;
a low refractive transmitting film (LLT) disposed on the first light blocking layer and comprising a plurality of grooves formed therein;
a second light blocking layer (LS_L2) disposed on the low refractive transmitting film and comprising a plurality of second light blocking patterns; and
a high refractive transmitting film (HLT) disposed on the second light blocking layer and comprising a plurality of lens units having a shape that is concave, curving toward the plurality of grooves.

15. The automobile of claim 14, wherein the display panel (100) further comprises:
a first medium layer disposed between the light emitting element layer and the first light blocking layer and comprising an inorganic material; and
a first light transmitting lower film disposed between the first light blocking layer and the low refractive transmitting film,
wherein the low refractive transmitting film and the first light transmitting lower film comprise different materials,
wherein the low refractive transmitting film comprises at least one of an ester-based compound or a phosphine oxide compound, and
wherein the first light transmitting lower film comprises at least one of propylene glycol methyl ether acetate, methacrylic acid-benzylmethacrylic acid copolymer, multi-functional acrylate, or a photo initiator.
